# EUROPEAN PATENT APPLICATION

(11) **EP 1 860 694 A1**
(43) Date of publication of application: **28.11.2007**
(21) Application number: 06729094.0
(22) Date of filing: 14.03.2006
(51) Int. Cl.: H01L 23/02, H04R 19/04

(54) **SEMICONDUCTOR DEVICE, SEMICONDUCTOR DEVICE MANUFACTURING METHOD AND COVER FRAME**

(30) Priority: 16.03.2005 JP 2005074901; 11.05.2005 JP 2005138371; 06.07.2005 JP 2005197440; 29.08.2005 JP 2005247498
(71) Applicant: YAMAHA CORPORATION, Naka-ku Hamamatsu-shi Shizuoka 430-8650 (JP)
(72) Inventor: SAITOH, Hiroshi c/o YAMAHA CORPORATION, Hamamatsu-shi, Shizuoka, 4308650 (JP); SUZUKI, Toshihisa c/o YAMAHA CORPORATION, Hamamatsu-shi, Shizuoka, 4308650 (JP); OMURA, Masayoshi c/o YAMAHA CORPORATION, Hamamatsu-shi, Shizuoka, 4308650 (JP)
(74) Representative: Wagner, Karl H.
(86) International application number: PCT/JP2006/305060
(87) International publication number: WO 2006/098339

(57) **Abstract**

A semiconductor device includes: a substrate; a semiconductor chip that is fixed to a first surface of the substrate; a chip covering lid body that is provided on the first surface of the substrate so as to cover the semiconductor chip and that forms a hollow first space portion that surrounds the semiconductor chip, and in which there is provided a substantially cylindrical aperture portion that extends to the outer side of the first space portion and has an aperture end at a distal end thereof and that is connected to the first space portion; and a first resin mold portion that forms the first space portion via the chip covering lid body and covers the substrate such that the aperture end is exposed, and that fixes the substrate integrally with the chip covering lid body.

## Description

### TECHNICAL FIELD

This invention relates to a semiconductor device that is provided with a semiconductor chip such as a sound pressure sensor chip and a pressure sensor chip, and to a method of manufacturing the same, and to a lid frame that is used with the same.

Priority is claimed on Japanese Patent Application Nos. 2005-74901, filed March 16, 2005, 2005-138371, filed May 11, 2005, 2005-197440, filed July 6, 2005, and 2005-247498, filed August 29, 2005, the contents of which are incorporated herein by reference.

### BACKGROUND ART

Conventionally, semiconductor devices such as, for example, pressure sensors and silicon microphones that are manufactured using silicon semiconductors are formed substantially in a rectangular plate shape, and are provided with semiconductor sensor chips in which recessed portions are formed that are recessed from the front surface towards the rear surface thereof. In this type of semiconductor device, this semiconductor sensor chip is packaged on a printed circuit board. A portion of this semiconductor sensor chip whose thickness has been reduced by the recessed portion forms a diaphragm (i.e., a movable electrode), and a displacement or distortion is generated in the diaphragm when pressure such as, for example, sound pressure is applied thereto. For example, a bridge resistive circuit that is formed on the diaphragm treats this displacement or distortion as a change in the electrical resistance, and detects pressure based on these changes in the electrical resistance that correspond to the size of the displacement or distortion (referred to below as distortion).

Generally, this type of semiconductor device has the characteristic that the smaller the range in which the displacement of the diaphragm takes place, or the less adhesion of fluid or the like to the diaphragm that occurs, the better the accuracy and reproducibility. Because of this, an amplifier such as an op-amp that amplifies the electrical signals that are output by the micro displacement of the diaphragm is provided in the semiconductor device. This amplifier is packaged on the printed circuit board together with the semiconductor sensor chip. A cover (i.e., a lid) is then used to cover the surface of the printed circuit board so as to package the semiconductor sensor chip and the amplifier within the same space, and protect these from the external environment (see, for example, Patent document 1).

In this type of semiconductor device, an aperture portion that connects the aforementioned space with the outside is provided in the cover that houses the semiconductor sensor chip and the amplifier in the same space. Variable pressure such as, for example, sound pressure and the like that is generated externally is guided into the space via this aperture portion, and arrives at the semiconductor sensor chip. In addition, a recessed portion that is recessed from the front surface of the printed circuit board towards the rear surface thereof is provided in a portion of the printed circuit board that is located directly below the diaphragm. As a result of a space being formed directly below the diaphragm by this recessed portion, the diaphragm vibrates (i.e., is displaced) correctly at a displacement amount that corresponds to the incoming pressure.

Moreover, in this type of semiconductor device, the fact that the semiconductor chip is connected to an external space via through holes that are formed in the circuit board and sealing resin package is disclosed, for example, in Patent document 2. The through holes that are formed in the sealing resin package are constructed, for example, by cylindrical pipes that are linked to the through holes in the circuit board.

The sealing resin package of this type of semiconductor device is formed by placing a circuit board on which the semiconductor chip and pipes have been mounted into a metal mold which has a cavity to allow these to be formed, and then supplying a flow of molten resin to this cavity.

Accordingly, it is necessary to prevent any shift in the position of the pipes relative to the circuit board that is caused by the flow of the molten resin which forms the sealing resin package, and also to prevent the molten resin flowing into the gaps between the pipes and the circuit board. Because of this, conventionally, the pipes are fixed in advance to the circuit board prior to the formation of the sealing resin package. The pipes are fixed using a method such as, for example, riveting the pipes to the through holes in the circuit board, welding them thereto, soldering them, or adhering them using an adhesive agent.

Furthermore, conventionally, some semiconductor devices have been provided with semiconductor chips having movable portions such as acceleration sensor chips and the like. In this type of semiconductor device, an empty space portion space is provided between the circuit board on which the semiconductor chip has been fixed and the resin body (i.e., the resin mold portion), and the semiconductor chip is placed within this space portion (see, for example, Patent document 3). The space portion is formed by placing a lid that covers the semiconductor chip on the front surface of the circuit board.

The resin body of this type of semiconductor device is formed by placing a circuit board on which the semiconductor chip and lid have been mounted into a mold which has a cavity to allow these to be formed, and then supplying a flow of molten resin to this cavity. In the formation of this resin body, it is necessary to prevent any shift in the position of the lid relative to the circuit board that is caused by the flow of the molten resin which forms the resin body, and also to prevent the molten resin flowing into the space portion. Therefore, conventionally, a step to adhere the lid to the surface of the circuit board, or a step to form recessed portions or support portions that are used to support end portions of the lid on the circuit board are performed prior to the formation of the resin body.
[Patent document 1] Published Japanese Translation (JP-A) No. 2004-537182 of the PCT International Publication (WO2002/045463)
[Patent document 2] Japanese Unexamined Patent Application, First Publication (JP-A) No. H09-119875
[Patent document 3] Japanese Unexamined Patent Application, First Publication (JP-A) No. H08-64709

However, in the conventional semiconductor device described in Patent document 1, it has been necessary to alter the size of the recessed portions that are formed on the circuit board in accordance with the characteristics of the semiconductor chip. Because of this, the problem arises that manufacturing the circuit board becomes somewhat complex, which leads to a reduction in the manufacturing efficiency of a semiconductor device. In addition, there is an increase in the cost of manufacturing a semiconductor device.

Furthermore, at the same time as it covers them, the cover forms a space above the semiconductor sensor chip and amplifier on the surface of the printed circuit board where the semiconductor sensor chip and amplifier have both been installed. When this cover is placed in position, the problem has arisen that it sometimes comes into contact with the semiconductor sensor chip and amplifier or with the wires electrically connecting them and thus causing damage. Moreover, because distal end portions of the cover are fixed to the printed circuit board using only, for example, an adhesive agent, if, for example, a shock or the like is applied thereto, the cover sometimes comes off, so that the problem and has arisen that there is a decrease in the durability of the semiconductor device which has led to a consequent reduction in the reliability of the semiconductor device.

Furthermore, during the manufacturing of the semiconductor device described in Patent document 2 which has a resin package, it has been necessary to perform the step of forming through holes in the circuit board and to perform the step of fixing pipes to the circuit board. Because of this, the problem has arisen that there has been an increase in the cost of manufacturing a semiconductor device, and a reduction in the efficiency of manufacturing a semiconductor device.

Furthermore, during the manufacturing of the semiconductor device described in Patent document 3, because it has been necessary to perform the step of adhering a lid to the circuit board and to perform the step of forming the recessed portions or support portions in the circuit board, the problem has arisen that there has been an increase in the cost of manufacturing a semiconductor device.

### DISCLOSURE OF THE INVENTION

The present invention was conceived in view of the above described circumstances, and it is an object thereof to provide a semiconductor device that makes it possible to achieve a reduction in manufacturing costs, an improvement in manufacturing efficiency, and an improvement in durability, and to also provide a method of manufacturing the semiconductor device as well as to a lid frame used with the semiconductor device.

The semiconductor device of the present invention includes: a substrate; a semiconductor chip that is fixed to a first surface of the substrate; a chip covering lid body that is provided on the first surface of the substrate so as to cover the semiconductor chip and that forms a hollow first space portion that surrounds the semiconductor chip, and in which there is provided a substantially cylindrical aperture portion that extends to the outer side of the first space portion and has an aperture end at a distal end thereof and that is connected to the first space portion; and a first resin mold portion that forms the first space portion via the chip covering lid body and covers the substrate such that the aperture end is exposed, and that fixes the substrate integrally with the chip covering lid body.

In the semiconductor device of the present invention, it is also possible for the substrate to be a circuit board and for the semiconductor chip to be electrically connected to the circuit board.

In the semiconductor device of the present invention, it is also possible for the substrate to be a stage portion that is separated from a lead frame, and for the semiconductor device to have electrical connection leads that are placed around a periphery of the stage portion and that are fixed by the first resin mold portion such that one end of each electrical connection lead is exposed from the first resin mold portion, and for the semiconductor chip to be electrically connected to the electrical connection leads inside the first space portion.

In the semiconductor device of the present invention, it is also possible for the semiconductor device to have: a chip through hole that is formed in a position on the stage portion where the semiconductor chip is mounted, and that penetrates in the thickness direction of the stage portion from the first surface to the second surface which is on the opposite side from the first surface; and a second resin mold portion that is formed on the second surface of the stage portion, and is integrally fixed to the second surface of the stage portion so as to form a second space portion that is connected to the chip through hole.

In the semiconductor device of the present invention, it is also possible for the second space portion to be formed by a stage covering lid body that covers the second surface of the stage portion.

In the semiconductor device of the present invention, it is also possible for a diaphragm to be formed in the semiconductor chip and for the chip through hole to be formed facing the diaphragm, and for a connecting lead that is displaced towards the second surface side to be connected to the stage portion, and for the second resin mold portion to be fixed to the second surface of the stage portion so as to envelop the electrical connection leads and the connecting lead.

In addition, the semiconductor device of the present invention includes: a stage portion having a first and a second surface; a chip through hole that is formed in the stage portion and penetrates the first and second surfaces in the thickness direction thereof; a semiconductor chip that is fixed to the first surface of the stage portion which is also a portion where the chip through hole is formed; a chip covering lid body that is provided on the first surface of the stage portion so as to cover the semiconductor chip and that forms a hollow first space portion that surrounds the semiconductor chip,; and a resin mold portion that covers the first surface of the stage portion so as to form the first space portion via the chip covering lid body, and that also covers the second surface of the stage portion so as to form a second space portion that is connected to the chip through hole at the second surface of the stage portion and form an aperture portion that connects the second space portion to the outside, and that fixes the stage portion integrally with the chip covering lid body.

In the semiconductor device of the present invention, it is also possible for a diaphragm to be formed in the semiconductor chip and for the chip through hole to be formed facing the diaphragm, and for a connecting lead that is displaced towards the second surface side of the stage portion to be connected to the stage portion, and for the electrical connection leads to be placed in the vicinity of the stage portion, and for the resin mold portion to have a first resin layer that covers the first surface of the stage portion so as to form the first space portion via the chip covering lid body, and have a second resin layer that forms the second space portion and the aperture portion on the second surface of the stage portion and that covers the second surface of the stage portion so as to envelop the electrical connection leads and the connecting lead.

Furthermore, the semiconductor device of the present invention includes: a circuit board; a semiconductor chip that placed on top of and fixed to one surface side in the thickness direction of the circuit board and is also electrically connected thereto; a lid frame that is placed on top of the one surface side of the circuit board and that also covers the semiconductor chip; and a resin mold portion that is placed so as to provide a hollow space portion between itself and the semiconductor chip via the lid body frame, and that fixes the circuit board integrally with the lid frame, wherein a lid body that is provided on the circuit board and forms the space portion, and protruding portions that extend from the lid body in the thickness direction so as to protrude towards the outer side from a top surface of the space portion, and whose distal end portions are exposed to the outside of the resin mold portion are formed in the lid frame.

In the semiconductor device according to this invention, an aperture end of an aperture portion is exposed to the outside from a resin mold portion in order that the aperture end of the aperture portion can be placed in contact with the mold when the resin mold portion is being formed using a mold. Namely, when this semiconductor device is being manufactured, a circuit board and a lid frame are sandwiched in the thickness direction of the circuit board by a pair of molds that are used to form the resin mold portion. Here, because an aperture portion of the substantially cylinder-shaped lid frame extends from a top end portion of the lid body in a direction in which it moves further away from the circuit board, one mold is in contact with the aperture end of the aperture portion and a gap is formed between the other mold and the top end portion of the lid body.

Moreover, because it is sandwiched by the pair of molds, the aperture portion is pressed towards the circuit board. Because a bottom end portion of the lid body that is in contact with the circuit board is pressed against the circuit board by the pressing of the aperture portion, the gap between the bottom end portion of the lid body and the circuit board can be closed. Furthermore, because the aperture end of the aperture portion also abuts against one mold, the aperture end of the aperture portion can be closed by the one mold. As a result of the above, a space portion is sealed off from the outside.

After the sandwiching by this pair of molds, molten resin is poured into a resin forming space whose boundaries are formed by the one mold, the lid body, the aperture portion, and the circuit board. As a result, a resin mold portion is formed in which a distal end portion of the aperture portion is exposed to the outside. At this time, because the gap between the bottom end portion of the lid body and the circuit board and the gap between the one mold and the aperture end of the aperture portion are closed by the pressing of the aperture portion by the one mold, molten resin that is poured into the resin forming space can be prevented from flowing into the space portion.

Moreover, as a result of the lid frame being pressed against the circuit board by the pair of molds, the relative position positions of the lid frame and the circuit board can be fixed. Accordingly, when forming the resin mold portion it is possible to prevent the lid frame being moved relative to the circuit board by the molten resin flowing into the resin forming space.

Moreover, according to the above described semiconductor device, when the semiconductor chip is a sound pressure sensor chip or a pressure sensor chip that is provided with a diaphragm, when pressure variations such as noise and the like reach the diaphragm from the outside via the aperture portion and the chip through hole in the stage portion, the diaphragm of the semiconductor chip vibrates based on these pressure variations, thereby enabling the pressure variations to be detected.

The volume of the chip covering lid body or of the first or second space portions whose boundaries are formed by the chip covering lid body can be easily altered in accordance only with the shape or size of the lid body without the design of the stage portion being altered. Accordingly, it is possible to secure a sufficient volume for the first or second space portions, and it is possible to keep to a minimum any changes in the pressure of the first or second space portions that are caused by the vibrating of the diaphragm. Because of this, the diaphragm of the semiconductor chip can be made to vibrate correctly by a deformation amount that is proportionate to the pressure vibrations of the noise or the like from the outside without being affected by changes in the pressure of the first or second space portions.

Moreover, in the embodiment in which the stage portion is supported in an elevated state by the connection leads, the layer thickness of the second resin layer can be increased. When this second resin layer is being formed, the protruding portion of the mold can be extended to below the stage portion so that the second space portion can be formed having a large volume. Accordingly, it is possible to keep to a minimum any changes in the pressure of the chip through hole and the second space portion that occur in conjunction with the vibrating of the diaphragm, and it is possible to prevent the deformation of the diaphragm being obstructed. As a result, the diaphragm can be made to vibrate correctly by a deformation amount that corresponds to the applied pressure so that pressure detected by this semiconductor device is accurate.

Furthermore, in a semiconductor device in which a protruding portion is formed in the lid body, a distal end portion of the protruding portion is exposed to the outside from the resin mold portion in order that the distal end portion of the protruding portion can be placed in contact with the mold when the resin mold portion is being formed using a mold. Namely, when this semiconductor device is being manufactured, a circuit board and a lid frame are sandwiched in the thickness direction of the circuit board by a pair of molds that are used to form the resin mold portion. Here, because the protruding portion of the lid frame extends from a top end portion of the lid body in a direction in which it moves further away from the circuit board, one mold is in contact with the distal end portion of the protruding portion and a gap is formed between the other mold and the top end portion of the lid body.

Because it is sandwiched by the pair of molds, the protruding portion is pressed towards the circuit board. Because a bottom end portion of the lid body that is in contact with the circuit board is pressed against the circuit board by the pressing of the protruding portion, the gap between the bottom end portion of the lid body and the circuit board can be closed. Namely, the space portion is sealed off from the outside.

After the sandwiching by this pair of molds, molten resin is poured into a resin forming space whose boundaries are formed by the one mold, the lid body, and the circuit board. As a result, a resin mold portion is formed in which the distal end portion of the protruding portion is exposed to the outside. At this time, because the gap between the bottom end portion of the lid body and the circuit board is closed by the pressing force of the protruding portion, molten resin that is poured into the resin forming space can be prevented from flowing into the space portion.

Moreover, as a result of the lid frame being pressed against the circuit board by the pair of molds, the relative position positions of the lid frame and the circuit board can be fixed. Accordingly, when forming the resin mold portion it is possible to prevent the lid frame being moved relative to the circuit board by the molten resin flowing into the resin forming space.

As a result, according to the present invention, it is no longer necessary to perform a step to fix the lid frame which covers the semiconductor chip to the circuit board, or to perform a step of forming through holes in the circuit board. As a result, it is possible to reduce costs when manufacturing a semiconductor device in which a semiconductor chip that is placed in the space portion is connected to an external space, and it is possible to achieve an improvement in the manufacturing efficiency.

### BRIEF DESCRIPTION OF THE DRAWINGS

FIG 1 is a side cross-sectional view showing a semiconductor device according to a first embodiment of the present invention.
FIG 2 is a cross-sectional view showing an example of a semiconductor chip that is used in the semiconductor device according to the first example of the present invention shown in FIG 1.
FIG 3 is a side cross-sectional view showing a method of manufacturing the semiconductor device shown in FIG 1.
FIG 4 is a side cross-sectional view showing a method of manufacturing the semiconductor device shown in FIG 1.
FIG 5 is a side cross-sectional view showing a method of manufacturing the semiconductor device shown in FIG 1.
FIG 6 is a side cross-sectional view showing a semiconductor device according to a second embodiment of the present invention.
FIG 7 is a cross-sectional view showing an example of a method of transporting a semiconductor device according to an embodiment of the present invention.
FIG 8 is a plan cross-sectional view showing a semiconductor device according to a third embodiment of the present invention as seen from a surface of a stage portion.
FIG 9 is a plan cross-sectional view showing a semiconductor device according to the third embodiment of the present invention as seen from another surface of a stage portion.
FIG 10 is a side cross-sectional view showing a semiconductor device according to the third embodiment of the present invention.
FIG 11 is a plan view showing a lead frame that is used in the manufacturing of the semiconductor device according to the third embodiment of the present invention shown in FIG 10.
FIG 12 is a side cross-sectional view showing a method of manufacturing the semiconductor device shown in FIG 10.
FIG 13 is a side cross-sectional view showing a method of manufacturing the semiconductor device shown in FIG 10.
FIG 14 is a side cross-sectional view showing a variant example of a through electrode in the semiconductor device according to the third embodiment of the present invention.
FIG 15 is a side cross-sectional view showing a first variant example of the semiconductor device according to the third embodiment of the present invention.
FIG 16 is a side cross-sectional view showing a second variant example of the semiconductor device according to the third embodiment of the present invention.
FIG 17 is a side cross-sectional view showing a third variant example of the semiconductor device according to the third embodiment of the present invention.
FIG 18 is a plan cross-sectional view showing a semiconductor device according to a fourth embodiment of the present invention as seen from a surface of a stage portion.
FIG 19 is a plan cross-sectional view showing a semiconductor device according to the fourth embodiment of the present invention as seen from another surface of a stage portion.
FIG 20 is a side cross-sectional view showing a semiconductor device according to the fourth embodiment of the present invention.
FIG 21 is a side cross-sectional view showing a semiconductor device according to a fifth embodiment of the present invention.
FIG 22 is a side cross-sectional view showing a semiconductor device according to a sixth embodiment of the present invention.
FIG 23 is a side cross-sectional view showing the semiconductor device according to the sixth embodiment of the present invention shown in FIG 23.
FIG 24 is a plan view showing a lead frame that is used in the manufacturing of the semiconductor device according to the sixth embodiment of the present invention shown in FIG 23.
FIG 25 is a cross-sectional view showing the lead frame shown in FIG 24.
FIG 26 is a side cross-sectional view showing a method of manufacturing the semiconductor device shown in FIG 23.
FIG 27 is a side cross-sectional view showing a method of manufacturing the semiconductor device shown in FIG 23.
FIG 28 is a side cross-sectional view showing a method of manufacturing the semiconductor device shown in FIG 23.
FIG 29 is a cross-sectional view showing a variant example of the semiconductor device according to the sixth embodiment of the present invention.
FIG 30 is a cross-sectional view showing a method of manufacturing the variant example of the semiconductor device according to the sixth embodiment of the present invention.
FIG 31 is a side cross-sectional view showing a semiconductor device according to a seventh embodiment of the present invention.
FIG 32 is a cross-sectional view showing a method of manufacturing the semiconductor device shown in FIG 31.
FIG 33 is a side cross-sectional view showing a method of manufacturing the semiconductor device shown in FIG 31.
FIG 34 is a side cross-sectional view showing a method of manufacturing the semiconductor device shown in FIG 31.
FIG 35 is a side cross-sectional view showing a semiconductor device according to an eighth embodiment of the present invention.
FIG 36 is a cross sectional view showing an example of a semiconductor chip that is used in the semiconductor device according to the eighth embodiment of the present invention shown in FIG 35.
FIG 37 is a side cross-sectional view showing a method of manufacturing the semiconductor device shown in FIG 35.
FIG 38 is a side cross-sectional view showing a method of manufacturing the semiconductor device shown in FIG 35.
FIG 39 is a side cross-sectional view showing a method of manufacturing the semiconductor device shown in FIG 35.
FIG 40 is a side cross-sectional view showing a state in which the semiconductor device shown in FIG 35 is mounted on a package board.
FIG 41 is a side cross-sectional view showing a semiconductor device according to a ninth embodiment of the present invention.

### BEST MODE FOR CARRYING OUT THE INVENTION

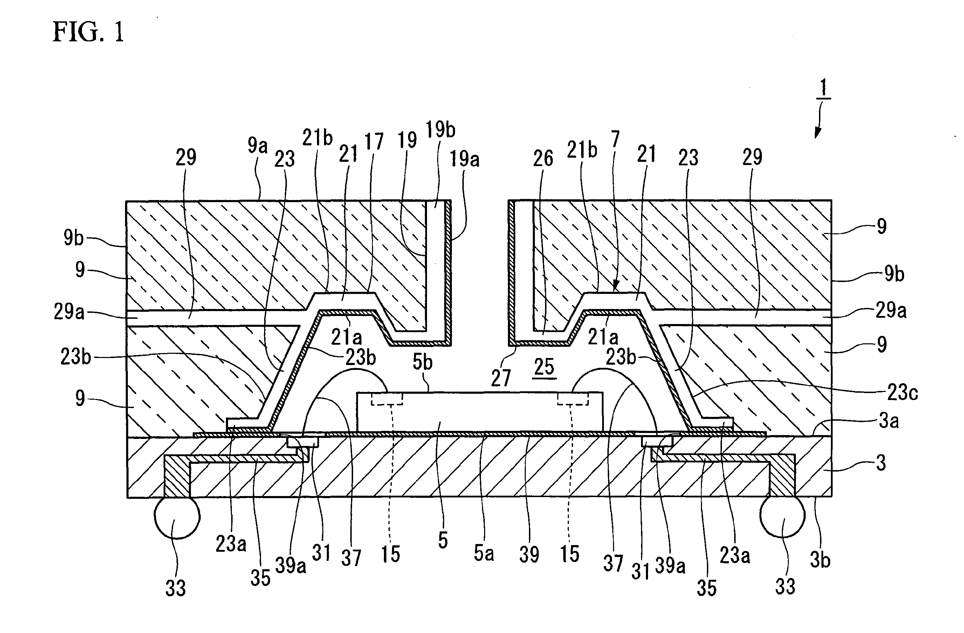

A first embodiment of the present invention is shown in FIG 1 through FIG 5. As is shown in FIG 1, this semiconductor device 1 is provided with a circuit board 3, a semiconductor chip 5 that is superimposed on one end side in the thickness direction of the circuit board 3, a lid frame 7, and a resin mold portion 9.

The semiconductor chip 5 is formed substantially in a plate shape, and a rear surface 5a thereof is adhesively fixed to a front surface 3a that is positioned on the one end side of the circuit board 3. This semiconductor chip 5 is, for example, a sound pressure sensor chip.

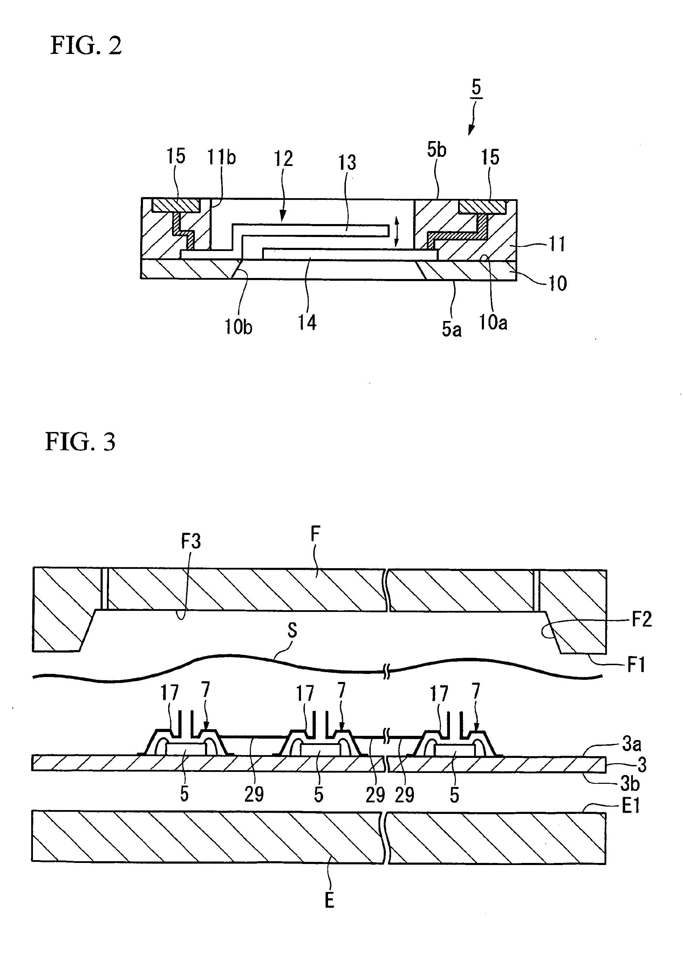

Namely, as is shown in FIG 2, this semiconductor chip 5 is constructed by stacking a multilayer printed circuit board 11 on a surface 10a of a silicon substrate 10, and then providing a condenser unit 12 in through holes 10b and 11b that penetrate in the thickness direction the silicon substrate 10 and the multilayer printed circuit board 11. The condenser unit 12 is formed by an oscillating electrode plate 13 that protrudes from an inner surface of the through holes 10b and 11b and a fixed electrode plate 14. The fixed electrode plate 14 is placed so as to overlap in the thickness direction via a minute gap with the oscillating electrode plate 13. The oscillating electrode plate 13 and the fixed electrode plate 14 are placed between the silicon substrate 10 in the multilayer printed circuit board 11.

In this condenser unit 12, when the oscillating electrode plate 13 oscillates based on sounds and changes in pressure that enter into the through hole 11b from a surface 5b side of the multilayer printed circuit board 11, changes in the gap between the oscillating electrode plate 13 and the fixed electrode plate 14 that are based on this vibration are output as changes in the electrostatic capacity between the oscillating electrode plate 13 and the fixed electrode plate 14.

Moreover, a plurality of pad electrodes 15 are formed so as to be exposed on the surface 5b of the multilayer printed circuit board 11. These pad electrodes 15 have a role of supplying power to the semiconductor chip 5, and also function as terminals to transmit to the outside output signals that are obtained from the condenser unit 12.

As is shown in FIG 1, the lid frame 7 is formed from a heat resistant thermosetting resin, and is provided with a lid body 17 that is placed on the front surface 3a of the circuit board 3 so as to cover the semiconductor chip 5, and a substantially cylindrical aperture portion 19 that protrudes from the lid body 17 while being formed integrally therewith.

The lid body 17 is provided with substantially plate-shaped top walls (i.e., top end portion) 21 that are placed in a position where they are separated in the thickness direction from the front surface 3a of the circuit board 3, and side walls 23 that protrude from peripheral edges of the top walls 21 towards the front surface 3a of the circuit board 3. Namely, the lid body 17 is formed by the top walls 21 and the side walls 23 substantially in a hollowed-out shape that opens onto a distal end portion 23a side of the side walls 23. In a state in which the distal end portion 23a of the side walls 23 is placed on the front surface 3a of the circuit board 3 that is positioned on the peripheral edges on the semiconductor chip 5, a hollow space portion 25 is created by the front surface 3a of the circuit board 3 and by inner surfaces 21a and 23b of the top walls 21 and side walls 23. Note that in this state, of the lid body 17, the top walls 21 are positioned the furthest away from the front surface 3a of the circuit board 3, and the inner surfaces 21a and 23b of the top walls 21 and side walls 23 are positioned such that they do not come into contact with the semiconductor chip 5.

The substantially cylindrical aperture portion 19 protrudes from a center portion of the top walls 21, in a direction in which it moves beyond the top walls 21 further away from the front surface 3a of the circuit board 3. This aperture portion 19 has the role of enabling the space portion 25 to open onto the outside of the resin mold portion 9, and the surface 5b of the semiconductor chip 5 is exposed to the outside via an insertion hole 19a of this aperture portion 19.

Moreover, the aperture portion 19 extends vertically upright relative to the front surface 3a of the circuit board 3 and the top surfaces 21b of the top walls 21, and can be elastically deformed relative to the lid body 17. Namely, as a result of deformation portions 26 that are formed in portions connecting the top walls 21 of the lid body 17 to the aperture portion 19 being elastically deformed, the aperture portion 19 is able to be moved elastically in a direction that is orthogonal to the front surface 3a of the circuit board 3.

Moreover, a thin film-shaped shield portion 27 that is formed on the inner surfaces 21a and 23b of the top walls 21 and side walls 23 facing the space portion 25 is provided on this lid frame 7. This shield portion 27 is formed by coating or blowing a conductive paste which has electroconductivity such as copper or silver or the like over the inner surfaces 21a and 23b of the top walls 21 and side walls 23 and also over inner surfaces of the insertion hole 19a of the aperture portion 19. Namely, electroconductivity is imparted to the lid body 17 and the aperture portion 19 by this shield portion 27. The shield portion 27 is formed so as to extend as far as distal end portions 23a of the side walls 23 of the lid body 17. When the lid frame 7 has been placed in position, the shield portion 27 is in contact with the front surface 3a of the circuit board 3, and the space portion 25 is covered by this shield portion 27.

In addition, a pair of joining portions 29 that extend integrally from peripheral edges of the top walls 21 in the longitudinal direction of the top walls 21 are formed in the lid frame 7.

On the circuit board 3 there are provided a plurality of pad electrodes 31 that are formed in a substantially plate shape and are placed on the front surface 3a, a plurality of solder balls (i.e., electrode portions) 33 that are placed on the rear surface 3b that is located on the other end side in the thickness direction of the circuit board 3, and wiring portions 35 that are placed inside the circuit board 3 and that electrically connect each of the plurality of pad electrodes 31 and solder balls 33. These wiring portions 35 are formed, for example, from copper foil.

The pad electrodes 31 are electrically connected by wires 37 to the pad electrodes 15 of the semiconductor chip 5. The pad electrodes 31 are positioned around the periphery of the area where the semiconductor chip 5 is placed and are exposed to the space portion 25. These pad electrodes 31 are formed, for example, by plating copper foil with nickel (Ni) having a thickness of 3 to 5 µm and gold (Au) having a thickness of 0.5 µm.

The solder balls 33 are formed substantially in a spherical shape, and protrude from the rear surface 3b of the circuit board 3.

A shield component 39 that has conductivity and takes the form of a thin film is provided on the front surface 3a of the circuit board 3. This shield component 39 is formed on the front surface 3a of the circuit board 3 in the areas facing the space portion 25, the area where the semiconductor chip 5 is placed, and the areas where the distal end portions 23a of the side walls 23 of the lid body 17 are placed. Namely, in a state in which the lid frame 7 has been placed on the front surface 3a of the circuit board 3, this shield component 39 is in contact with the shield portion 27 of the lid frame 7. Accordingly, the shield component 39 is constructed so as to enclose the space portion 25 including the semiconductor chip 5 as well as the shield portion 27 of the lid frame 7.

Note that as a result of the above, the above described semiconductor chip 5 is fixed to the front surface 3a of the circuit board 3 via this shielding component 39, and the distal end portion 23a of the side walls 23 of the lid frame 7 is also placed on the front surface 3a of the circuit board 3 via this shield component 39. However, holes 39a are formed in this shield component 39 avoiding the respective pad electrodes 31 in order that the pad electrodes 31 of the circuit board 3 are exposed to the space portion 25, so that the shield component 39 and the pad electrodes 31 are electrically insulated from each other.

The resin mold portion 9 is in contact with the front surface 3a of the circuit board 3 and also with outer surfaces 21b and 23c of the lid body 17 that are located on the opposite side from the inner surfaces 21a and 23b. In addition, the resin mold portion 9 surrounds the joining portions 29 and the aperture portion 19 of the lid frame 7, and fixes the circuit board 3 and the lid frame 7 in a single unit.

Note that an aperture end 19b of the aperture portion 19 that protrudes from the lid body 17 and distal end portions 29a of the joining portions 29 are exposed to the outside respectively at a surface 9a of the resin mold portion 9 that faces in the same direction as the front surface 3a of the circuit board 3, and at side surfaces 9b that are adjacent to the surface 9a.

Namely, the resin mold portion 9 is constructed so as to cover the semiconductor chip 5 via the hollow space portion 25 that is formed by the lid body 17. Note that in FIG 1, the resin mold portion 9 is depicted as being separated by the aperture portion 19 and the joining portions 29, however, in actual fact, the aperture portion 19 and the joining portions 29 are surrounded by a single resin mold portion 9, and the resin mold portion 9 is formed as a single unit.

Next, a method of manufacturing the semiconductor device 1 that has the above described structure above will be described.

Note that in this manufacturing method, a single circuit board 3 that is made up of a plurality of units that are composed of a plurality of pad electrodes 31, wiring portions 35, and a shielding component 39 is prepared in advance in order to construct the semiconductor device 1.

In addition, the semiconductor chips 5 are each adhered to the front surface 3a of the circuit board 3 via the respective shield components 39. This adhering of the semiconductor chips 5 is performed by placing the semiconductor chips 5 on the front surface 3a of the circuit board 3 via a silver paste, and then curing this silver paste. After this adhering has ended, plasma cleaning is performed in order to remove any contamination adhering to the surfaces 3a and 5b of the circuit board 3 and semiconductor chips 5, and particularly to the pad electrodes 15 and 31. After this, the wires 37 are placed in position by wire bonding and the pad electrodes 15 and 31 of the semiconductor chips 5 and the circuit board 3 are mutually electrically connected.

Thereafter, as is shown in FIG 3, a plurality of lid frames 7 that are integrally joined by the joining portions 29 are prepared (frame preparation step). In this frame preparation step, a plurality of lid frames 7 that are joined together are formed by an injection molding method using heat resistant thermosetting resin.

Next, the plurality of lid frames 7 are stacked on the front surface 3a of the circuit board 3 so that the respective semiconductor chips 5 are covered by the respective lid bodies 17 (frame placement step). Here, because the respective joining portions 29 are set such that the respective lid frames 7 are placed in predetermined positions covering the respective semiconductor chips 5, the positioning of the respective lid frames 7 relative to the plurality of semiconductor chips 5 can be performed easily.

A mold E having a flat surface E1 is then placed on the rear surface 3b side of the circuit board 3, and a mold (i.e., one mold) F having a recessed portion F2 that has been hollowed out from a surface F1 is placed opposite this on the front surface 3a side of the circuit board 3. Namely, the pair of molds E and F are constructed so as to sandwich the circuit board 3 in the thickness direction thereof.

At the same time as this pair of molds E and F is placed in position, a sheet S in the shape of a thin film that is able to be peeled off easily from the mold F and from the resin which forms the resin mold portion is placed between the circuit board 3 and lid frame 7 and the mold F (sheet placement step). This sheet S is elastically deformable and is formed, for example, from fluorine resin.

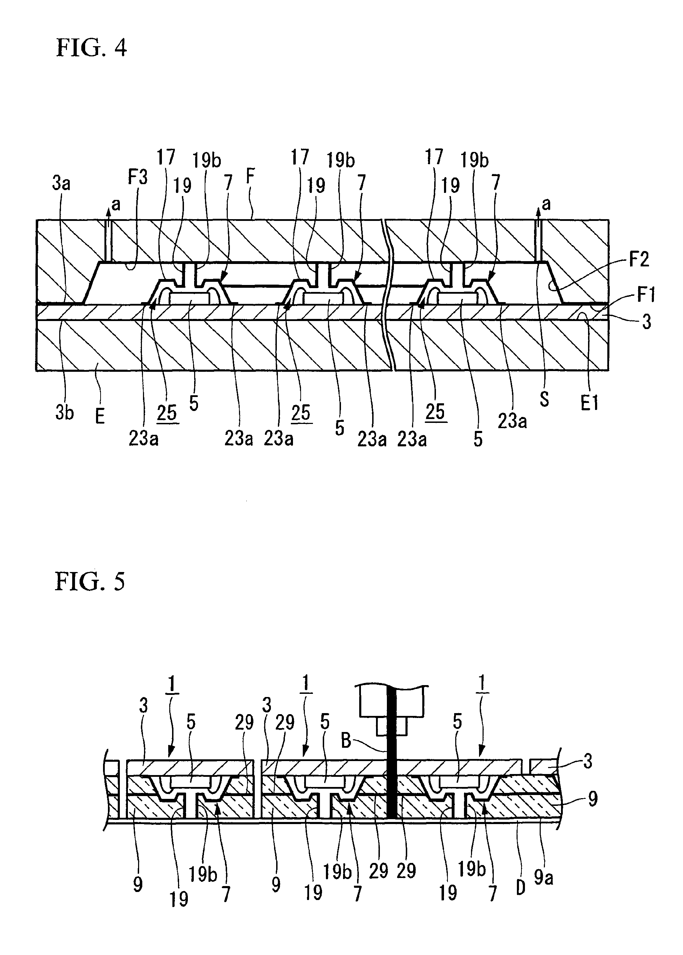

Thereafter, the mold F is moved in a direction towards the mold E and, as is shown in FIG 4, the circuit board 3 is sandwiched between the flat surface E1 and the surface F 1 of the pair of molds E and F, and the aperture portion 19 is pressed towards the circuit board 3 such that the aperture end 19b of the aperture portion 19 is blocked by a bottom surface F3 of the recessed portion F2 of the mold F (pressing step). Prior to this pressing step, the sheet S is stuck using a vacuum (i.e., the arrows a) to the bottom surface F3 of the mold F.

Accordingly, in a state in which this pressing step has been performed, the rear surface 3b of the circuit board 3 is in contact with the flat surface E1 of the mold E, and the front surface 3a of the circuit board 3 is in contact via the sheet S with the surface F1 of the mold F. Moreover, the aperture end 19b of the aperture portion 19 of the lid frame 7 abuts against the bottom surface F3 of the mold F. During this abutment, because the aperture end 19b of the aperture portion 19 is pressing against the sheet S, the sheet S is elastically deformed. Furthermore, because the aperture portion 19 extends from the lid body 17 in a direction in which it moves further away from the circuit board 3, a gap is formed between the mold F and the lid body 17.

In this pressing step, because the distal end portion 23a of the lid body 17 that is in contact with the circuit board 3 via the aperture portion 19 are pressing against the circuit board 3, the gap between the distal end portion 23a of the lid body 17 and the circuit board 3 can be sealed off.

Moreover, in this pressing step, the aperture portion 19 is elastically deformed relative to the lid body 17. Namely, because the distal end portion 23a of the lid body 17 is pressed by a moderate force onto the circuit board 3 due to the elastic force of the aperture portion 19, the gap between the distal end portion 23a of the lid body 17 and the circuit board 3 can be reliably sealed off

Furthermore, because the aperture end 19b of the aperture portion 19 is also pressed by a moderate force onto the mold F due to the elastic force of the aperture portion 19, and because the sheet S that is placed between the bottom surface F3 of the mold F and the aperture end 19b of the aperture portion 19 is elastically deformed, the gap between the aperture end 19b of the aperture portion 19 and the bottom surface F3 of the mold F can also be reliably closed. As a result of the above, the space portion 25 is tightly sealed off from the outside.

Moreover, during this pressing step, because the lid frame 7 is pressed by the pair of molds E and F onto the circuit board 3, the relative positions of the lid frame 7 and the circuit board 3 are fixed.

Furthermore, in this pressing step, the aperture portion 19 is elastically deformed relative to the lid body 17. Namely, the force with which the lid body 17 is pressed onto the circuit board 3 by the mold F can be absorbed by the elastic deformation of the aperture portion 19. Because of this, as a result of the elastic deformation of the aperture portion 19, it is possible to prevent the force with which the lid frame 7 is pressed against the circuit board 3 by the mold F being excessively transmitted to the lid body 17, and it is possible to prevent the lid body 17 becoming deformed.

Note that, if the abutment of the aperture end 19b of the aperture portion 19 against the sheet S in the pressing step is considered, it is preferable that the shape of the aperture end 19b of the aperture portion 19 is a rounded shape. Namely, by constructing the aperture end 19b of the aperture portion 19 in the manner described above, it is possible to prevent the aperture end 19b of the aperture portion 19 biting into the sheet S and notches being consequently generated in the sheet S, and to thereby prevent damage to the sheet S that is due to these notches. The rounded shape of the aperture end 19b may be created, for example, in the frame preparation step.

Thereafter, in a state in which the aperture portion 19 is pressed by the bottom surface F3 of the mold F, a thermosetting resin such as an epoxy resin is poured in a molten state into a single gap that is formed by the recessed portion F2 of the mold F, the circuit board 3, the plurality of lid bodies 17, and the aperture portion 19 so as to form a resin mold portion 9 in which the circuit board 3 and the plurality of lid frames 7 are fixed in a single unit (molding step). Note that the aforementioned gap refers to a resin forming space that is used to form the resin mold portion 9. Moreover, this resin mold portion 9 is formed by a transfer molding method in which molten resin is poured sequentially from an end portion of a single large resin forming space.

In this molding step, because the gap between the distal end portion 23a of the lid body 17 and the circuit board 3 is sealed off by the pressing force of the aperture portion 19, and because the gap between the mold F and the aperture end 19b of the aperture portion 19 is sealed off by the pressing force of the aperture portion 19 and the elastic pressure of the sheet S, it is possible to prevent the molten resin that is poured into the resin forming space entering into the space portion 25. Moreover, in this molding step, because the relative positions of the lid frame 7 and the circuit board 3 are already fixed, it is possible to prevent the lid frame 7 being moved relative to the circuit board 3 by the molten resin that is poured into the resin forming space.

Note that, in this molding step, after the resin forming space has been filled by the molten resin, the resin mold portion 9 is formed by then hardening the resin using heat, as is shown in FIG 5.

After this molding step, a sheet-shaped dicing tape (i.e., a screening seal) D is adhered onto the entire surface 9a of the resin mold portion 9 so that the aperture end 19b of the aperture portion 19 is sealed off by this dicing tape D (seal adhesion step). Thereafter, a dicing step is performed in which a blade B is used to cut up the individual semiconductor devices 1. At this time, the resin mold portion 9, the circuit board 3, and the joining portions 29 are cut, however, the dicing tape D is not cut. The cutting of this dicing tape D is performed after the completion of the dicing step.

Finally, the manufacturing of the semiconductor device 1 is ended when the solder balls 33 (see FIG 1) are mounted on the wiring portions 35 that are exposed on the rear surfaced 3b of the circuit board 3. Note that the dicing tape D remains adhered until the mounting of the semiconductor device 1 on a package board of an electronic device such as a mobile telephone or personal computer is completed.

When the semiconductor device 1 is mounted on a package board, the rear surface 3b of the circuit board 3 is positioned facing the surface of the package board, and the solder balls 33 are placed on land portions that are formed on the surface of the package board. By then pressing the semiconductor device 1 against the surface of the package board while applying heat to the solder balls 33, the solder balls 33 are fixed to the land portions and are also electrically connected thereto.

According to the above described semiconductor device 1, the method of manufacturing the semiconductor device 1, and the lid frame 7 that is used therein, simply by sandwiching the circuit board 3 and the lid frame 7 between the pair of molds E and F, it is possible to prevent molten resin flowing into the space portion 25 when the resin mold portion 9 is being formed, and it is possible to prevent the lid frame 7 moving relative to the circuit board 3. Accordingly, it is no longer necessary to perform a step to fix the lid frame 7 which covers the semiconductor chip 5 to the circuit board 3, or to perform a step of forming through holes in the circuit board 3. As a result, it is possible to reduce costs when manufacturing a semiconductor device 1 in which a semiconductor chip 5 that is placed in the space portion 25 is connected to an external space, and it is possible to achieve an improvement in the manufacturing efficiency.

Moreover, because the shield portion 27 of the conductive lid frame 7 and the shielding component 39 of the circuit board 3 surround the semiconductor chip 5, even if electrical noise that is generated on the exterior side of the semiconductor device 1 intrudes into the circuit board 3 and resin mold portion 9, in the lid frame 7 and the shielding component 39 the noise is prevented from intruding into the space portion 25 and the insertion hole 19a. Accordingly, this noise is reliably prevented from reaching the semiconductor chip 5, and any erroneous operation of the semiconductor chip 5 that is caused by such noise can be reliably prevented.

Furthermore, because the force with which the lid frame 7 is pressed in the pressing step against the circuit board 3 by the mold F which has the recessed portion F2 is prevented from being transmitted in excess to the lid body 17 by the elastic deformation of the aperture portion 19 so that the lid body 17 is prevented from becoming deformed, it is possible to prevent any irregularity in the space portion 25 that is caused by deformation of the lid body 17.

Moreover, because the distal end portion 23a of the lid body 17 is pressed by a moderate force onto the circuit board 3 due to the elastic force of the aperture portion 19, the gap between the distal end portion 23a of the lid body 17 and the circuit board 3 can be reliably sealed off. Furthermore, because the aperture end 19b of the aperture portion 19 is also pressed by a moderate force onto the mold F due to the elastic force of the aperture portion 19, and because the sheet S that is placed between the bottom surface F3 of the mold F and the aperture end 19b of the aperture portion 19 is elastically deformed, the gap between the aperture end 19b of the aperture portion 19 and the bottom surface F3 of the mold F can also be reliably sealed.

Furthermore, because the semiconductor device 1 has what is known as a surface package type of structure in which the solder balls 33 are only placed on the rear surface 3b side of the circuit board 3 which faces the package board, the package area of the semiconductor device 1 on the package board is limited to the surface area of the rear surface 3b of the circuit board 3. Accordingly, it is possible to reduce the mounting area of the semiconductor device 1 on the package board, and achieve a reduction in the size of the package board.

Moreover, when manufacturing a plurality of semiconductor devices 1, by joining together a plurality of the lid frames 7 using the joining portions 29, the positioning of the respective lid frames 7 on the respective semiconductor chips 5 that have been placed on the circuit board 3 can be performed easily. Moreover, it becomes possible to easily manufacture a plurality of semiconductor devices 1 simultaneously, and it is possible to achieve an improvement in the manufacturing efficiency of the semiconductor devices 1.

Furthermore, in the pressing step because the aperture portion 19 of the lid frame 7 is abutted against the bottom surface F3 of the mold F via the sheet S, it is possible to prevent the mold F becoming damaged by the contact with the aperture portion 19. Moreover, because the molding step is performed with the sheet S placed on the bottom surface F3 of the mold F, it is possible to prevent the mold F becoming contaminated by molten resin.

Because the aperture end 19b of the aperture portion 19 is sealed off by the dicing tape D from the end of the molding step until the semiconductor device 1 is mounted on an electronic instrument, any dust and dirt or moisture is prevented from entering through the aperture end 19b into the space portion 25 during the dicing step or when the semiconductor device 1 is being transported or mounted, and any erroneous operation of the semiconductor chip 5 that is caused by such dust and dirt or moisture can be reliably prevented.

Note that in the above described embodiment, the shield component 39 is placed on the front surface 3a of the circuit board 3, however, the present invention is not limited to this and it is also possible for the shield component 39 to be formed so as to surround the space portion 25 including at least the lid body 17 and the semiconductor chip 5. Namely, it is possible for a portion of the shield component 39 to be placed inside the circuit board 3.

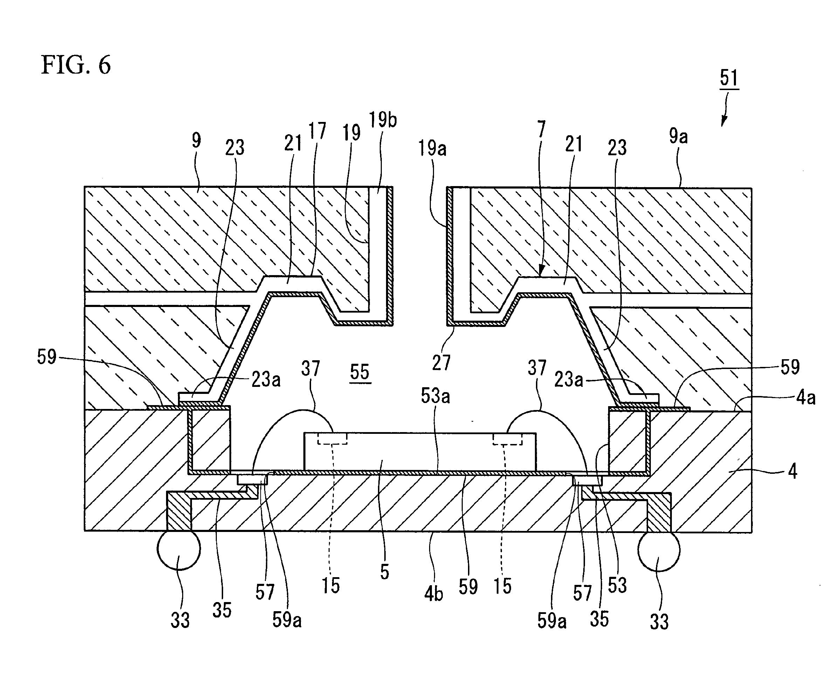

Next, a second embodiment of the present invention will be described with reference made to FIG 6. Note that, here, only points of variance with the first embodiment will be described and component elements that are the same as those of the semiconductor device 1 are given the same symbols and a description thereof is omitted.

As is shown in FIG 6, a recessed portion 53 that has a substantially rectangular shape in cross sectional view is formed in a circuit board 4 that constitutes a semiconductor device 51 according to this embodiment by being hollowed out in the thickness direction from a front surface 4a thereof. A semiconductor chip 5 is placed on a bottom surface 53a of this recessed portion 53.

A lid frame 7 is placed so as to extend across this recessed portion 53. Namely, the distal end portions 23a of the lid body 17 are placed on the front surface 4a of the circuit board 4 that is positioned on a peripheral edge of the recessed portion 53. In this state, a hollow space portion 55 is created by the recessed portion 53 of the circuit board 4 and the top walls 21 and side walls 23 of the lid frame 7.

A plurality of pad electrodes 57 that are electrically connected to the pad electrodes 15 of the semiconductor chip 5 by wires 37 are placed on the bottom surface 53a of the recessed portion 53. These pad electrodes 57 are electrically connected via wiring portions 35 to the plurality of solder balls 33 that are placed on the rear surface 4b of the circuit substrate 4.

Moreover, a shield component 59 that encloses the space portion 55 including the semiconductor chip 5 as well as the shield portion 27 of the lid frame 7 is provided on the circuit board 4. Namely, the shield component 59 is placed on the bottom surface 53a of the recessed portion 53, and is provided so as to be exposed from peripheral edges of the bottom surface 53a right through the interior of the circuit board 4 as far as the front surface 4a of the circuit board 4 that is positioned on the peripheral edges of the recessed portion 53. Accordingly, in a state in which the lid frame 7 is placed on the front surface 4a of the circuit board 4, the shield component 59 is in contact with the shield portion 27 of the lid frame 7.

Note that, as a result of the above, the semiconductor chip 5 is fixed to the front surface 4a of the circuit board 4 via this shield component 59, and the distal end portions 23a of the side walls 23 of the lid frame 7 are also placed on the front surface 4a of the circuit board 4 via this shield component 59. Holes 59a are formed in this shield component 59 avoiding the respective pad electrodes 57 in order that the pad electrodes 57 of the circuit board 4 are exposed to the space portion 55, so that the shield component 59 and the pad electrodes 57 are electrically insulated from each other.

The semiconductor device 51 that is constructed in the manner described above can be manufactured using the same pair of molds E and F as in the first embodiment.

According to the above described semiconductor device 51, the same effects can be achieved as those of the first embodiment.

In addition, because the semiconductor chip 5 and the pad electrodes 57 that are placed on the bottom surface 53a of the recessed portion 53 are electrically connected by the wires 37, it is possible to prevent the wires 37 from protruding to the outside of the recessed portion 53. Accordingly, when the frame placement step and the pressing step are being performed with these wires 37 having been placed in position, it is possible to reliably deform the wires 37 while preventing the wires 37 from coming into contact with the lid frame 7. Accordingly, when manufacturing the semiconductor device 51, it is possible to easily secure an electrical connection between the circuit board 4 and the semiconductor chip 5.

Note that, in the above described first and second embodiments, the aperture portion 19 protrudes from a center portion of the top walls 21, however, the present invention is not limited to this, and it is sufficient if the aperture portion 19 extends in a direction in which it moves further away from the front surfaces 3a and 4a of the circuit boards 3 and 4 beyond at least the top walls 21 so as to enable the space portions 25 and 55 to open onto the outside via the surface 9a of the resin mold portion 9. Namely, it is sufficient if the aperture portion 19 protrudes from the side walls 23 of the lid body 17. Even in this structure, because the aperture portion 19 is able to be pressed by the mold F, when manufacturing the semiconductor devices 1 and 51, it is possible to prevent molten resin flowing into the hollow spaces 25 and 55, and prevent the lid frame 7 being moved relative to the circuit boards 3 and 4.

Moreover, the shield portion 27 of the lid frame 7 is formed by coating a conductive paste over the inner surfaces 21a and 23b of the top walls 21 and side walls 23 that constitute the lid body 17, and also over the inner surfaces of the insertion hole 19a of the aperture portion 19, however, the present invention is not limited to this, and it is sufficient if electrical noise is prevented from entering into the space portions 25 and 55 at least via the lid body 17. Namely, the shield portion 27 may be formed, for example, by coating a conductive paste over the outer surfaces of the top wall 21 and the side walls 23, and also over the outer circumferential surface of the aperture portion 19, or by immersing these in a conductive paste.

Furthermore, it is also possible, for example, to form the lid frame 7 using a conductive resin, and coat a non-conductive resin on the inner surfaces 21a and 23b of the lid body 17 that face the space portions 25 and 55, and on the inner surface of the insertion hole 19a of the aperture portion 19. It is also possible coat both the non-conductive resin and the shield portion 27 on top of each other on these inner surfaces 21a and 23b.

Moreover, the lid body 17 and the aperture portion 19 are provided with conductivity, however, the present invention is not limited to this, and it is sufficient if at least the lid body 17 that constitutes the space portions 25 and 55 is provided with conductivity.

Furthermore, the lid frame 7 is formed from a heat-resistant thermosetting resin, however, it is sufficient if it is formed from at least a resin material. It is, however, preferable if the lid frame 7 is formed from a resin material that has sufficient heat resistance to prevent it from being thermally deformed when the lid frame 7 is heated in the molding step and when the semiconductor devices 1 and 51 are being packaged on the package board. Specifically, it is preferable if the lid frame 7 is formed from a resin material such as engineering plastic that is able to withstand heat up to approximately 170 to 180 °C.

Moreover, if consideration is given to the prevention of the intrusion of electrical noise into the space portions 25 and 55, then it is also possible to form the lid frame 7 from a conductive material such as a metal. In the case of this structure, the lid frame 7 is able to withstand higher temperatures during the molding step and during the packaging of the semiconductor device 1 on the package board. Moreover, because a conductive material has greater rigidity compared to a resin material, it is possible to prevent the top walls 21 and the side walls 23 of the lid frame 7 bending and becoming deformed in the molding step, and it is easy to secure the space portions 25 and 55.

Furthermore, the lid frame 7 is not limited to being formed from the above described resin material or conductive material. For example, if it is particularly important to prevent electrostatic charges in the semiconductor chip 5, then it is preferable for the lid frame 7 to be formed from a resin material in which carbon has been mixed.

When manufacturing the semiconductor devices 1 and 51, a plurality of lid frames 7 that are joined by the joining portions 29 were placed on the front surfaces 3a and 4a of the circuit boards 3 and 4, however, it is also possible to use individual lid frames 7 that do not have the joining portions 29.

Furthermore, the solder balls 33 that are electrically connected to the wiring portions 35 were provided on the rear surfaces 3b and 4b of the circuit boards 3 and 4, however, the present invention is not limited to this and it is sufficient if at least electrode portions that are to be electrically connected to the package board 45 are exposed on the rear surfaces 3b and 4b of the circuit boards 3 and 4.

Namely, it is also possible for these electrode portions to be formed integrally with the wiring portions 35, and it is also possible for the wiring portions 35 to be made to protrude from the rear surfaces 3b and 4b of the circuit boards 3 and 4.

Moreover, a single piece of dicing tape D was adhered over the plurality of semiconductor devices 1 and 51, however, the present invention is not limited to this and it is also possible, for example, to adhere individual screening seals onto the surface 9a of the resin mold portion 9 of the respective semiconductor devices 1 and 51 and thereby seal off the aperture ends 19b of the aperture portions 19.

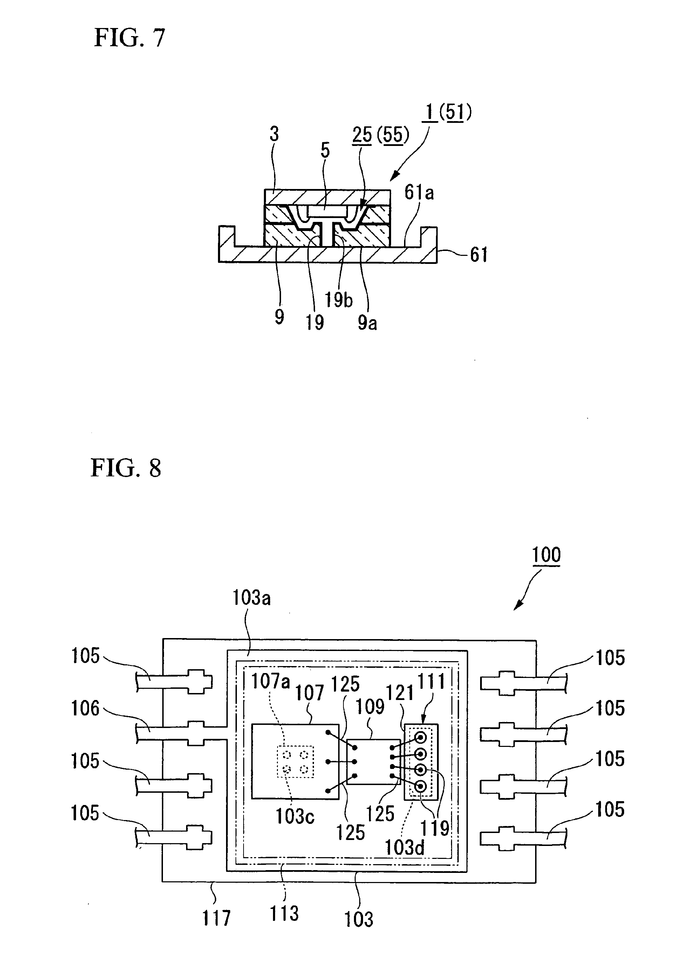

Furthermore, a screening seal such as the dicing tape D was adhered onto the surface 9a of the resin mold portion 9 in order to seal off the aperture ends 19b of the aperture portions 19, however, it is not essential for the screening seal to be adhered thereto. Namely, for example, as is shown in FIG 7, when transporting semiconductor devices 1 and 51 that have completed the manufacturing process, it is also possible for the surface 9a of the resin mold portion 9 to be positioned facing a surface 61a of a transporting tray (i.e., mounting base) 61 on which the semiconductor devices 1 and 51 are mounted for transporting. In the case of this structure as well, it is possible to prevent dust and dirt or moisture from entering the hollow spaces 25 and 55 through the aperture end 19b when the semiconductor devices 1 and 51 are being transported, and any erroneous operation of the semiconductor devices 1 and 51 that might be caused by this dust and dirt or moisture can be prevented.

Moreover, the semiconductor chip 5 and the circuit boards 3 and 4 are electrically connected by the wires 37, however, the present invention is not limited to this and it is simply sufficient for the semiconductor chip 5 and the circuit boards 3 and 4 to be electrically connected. Namely, it is also possible, for example, for the semiconductor chip 5 to be placed on the front surface 3a or the bottom surface 53a of the recessed portion 53 of the circuit boards 3 and 4 so that the pad electrodes 15, 31, and 57 of the semiconductor chip 5 and the circuit boards 3 and 4 are facing each other.

Furthermore, a sound pressure sensor chip is described above as an example of the semiconductor chip 5, however, the semiconductor chip 5 may also be a pressure sensor chip that, for example, measures the pressure of a space outside the semiconductor device 1 and also changes in this pressure.

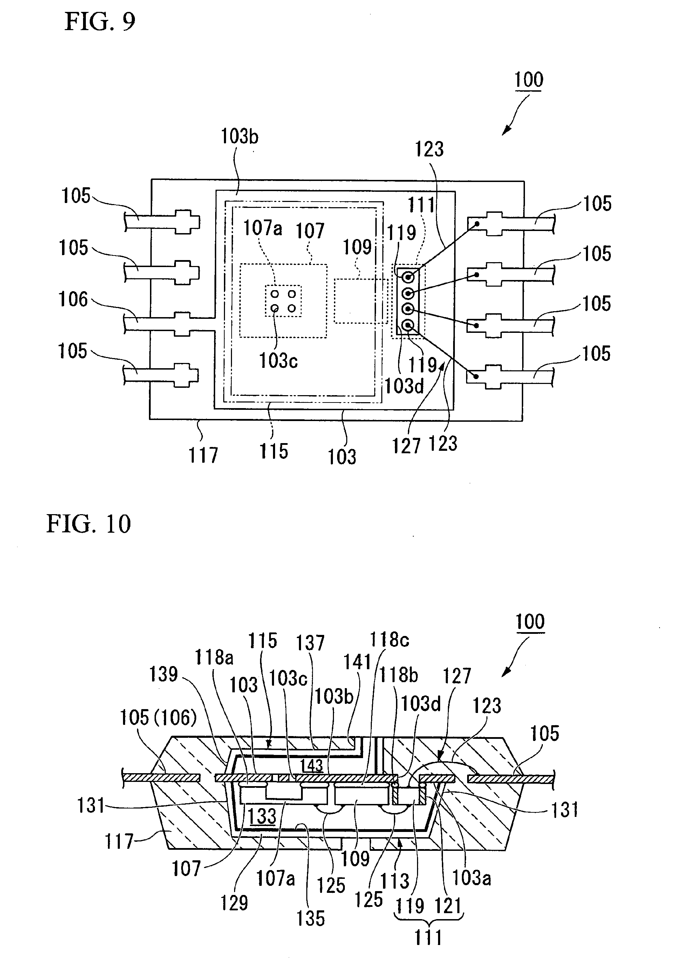

FIG 8 through FIG 13 show a third embodiment of the present invention. As is shown in FIG 8 through FIG 10, a semiconductor device 101 is provided with a metal stage portion 103 that is formed substantially in a plate shape, a plurality of metal electrical connection leads 105 and a connecting lead 106 that are placed around the stage portion 103, a semiconductor chip 107, an IC 109, and a through electrode 111 that are placed on a rear surface (i.e., one surface) 103a of the stage portion, a chip covering lid body 113 that is placed on the rear surface 103a of the stage portion 103, a stage covering lid body 115 that is placed on a front surface (i.e., another surface) 103b of the stage portion 103, and a resin mold portion 117 that fixes the stage portion 103, the leads 105 and 106, the chip covering lid body 113, and the stage covering lid body 115 in a single integral unit.

The stage portion 103 is formed substantially in a rectangular shape when seen in plan view, and a plurality of chip through holes 103c and a wiring through hole 103d are provided so as to penetrate in the thickness direction of the stage portion 103.

The plurality of leads 105 and 106 are arranged in parallel with a direction that extends along the rear surface 103a and the front surface 103b of the stage portion 103, and distal end portions thereof protrude from side portions of the resin mold portion 117. Note that, although omitted from the drawings, it is also possible for the distal end portions of the respective leads 105 and 106 to be formed so as to extend in the thickness direction of the stage portion 103, so that the semiconductor device 101 is formed as what is known as a quad flat package (QFP). The connecting lead 106 is connected to the stage portion 103, while the other electrical connection leads 105 are positioned such that a gap is provided between them and the stage portion 103. A portion of these electrical connection leads 105 are electrically connected via the through electrode 111 and the IC 109 to the semiconductor chip 107 (described below).

The semiconductor chip 107 is adhesively fixed via a non-conductive adhesive agent 118a which is electrically non-conductive to the rear surface 103a of the stage portion 103 so as to cover the chip through holes 103c in the stage portion 103. Namely, the semiconductor chip 107 is electrically insulated from the stage portion 103. The semiconductor chip 107 is what is known as a sound pressure sensor chip that converts sound into electrical signals, and is provided with a diaphragm 107a that vibrates in accordance with sound that reaches the semiconductor chip 107. This diaphragm 107a is placed on the rear surface 103a of the stage portion 103 so as to face the chip through holes 103c.

The through electrode 111 is provided with a plurality of insertion terminal portions 119 that are formed from a conductive material, and a non-conductive supporting block 121 that is formed from an electrically non-conductive material and supports the respective insertion terminal portions 119 from the periphery thereof. The through electrodes 111 are adhesively fixed via a non-conductive adhesive agent 118b, in the same way as the semiconductor chip 107, to the rear surface 103a of the stage portion 103 so as to cover the wiring through hole 103d. The plurality of insertion terminal portions 119 are exposed not only on the rear surface 103a side of the stage portion 103, but also on the front surface 103b side of the stage portion 103 via the wiring through hole 103d, and are electrically connected to the plurality of leads 105 by wires (i.e., second wires) 123 via the wiring through hole 103d.

The IC 109 controls operations of the semiconductor chip 107, and, in the same way as the semiconductor chip 107, is adhesively fixed via a non-conductive adhesive agent 118c to the rear surface 103a of the stage portion 103 so as to be positioned between the semiconductor chip 107 and the through electrode 111. This IC 109 is electrically connected to the semiconductor chip 107 and the respective insertion terminal portions 119 of the through electrode 111 by a plurality of wires (i. e., first wires) 125.

An electrical wiring device 127 that connects the semiconductor chip 107 to the leads 105 is formed by the IC 109, the though electrodes 111, and the wires 123 and 125.

The chip covering lid body 113 is placed on the rear surface 103a of the stage portion 103 so as to cover the semiconductor chip 107, the IC 109 and the through electrode 111. This chip covering lid body 113 is provided with a substantially plate-shaped top wall 129 that is placed at a position separated in the thickness direction from the rear surface 103a of the stage portion 103, and side walls 131 that protrude from peripheral edges of the top wall 129 towards the rear surface 103a of the stage portion 103. Namely, the chip covering lid body 113 is formed by the top wall 129 and the side walls 131 substantially in a concave shape that is open on the distal end portion side of the side walls 131.

Accordingly, in a state in which the distal end portions of the side walls 131 are placed on the rear surface 103a of the stage portion 103, a hollow first space portion 133 is created by the rear surface 103a of the stage portion 103 and the inner surfaces of the top wall 120 and side walls 131. Note that in this state, the inner surfaces of the top wall 129 and side walls 131 are positioned so as not to come into contact with the semiconductor chip 107 and the wires 125 that are located in the first space portion 133.

The chip covering lid body 113 is formed from a conductive material, and is constructed by coating a non-conductive paste (i.e., chip insulating portion) 135 that is formed from an electrically non-conductive material on inner surfaces of the top wall 129 and side walls 131 that face the first space portion 133. The chip covering lid body 113 is also electrically connected to the stage portion 103. Accordingly, the semiconductor chip 107 and the IC 109 are also electrically enclosed by the stage portion 103 and the chip covering lid body 113 which has conductivity. Moreover, the non-conductive paste 135 makes it possible to prevent the semiconductor chip 107, the IC 109, the through electrode 111, and the wires 125 that are located in the first hollow space 133 from becoming electrically conductive with the chip covering lid body 113.

The stage covering lid body 115 is located on the front surface 103b of the stage portion 103 so as to cover the chip through holes 103c. This stage covering lid body 115 is provided with a substantially plate-shaped top wall 137 that is placed at a position separated in the thickness direction from the front surface 103b of the stage portion 103, and side walls 139 that protrude from peripheral edges of the top wall 137 towards the front surface 103b of the stage portion 103, and also with a substantially cylindrical aperture portion 141 that protrudes from the top wall 137 in a direction in which it moves away from the front surface 103b of the stage portion 103. Namely, the stage covering lid body 115 is formed by the top wall 137 and the side walls 139 substantially in a concave shape that is open on the distal end portion side of the side walls 139.

Accordingly, in a state in which the distal end portions of the side walls 139 are placed on the front surface 103b of the stage portion 103, a hollow second space portion 143 is created by the front surface 103b of the stage portion 103 and the inner surfaces of the top wall 137 and side walls 139.

The substantially cylindrical aperture portion 141 has the role of enabling the second space portion 143 to be exposed to the outside of the resin mold portion 117, and the semiconductor chip 107 is placed in a position where it is connected to the outside via the chip through holes 103c, the second hollow space 143, and the aperture portion 141. Namely, the chip through holes 103c and the semiconductor chip 107 are offset so as not to overlap with each other in the thickness direction of the aperture portion 141 and the stage portion 103 such that they are not exposed directly to the outside through the aperture portion 141 of the stage covering lid body 115.

Moreover, in the same way as the chip covering lid body 113, the stage covering lid body 115 is formed from a conductive material and is electrically connected to the stage portion 103. Accordingly, the second space portion 143 is also electrically enclosed by the stage portion 103 and the stage covering lid body 115 which has conductivity.

Next, a method of manufacturing the semiconductor device 101 that has the above described structure above will be described.

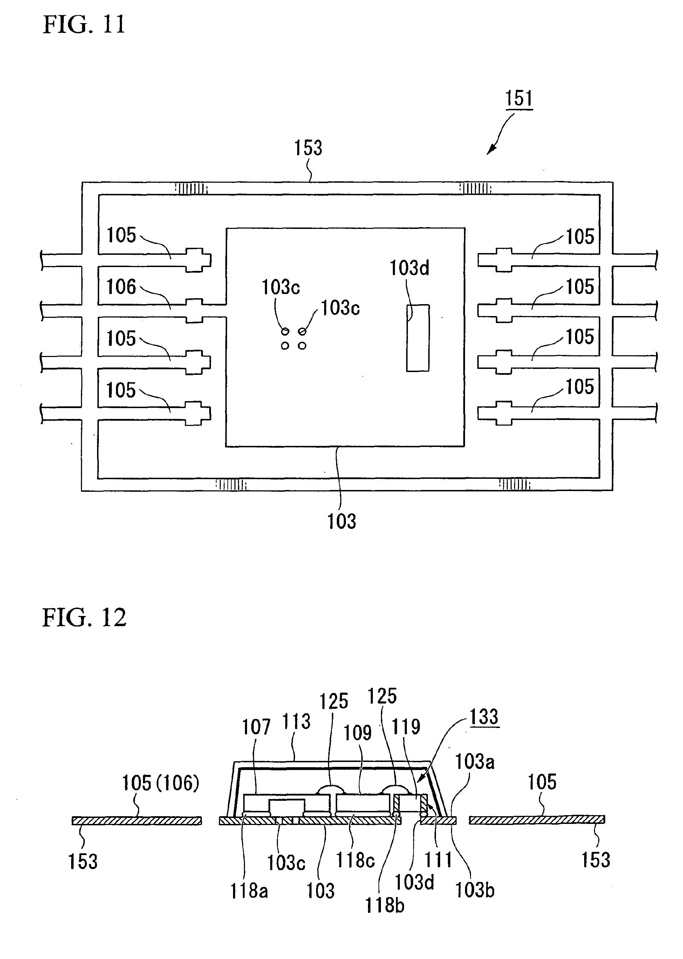

Firstly, as is shown in FIG 11, a lead frame 151 in which the stage portion 103 and the plurality of leads 105 and 106 are joined together as a single unit is formed by performing a pressing process or an etching process or by performing both processes on a thin plate-shaped metal plate (frame preparation step). Namely, the plurality of leads 105 and 106 are joined together by a rectangular frame portion 153 that is formed so as to surround the stage portion 103, and the electrical connection leads 105 and the stage portion 103 are mutually connected via this rectangular frame portion 153 and the connecting lead 106.

Moreover, in this frame preparation step, the chip through holes 103c and the wiring through hole 103d that penetrate in the thickness direction of the stage portion 103 are formed at the same time as the stage portion 103, the leads 105 and 106, and the rectangular frame portion 153 in the aforementioned pressing process or etching process.

Next, as is shown in FIG 12, the semiconductor chip 107 is adhesively fixed using a non-conductive adhesive agent 118a to the rear surface 103a of the stage portion 103 such that the semiconductor chip 107 overlaps with the chip through holes 103c in the thickness direction of the stage portion 103 (chip adhesion step).

In the same way as the semiconductor chip 107, the through electrode 111 is adhesively fixed to the rear surface 103a of the stage portion 103 using a non-conductive adhesive agent 118b (terminal portion mounting step). At this time, the insertion terminal portions 119 of the through electrode 111 are exposed from both the surface 103a and the surface 103b of the stage portion 103 via the wiring through hole 103d of the stage portion 103. In addition, the wiring through hole 103d is completely closed off by the through electrode 111. This terminal portion mounting step may be performed either before or after or at the same time as the chip adhesion step.

Furthermore, in the same way as the above described semiconductor chip 7 and through electrode 111, the IC 109 is also adhered to the rear surface 103a of the stage portion 103 via a non-conductive adhesive agent 118c. This adhering of the IC 109 may be performed either before or after or at the same time as the chip adhesion step and the terminal portion mounting step.

Next, the wires 125 are positioned respectively between the semiconductor chip 107 and the IC 109 and between the IC 109 and the through electrode 111 so that the semiconductor chip 107 and the insertion terminal portions 119 of the through electrode 111 are electrically connected via the IC 109 (a first wire placement step). Furthermore, the chip covering lid body 113 is placed on the rear surface 103a of the stage portion 103 so as to cover the semiconductor chip 107, the IC 109 and the through electrode 111. As a result, a first hollow space portion 133 that surrounds the semiconductor chip 107 is formed by the chip covering lid body 113 and the stage portion 103 (chip lid body placement step).

The chip adhesion step, the terminal portion mounting step, the first wiring step, and the chip lid body placement step are performed with the rear surface 103a of the stage portion 103 facing upwards.

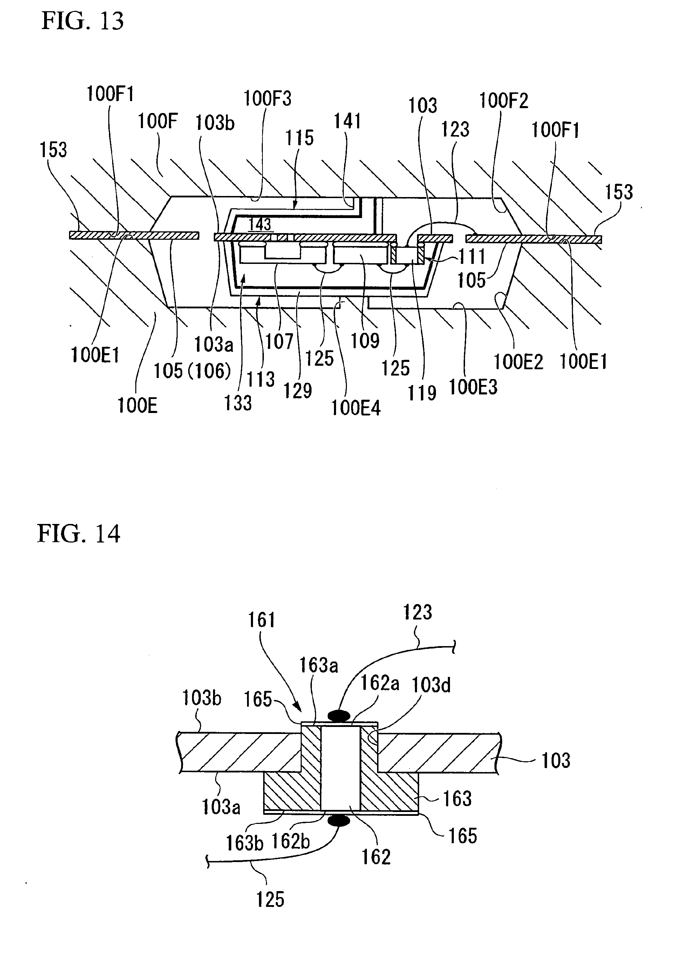

Thereafter, as is shown in FIG 13, with the front surface 103a of the stage portion 103 facing upwards, wire bonding is performed to place wires 123 between the plurality of leads 105 and the insertion terminal portions 119 via the wiring insertion holes 103, thereby electrically connecting the leads 105 to the through electrode 111 (second wire placement step).

In addition, the stage covering lid body 115 is placed on the front surface 103b of the stage portion 103 so as to cover the front surface 103b of the stage portion 103 including the chip through holes 103c. As a result, a second hollow space portion 143 is formed by the stage covering lid body 115 and the stage portion 103 (stage lid body placement step). This stage lid body placement step may be performed prior to the second wire placement step or subsequent to the second wire placement step.

Thereafter, a pair of molds 100E and 100F that are used to form a resin mold portion are placed on the front surface 103b side and the rear surface 103a side of the stage portion 103, and distal end portions of the leads 105 and 106 as well as the rectangular frame portion 153 are sandwiched by surfaces 100E1 and 100F1 of this pair of molds 100E and 100F. The one mold 100E that is placed on the rear surface 103a side of the stage portion 103 has a recessed portion 100E2 that is hollowed out from the surface 100E1, while the other mold 100F that is placed on the front surface 103b side of the stage portion 103 has a recessed portion 100F2 that is hollowed out from the surface 100F1.

In a state of being sandwiched by the pair of molds 100E and 100F, the chip covering lid body 113 is housed within the recessed portion 100E2 of the one mold 100E. In addition, a portion of the top wall 129 thereof abuts against a protruding portion 100E4 that is formed so as to protrude from a bottom surface 100E3 of the recessed portion 100E2. At this time, the chip covering lid body 113 is pressed against the rear surface 103a of the stage portion 103 by the protruding portion 100E4 of the one mold **100E.**

Moreover, in this state, the stage covering lid body 115 is housed within the recessed portion 100F2 of the other mold 100F. In addition, the distal end of the aperture portion 141 thereof abuts against a bottom surface 100F3 of the recessed portion 100F2, so that the aperture portion 141 is closed off by the bottom surface 100F3 of this recessed portion 100F2. At this time, the stage covering lid body 115 is pressed against the front surface 103b of the stage portion 103 by the other mold 100F.

Note that when the leads 105 and 106 and the rectangular frame portion 153 are being sandwiched by the pair of molds 100E and 100F, it is preferable for a resin sheet (not shown) that is in the shape of a thin film and is able to be peeled off easily from the resin which forms the resin mold portion and from the respective molds 100E and 100F to be placed in the gap between the chip covering lid body 113 and the one mold 100E, and also in the gap between the stage covering lid body 115 and the other mold 100F. This resin sheet is formed, for example, from fluorine resin.

Thereafter, a thermosetting resin such as an epoxy resin is poured in a molten state into resin forming space that is formed by the pair of molds 100E and 100F, thereby forming a resin molded portion 117 in which the stage portion 103, the chip covering lead body 113, the stage covering lead body 115, and the leads 105 and 106 are fixed in a single integral unit (molding step).

In this molding step, because the protruding portion 100E4 of the one mold 100E presses the chip covering lid body 113 against the rear surface 103a of the stage portion 103, the gap between the chip covering lid body 113 and the rear surface 103a of the stage portion 103 can be reliably sealed off. Moreover, because the bottom surface 100F3 of the other mold 100F presses the aperture portion 141 of the stage covering lid body 115 against the front surface 103b of the stage portion 103, the gap between the stage covering lid body 115 and the front surface 103b of the stage portion 103 as well as the gap between the aperture portion 141 of the stage covering lid body 115 and the bottom surface 100F3 of the other mold 100F can be reliably sealed off.

As a result of the above, it is possible to prevent molten resin that has been poured into the resin forming space entering into the first space portion 133 and the second space portion 143. Moreover, because the wiring through hole 103d is also completely sealed off by the through electrode 111, the molten resin is also unable to flow into the first space portion 133 via the wiring through hole 103d.

Note that, in this molding step, after the resin forming space has been filled by the molten resin, the resin mold portion 117 is formed by then hardening the resin using heat, as is shown in FIGS. 8 through 10. Finally, the rectangular frame portion 153 is cut off and each of the leads 105 and 106 that protrude to the outside of the resin mold portion 117 are separated thereby ending the manufacturing of the semiconductor device 101.

When mounting a semiconductor device 101 that has been manufactured in the manner described above on an electronic device such as a mobile phone or the like, for example, the leads 105 and 106 that protrude to the outside from the resin mold portion 117 are mutually electrically connected with other electronic components and electrical components of the electronic device.

In this semiconductor device 101, when pressure variations such as sounds or the like reach the diaphragm 107a of the semiconductor chip 107 via the aperture portion 141, the second space portion 143, and the chip through holes 103c of the stage portion 103, the diaphragm 107a vibrates based on these pressure variations thereby enabling the pressure variations to be detected.

According to the above described semiconductor device 101 and to a method of manufacturing this semiconductor device, without the shape or size of the stage portion 103 having to be altered, the volume of the first space portion 133 can be easily altered in accordance with the shape and size of only the chip covering lid body 113 that is mounted in the chip lid body placement step. Accordingly, the volume of the first space portion 133 can be satisfactorily secured, and it is possible to reduce pressure changes in the first space portion 133 that are based on vibrations of the diaphragm 107a of the semiconductor chip 107. Because of this, the diaphragm 107 a of the semiconductor chip 107 is unaffected by pressure changes in the first space portion 133, and is able to vibrate accurately in response to pressure vibrations from sound or the like from the outside.

Moreover, because it is possible to easily alter the design of a semiconductor device 101 in accordance with the characteristics of the semiconductor chip 107, it is possible to improve the manufacturing efficiency of the semiconductor device 101 and to easily reduce the costs of manufacturing the semiconductor device 101.

In addition, according to the above described semiconductor device 101, by forming the second space portion 143 using the stage covering lid body 115 that is provided with the aperture portion 141, it is possible to easily change the position of the aperture portion 141 relative to the chip through holes 103c and the semiconductor chip 107. Namely, the chip through holes 103c and the aperture portion 141 are offset so as not to overlap with each other in the thickness direction of the stage portion 103 without incurring any increase in the costs of manufacturing the semiconductor device 101. Accordingly, even if dust and dirt or water droplets from the outside enter into the second space portion 143 via the aperture portion 141, it is easy to prevent this dust and dirt or water droplets directly reaching the semiconductor chip 7.

Furthermore, because the conductive stage portion 103 and the chip covering lid body 113 enclose the semiconductor chip 107, even if electrical noise that is generated on the outside of the semiconductor device 101 intrudes into the resin mold portion 117, in the stage portion 103 and the chip covering lid body 113 the noise is prevented from intruding into the first space portion 133 and is reliably prevented from reaching the semiconductor chip 107.

Because the conductive stage portion 103 and the stage covering lid body 115 overlap each other in the thickness direction of the stage portion 103, even if electrical noise that is generated on the outside of the semiconductor device 101 intrudes into the resin mold portion 117 from the front surface 103b side of the stage portion 103, in the stage portion 103 and the stage covering lid body 115 the noise is prevented from intruding into the first space portion 133 and is reliably prevented from reaching the semiconductor chip 107.

Because of the above, any erroneous operation of the semiconductor chip 107 that is caused by such noise can be reliably prevented.

Furthermore, by coating the non-conductive paste 135 on the inner surfaces of the chip covering lid body 113, it is possible to prevent the chip covering lid body 113, which is conductive, from becoming electrically connected to the electrical wiring such as the semiconductor chip 107 and the wires 125 that extend from the semiconductor chip 107. Consequently, short-circuiting of the electrical circuitry of the semiconductor device 101 can be prevented.

Moreover, by mutually electrically connecting each of the wires 125 and 123 that extend from the semiconductor chip 107 and the leads 105 via the wiring through hole 103d and the through electrode 111, even if the leads 105 are positioned on the outer side of the first space portion 133 where the semiconductor chip 107 has been placed, it is still possible to mutually electrically connect the semiconductor chip 107 and the leads 105.

Furthermore, according to the method of manufacturing the semiconductor device 101, because the stage portion 103 on which the semiconductor chip 107 has been placed, the leads 105, the chip through holes 103c, and the wiring through hole 103d and 106 can be formed simply by performing a pressing process or an etching process on a thin metal plate in the frame preparation step, the semiconductor device 101 can be manufactured at low cost compared with when a circuit board is used as is the case conventionally.

Moreover, because it is possible for the processing from the chip adhesion step to the chip lid body placement step to be performed with the rear surface 103a of the stage portion 103 facing upwards, and with the second wiring step subsequently performed with the front surface 103b of the stage portion 103 facing upwards, the semiconductor device 101 can be manufactured easily.

Note that in the above described embodiment, the through electrode 111 is adhesively fixed to the rear surface 103a of the stage portion 103 via the non-conductive adhesive agent 118b, however, the present invention is not limited to this, and it is also possible for the through electrode 111 to be fixed in a state of electrical insulation from the stage portion 103 so as to cover at least the wiring through hole 103d. Namely, it is also possible for the through electrode 111 to be adhesively fixed, for example, to the front surface 103b of the stage portion 103.

Moreover, for example as is shown in FIG 14, it is also possible for a through electrode 161 to be inserted through the wiring through hole 103d with no gap provided between them. Note that, in this structure as well, because the respective insertion terminal portions 162 are supported at the periphery thereof by a non-conductive supporting block 163, the respective insertion terminal portions 162 do not come into contact with the stage portion 103, namely, are electrically insulated from the stage portion 103. By employing this structure, the wiring through hole 3d can be easily and reliably sealed off, and the positioning of the through electrode 161 relative to the stage portion 3 can be performed easily.

Moreover, as is shown in FIG 14, when connecting surfaces 162a and 162b of the respective insertion terminal portions 162 to which end portions of the respective wires 123 and 125 are bonded are placed in a position where they protrude from the front surface 103b and rear surface 103a of the stage portion 103, then it is also possible to provide a conductive plating 165 extending from the connecting surfaces 162a and 162b of the insertion terminal portions 162 across end surfaces 163a and 163b of the non-conductive supporting block 163 which form a flat surface with the connecting surfaces 162a and 162b. In this case, the adhesion surface area of the respective wires 123 and 125 can be enlarged by the conductive plating 165. Accordingly, the respective wires 123 and 125 can be adhered easily without the wire bonder that is used to adhere the wires 123 and 125 having to be positioned with an unduly high degree of accuracy.

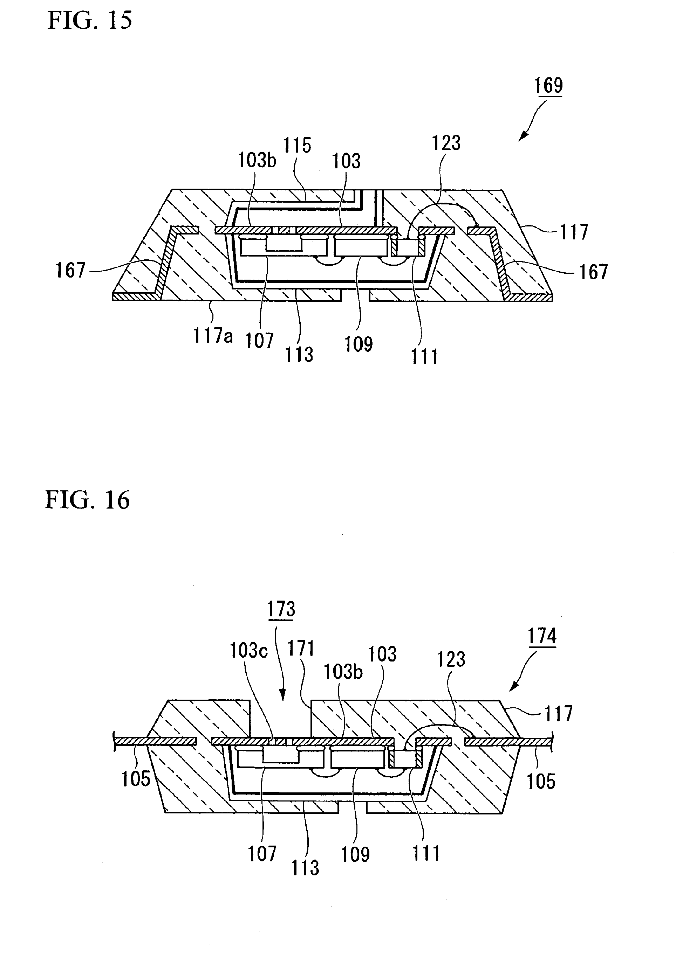

Furthermore, the plurality of leads 105 and 106 are made to protrude to the outside from side portions of the resin mold portion 117, however, the present invention is not limited to this. For example, as is shown in FIG 15, it is also possible for a plurality of leads 167 to be formed so as to be exposed directly from a bottom surface 117a of the resin mold portion 117. Namely, a semiconductor device 169 can be constructed as what is known as a quad flat non-lead (QFN).

Moreover, the stage covering lid body 115 is placed on the front surface 103b of the stage portion 103, however, the present invention is not limited to this and it is sufficient if the second space portion is formed such that at least the chip through holes 103c are in communication with the outside of the resin mold portion 117 via the front surface 103b of the stage portion 103. Namely, for example, as is shown in FIG 16, it is also possible to form a hole 171 in the resin mold portion 117 that allows the chip through holes 103c to be exposed to the outside, so that a second space portion 173 is formed by this hole 171.

Here, the second space portion 173 can be formed, for example, by providing protrusions that abut against the front surface 103b of the stage portion 103 on the mold that is used to form the resin mold portion. In this structure, as in the above described embodiment, the stage covering lid body 115 and the stage lid body placement step are unnecessary, thereby enabling an improvement in the manufacturing efficiency of the semiconductor device 174 to be achieved.

Note that when a conductive material is formed on inner surfaces of the hole 171 that forms this second space portion 173, it is possible to prevent externally generated noise reaching the semiconductor chip 107 via the resin mold portion 117.

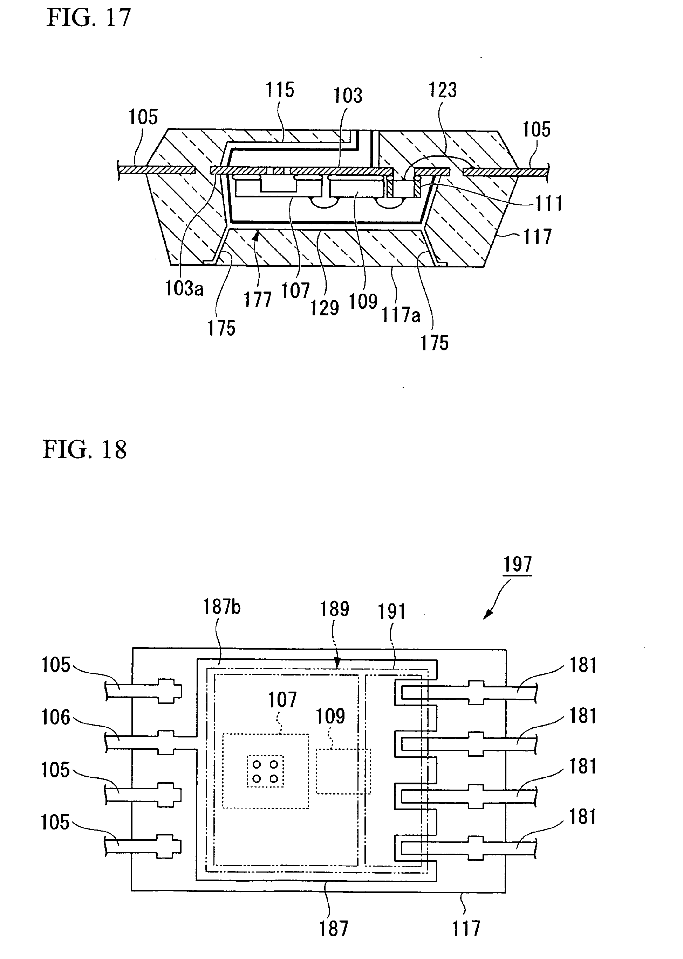

Furthermore, the chip covering lid body 113 is formed substantially in a concave shape that is open on the rear surface 103a side of the stage portion 103, however, for example, as is shown in FIG 17, in addition to this, it is also possible to create a chip covering lid body 177 that is formed integrally with protruding portions 175 that extend in a direction in which they move away from the rear surface 103a of the stage portion 103 beyond the top wall 129. Note that distal end portions of these protruding portions 175 are exposed to the outside at the bottom surface 117a of the resin mold portion 117 which is facing in the same direction as the rear surface 103a of the stage portion 103.

In the case of this structure, in the same way as in the above described embodiment, in the molding step, when the stage portion 103 is sandwiched in the thickness direction thereof by the pair of molds 100E and 100F, the protruding portions 175 can be abutted against the bottom surface 100E3 of the one mold 100E (see FIG 13). Because of this, the chip covering lid body 177 can be pressed by the one mold 100E against the rear surface 103a of the stage portion 103. Namely, it is no longer necessary to form the protruding portion 100E4 on the one mold 100E in order to hold the top wall 129, as in the above described embodiment, so that the one mold 100E can be manufactured at low cost.

Moreover, in this state, because a gap is formed by the protruding portions 175 between the top wall 129 and the bottom surface 100E3 of the one mold 100E, the entire top wall 129 can be embedded inside the resin mold portion 117.

Furthermore, in the above described structure, by making the respective protruding portions 175 able to be elastically deformed relative to the top wall 129 of the chip covering lid body 177, it is possible to limit the pressing force of the one mold 100E against the chip covering lid body 177 to a moderate size.

Moreover, the electrical wiring device 127 is formed by the IC 109, the through electrode 111, and the wires 123 and 125, however, the present invention is not limited to this, and it is sufficient if at least the semiconductor chip 107 and the leads 105 are electrically connected. Namely, for example, as is shown in FIGS. 18 to 20, it is also possible for leads 181 to be positioned such that they are exposed to a first space portion 183.

However, in the case of the above described structure, it is necessary to ensure that resin does not enter into the first space portion 183 through gaps between the respective leads 181 and a stage portion 187, or through gaps between mutually adjacent leads 181 and 181. Specifically, for example, it is possible to form a covering portion 191 on a stage covering lid body 189 that covers the gaps between the respective leads 181 and the stage portion 187, and to fill the gaps between mutually adjacent leads 181 and 181 by placing distal end portions of side walls 195 of the covering portion 191 and a chip covering lid body 193 in contact with each other.

In particular, when distal end portions of side walls 195 of the covering portion 191 and the chip covering lid body 193 are placed in contact with each other via polyimide tape, by changing the polyimide tape, the gaps between the respective leads 181 can be filled reliably and resin can be reliably prevented from entering into the first space 183. Moreover, because polyimide tape is non-conductive, it is possible to electrically insulate the leads 181 from the chip covering lid body 193 and the stage covering lid body 189.

In addition, in the case of this structure, it is possible to electrically connect the IC 109 to the leads 181 using the wires 185 without using the through electrode 111, as in the case of the third embodiment.

Moreover, in the case of this structure, because the aforementioned wires 185 are placed in the first space 183, the wires 185 do not come into contact with the resin mold portion 117. Because of this, when the resin mold portion is being formed using molten resin in the molding step, it is possible to prevent the wires 185 being pushed by the flow of molten resin and becoming deformed. Accordingly, it is possible to easily secure an electrical connection between the semiconductor chip 107 and the leads 181.

Furthermore, in the first wiring step, the semiconductor chip 107 and the IC 109 can be electrically connected by the wires 125 while the IC 109 and the leads 181 can be electrically connected directly by the wires 185. Because of this, it is no longer necessary to perform the second wiring step, as in the above described embodiments, and it is thus possible to achieve an improvement in the manufacturing efficiency of the semiconductor device 197.

Note that, when manufacturing the semiconductor device 197 having this structure, in the chip lid body mounting step of the manufacturing method of the above described embodiment, the chip covering lid body 193 is positioned such that the leads 181 are exposed in the first space portion 183, while in the stage lid body placement step, the stage covering lid body 189 may be positioned such that the leads 181 are covered by the covering portion 191.

In the structure of the fourth embodiment shown in FIG 18 through FIG 20, the covering portion 191 is formed on the stage covering lid body 189, however, the present invention is not limited to this and it is sufficient if the semiconductor device 197 is structured such that at least the molten resin does not enter into the first space portion 183. Namely, it is also possible, for example, for a non-conductive screening seal that covers the gap between the respective leads 181 and the stage portion 187 to be adhered onto a front surface (i.e., the other surface) 187b of the stage portion 187 and the leads 181. In the case of this structure, by applying the structure of the semiconductor device shown in FIG 16, both the stage covering lid body 189 and the stage lid body placement step are rendered unnecessary.

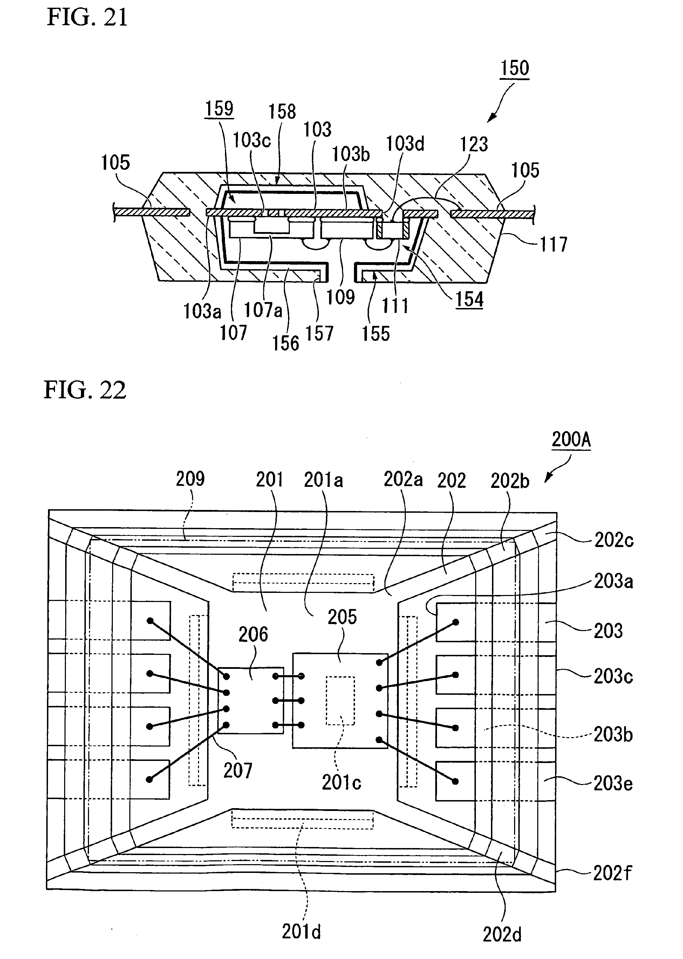

Moreover, in the above described embodiment, the first space portion 133 that encloses the semiconductor chip 107 is sealed off from the outside, however, as is shown in FIG 21, for example, it is also possible for a first space portion 154 to be exposed to the outside.

Namely, it is also possible for a chip covering lid body 155 that is placed on the rear surface 103a of the stage portion 103 to be provided with a substantially cylindrical aperture portion 157 that protrudes from a top wall 156 of the chip covering lid body 155 in a direction in which it moves away from the rear surface 103a of the stage portion 103. This aperture portion 157 has the role of allowing the first space portion 154 to be exposed to the outside of the resin mold portion 117. This aperture portion 157 is formed in a position where it does not overlap in the thickness direction of the stage portion 103 with the semiconductor chip 107 so that the semiconductor chip 107 is not directly exposed to the outside.

In this structure, when pressure variations such as sounds or the like reach the diaphragm 107a of the semiconductor chip 107 via the aperture portion 157 and the first space portion 154, the diaphragm 107a vibrates based on these pressure variations thereby enabling the pressure variations to be detected. Accordingly, it is also possible to employ a structure in which the stage covering lid body 158 that is placed on the front surface 103b of the stage portion 103 seals off the second space portion 159 to the outside. Namely, it is no longer necessary to form the same type of aperture portion as in the above described embodiments in this stage covering lid body 158.

Note that when manufacturing the semiconductor device 150, it is also possible to seal off the aperture portion 157 using the mold which is used to create the resin mold portion in order that molten resin does not flow through the aperture portion 157 into the first space portion 154 in the molding step.

In the case of this structure as well, in the same way as in the above described embodiment, because it is possible to easily alter the size of the sealed second space portion 159 in accordance with the shape and size of only the stage covering lid body 158, it is possible to improve the manufacturing efficiency of the semiconductor device 150 and to easily reduce the costs of manufacturing the semiconductor device 150.

Moreover, by forming the first space portion 154 using the chip covering lid body 155 that is provided with the aperture portion 157, it is possible without incurring any increase in the costs of manufacturing the semiconductor device 150 to mutually offset the semiconductor chip 7 and the aperture portion 157 such that they do not overlap with each other in the thickness direction of the stage portion 103 in order that the semiconductor chip 107 is not exposed directly to the outside via the aperture portion 157. Accordingly, even if dust and dirt or water droplets from the outside enter into the first space portion 154 via the aperture portion 157, it is easy to prevent this dust and dirt or water droplets directly reaching the semiconductor chip 107.

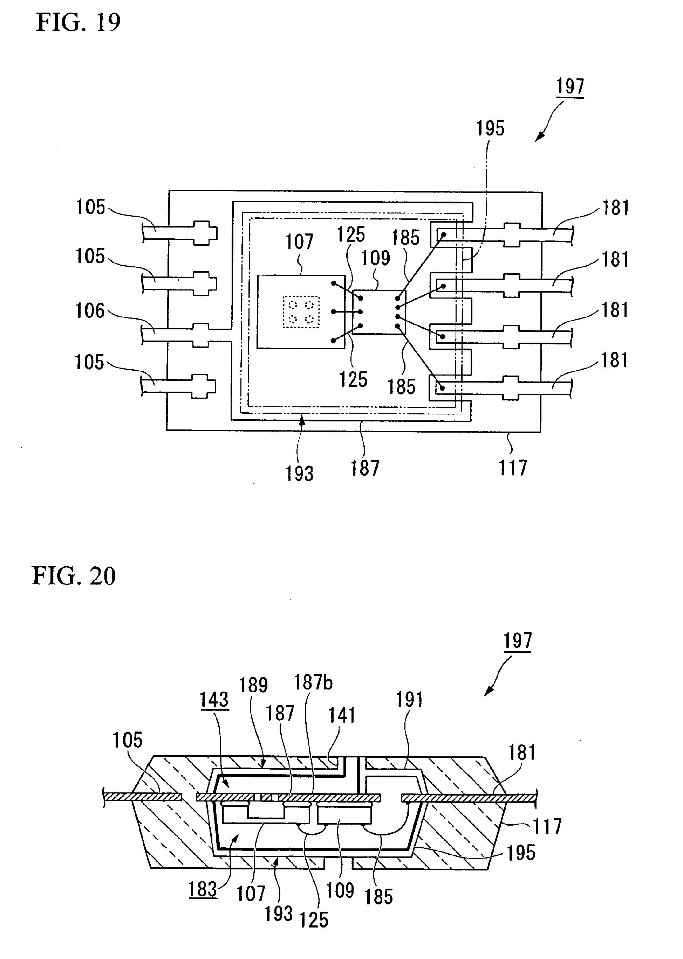

Note that in the case of this semiconductor device 150 as well, in the same way as in the semiconductor device shown in FIG 20, by exposing the leads 105 in the first space portion 154, or by forming a covering portion on the stage covering lid body 158, it is possible to electrically connect the semiconductor chip 107 to the leads 105 without forming the wiring through hole 103d or using the through electrode 111. Moreover, in this case, because it is no longer necessary to perform the second wiring step as in the above described embodiment, an improvement in the manufacturing efficiency of the semiconductor device 150 can be achieved.

Furthermore, in the above described embodiment, the chip covering lid body 113 and the stage covering lid body 115 are formed from a conductive material and a non-conductive paste 135 is coated on inner surfaces thereof, however the present invention is not limited to this and it is sufficient if the chip covering lid body 113 and the stage covering lid body 115 have conductivity to allow them to be electrically connected to at least the stage portion 103.

Accordingly, it is also possible for the chip covering lid body 113 and the stage covering lid body 115 to be formed, for example, from a conductive material and for outer surfaces thereof to be coated with a non-conductive paste. Moreover, it is also possible for the chip covering lid body 113 and the stage covering lid body 115 to be formed, for example, from an electrically non-conductive material, and for a conductive paste to be coated on outer surfaces or inner surfaces thereof, or for a separate lid body (i.e., a chip non-conductive portion) which is non-conductive to be placed on an inner surface side and an outer surface side thereof

Note that it is desirable for at least the inner surface side of the chip covering lid body 113 to be non-conductive in order to ensure electrical insulation between the semiconductor chip 107, the IC 109, the through electrode 111, and the wires 125 and the chip covering lid body 113.

Moreover, in the above described embodiment, the stage portion 103, the leads 105 and 106, and the lead frame 151 are made from metal, however, the present invention is not limited to this and it is sufficient if they simply have conductivity. Moreover, if no consideration needs to be given to preventing noise from entering into the first space portion 133, then it is also possible for the stage portion 103 to be formed from an electrically non-conductive material. If the stage portion 3 is formed from a non-conductive material, then a conductive adhesive agent may be used when the semiconductor chip 107, the IC 109, and the through electrode 111 are adhered to the stage portion 103.

Furthermore, the semiconductor chip 107 is formed by a pressure sensor chip which is provided with the diaphragm 107a, however, the present invention is not limited to this and it is sufficient if at least a movable portion such as the diaphragm 107a that forms the semiconductor chip 107 is provided. Accordingly, the semiconductor chip may be, for example, a pressure sensor chip that measures pressure or pressure changes in an external space outside the semiconductor device 101, or may be an acceleration sensor chip that detects rates of acceleration.

A semiconductor device according to a sixth embodiment of the present invention as well as a method of manufacturing the semiconductor device will now be described with reference made to FIG 22 through FIG 28. The present embodiment relates to a semiconductor device that detects sound pressure such as noise and the like that is externally generated, and relates to a semiconductor device that is manufactured using a lead frame.

As is shown in FIG 22 through FIG 23, a semiconductor device 200A of the present embodiment includes as principal component elements: a substantially plate-shaped stage portion 201 which presents a substantially rectangular configuration when seen in plan view; a plurality of connecting leads 202 that have one end 202a which is connected to the stage portion 201 and that supports the stage portion 201 in an elevated state; a plurality of electrical connection leads 203 that extend from a side end side of the semiconductor device 200A towards the stage portion 201 such that one end 203a thereof is positioned in the vicinity of the stage portion 201; a first sealing resin layer 204 that seals off the stage portion 201, the connecting leads 202, and the leads 203; a semiconductor sensor chip (i.e., a sound pressure sensor chip) 205 that has a substantially rectangular shape when seen in plan view and is fixed to a top surface 201a of the stage portion 201; an amplifier 206 that is also fixed to the top surface 201a of the stage portion 201 and amplifies electrical signals output by the semiconductor sensor chip 205; wires 207 that electrically connect together the semiconductor sensor chip 205, the amplifier 206, and the leads 203; a lid body 209 that has a substantially concave cross-section and that is mounted on the first sealing resin layer 204 and that forms a space (i.e., a first space) 212 above the semiconductor sensor chip 205 and the amplifier 206 so as to thereby cover the semiconductor sensor chip 205 and the amplifier 206; and a second sealing resin layer 210 that covers an outer surface 209d of the lid body 209 and is fixed to the first sealing resin layer 204.

A through hole 20 1 c that penetrates from the top surface 201a to a bottom surface 201 b is formed in the stage portion 201. In addition, suspended portions 201d that each extend outwards from the respective side ends of the top surface 201 a and extend down to a bottom surface 204a side of the first sealing resin layer 204 are provided on the stage portion 201. Bottom surfaces 201e on the distal end side of each suspended portion 201 d are level with the bottom surface 204a of the first sealing resin layer 204, and are also exposed at the bottom surface (i.e., the bottom surface of the semiconductor device 200A) 204a of the first sealing resin layer 204. The top surface 201a of the stage portion 201 is level with a top surface 204b of the first sealing resin layer 204 and is also exposed at this top surface 204b.

The connecting leads 202 are each formed substantially in the shape of a flat belt, and the one end 202a thereof is connected to the vicinity of a corner portion of the substantially rectangular shaped (in plan view) stage portion 201 and extends towards the outer side of the stage portion 201. Moreover, a bent portion 202b is provided substantially in the center in the direction in which the connecting leads 202 extend. This bent portion 202b is provided with a surface 202d that is parallel with respective top surfaces 202c that sandwich the bent portion 202b from the front and back thereof in the extension direction. These surfaces 202d are placed above the respective top surfaces 202c that sandwich the bent portion 202b, and are also placed above the top surface 201a of the stage portion 201. Here, in the connecting leads 202, the top surfaces 202c are placed on substantially the same horizontal plane as the top surface 201a of the stage portion 201 between the one end 202a and the bent portion 202b, while the top surfaces 202c between the bent portion 202b and another end 202f are placed below the top surfaces 202c between the one end 202a and the bent portion 202b and are also placed below the bottom surface 201b of the stage portion 201. A bottom surface 202e on this other end 202f side is placed on substantially the same horizontal plane as the bottom surface 204a of the first sealing resin layer 204 and is also exposed thereat.

The plurality of leads 203 are provided between adjacent connecting leads 202, and are perpendicular to opposing side ends of the stage portion 201 while extending from outer portions towards the stage portion 201. Here, the respective leads 203 extend such that distal ends (i.e., one ends) 203a thereof are positioned on the stage portion 201 side of the bent portions 202b of adjacent connecting leads 202. Furthermore, folded portions 203b are provided partway along each lead 203 in the extension direction thereof, and a bottom surface 203d from another end 203c thereof to the folded portions 203b is positioned on substantially the same horizontal plane as the bottom surface 204a of the first sealing resin layer 204, and is also exposed thereat. In contrast to this, a top surface 203e from the folded portions 203b to the distal end 203a is positioned on substantially the same horizontal plane as the respective top surfaces 201a and 204b of the stage portion 201 and the first resin sealing layer 204, and is also exposed thereat.

The first resin sealing layer 204 that seals the stage portion 201, the connecting leads 202, and the leads 203 that are constructed in this manner is provided with a top surface 204b and a bottom surface 204a that are parallel with each other, and is formed such that a portion thereof that seals the bent portion 202b of the connecting leads 202 protrudes upwards. In contrast, a recessed portion 204c whose one end is positioned above the bottom surface 204a of the first sealing resin layer 204 and whose other end extends to the through hole 201c of the stage portion 201 is provided in a portion of the first resin sealing layer 204 that is surrounded by the bottom surface 201b and the suspended portions 201d of the stage portion 201. A second space 208 is formed by combining the recessed portion 204c with the through hole 201c that is connected thereto.

In the present embodiment, the width of this second space 208 in cross-sectional view is substantially the same as the width of the through hole 201c, and the second space 208 becomes sealed off when the semiconductor sensor chip 205 is placed on the top surface 201 a of the stage portion 201.

The semiconductor sensor chip 205 is formed substantially in the shape of a flat plate, and a recessed portion 205c that is hollowed out from a bottom surface 205a towards a top surface 205b is formed substantially in the center of the semiconductor sensor chip 205 when seen in plan view from the bottom surface 205a side. A portion of this semiconductor sensor chip 205 whose thickness has been reduced by the recessed portion 205c forms a diaphragm (i.e., a movable electrode) 205d, and this diaphragm 205d is able to deform (i.e., vibrate) by a deformation amount that corresponds to the size of sound pressure such as, for example, noise or the like that is applied to the diaphragm 205d. A bridge resistive circuit (not shown) is formed on the top surface 205b side of the diaphragm 205d. This bridge resistive circuit treats deformation of the diaphragm 205d as a change in the electrical resistance, and detects sound pressure by converting these changes in the electrical resistance into pressure. The bridge resistive circuit is then able to output electrical signals in accordance with the size of this sound pressure. The semiconductor sensor chip 205 that is constructed in this manner is adhered via a non-conductive component 211 that electrically insulates the stage portion 201 from the semiconductor sensor chip 205 onto the top surface 201a of the stage portion 201 while facing the bottom surface 205a. At this time, the semiconductor sensor chip 205 is adhered such that the through hole 201c of the stage portion 201 is located directly beneath the diaphragm 205d so that the diaphragm 205d and the through hole 201c face each other.

Note that in the present embodiment an amplifier 206 such as, for example, an op-amp that has been formed as an integrated circuit (IC) is adhered via the non-conductive component 211 onto the top surface 201a of the stage portion 201, and this amplifier 206 is provided in parallel with the semiconductor sensor chip 205.

A plurality of bonding pads are provided respectively on the semiconductor sensor chip 205 and the amplifier 206 that have been arranged in this manner, and the semiconductor sensor chip 205 and the amplifier 206, and also the amplifier 206 and the top surfaces 203e of the leads 203 that are located in the first space 212 and is exposed at the top surface 204b of the first resin sealing layer 204 are each connected by the respective wires 207 via these bonding pads, thereby electrically connecting together the semiconductor sensor chip 205, the amplifier 206, and the leads 203.

The lid body 209 is formed having a substantially concave-shaped cross-section whose open side faces downwards and is formed by a flat plate-shaped top wall 209a, side walls 209b that are joined to the top wall 209a and extend downwards, and distal end portions 209c that are joined to the side walls 209b and extend outwards in a horizontal direction. An aperture portion 209i that connects a first space portion 212 to the outside is provided in the top wall 209a of the lid body 209, and this aperture portion 209i is formed so as to enable an inner surface 209f of the lid body 209 to extend upwards in a perpendicular direction relative to the top wall 209a. Furthermore, supporting components 209e are provided on the outer surface 209d of the lid body 209 that is positioned at the side walls 209b, and one end of these supporting components 209e is connected to the outer surface 209d of the side walls 209b, while a distal end (i.e., another end) thereof is provided so as to extend to the outside as far as the top surface of the second sealing resin layer 210 (i.e., the top surface of the semiconductor device 200A).

Moreover, a conductive paste 209h is adhered using, for example, a suitable device that performs coating or the like onto the inner surface 209f of the lid body 209 and onto bottom surfaces 209g of the distal end portions 209c that are connected to the inner surface 209f, thereby forming a conductive layer 209h. Here, in the present embodiment, the bottom surfaces 209g of the distal end portions 209c also form part of the inner surface 209f of the lid body 209.

The lid body 209 that is constructed in this manner is mounted on the top surface 204b of the first sealing resin layer 204 with the bottom surface 209g of the portion of the distal end portion 209c to which the conductive paste 209h is adhered firmly fixed to the surface 202d of the bent portion 202b of the connecting leads 202, and with the bottom surface 209g of the other portion firmly fixed to the top surface 204b of the first sealing resin layer 204. As a result, a first space 212 is created in a portion surrounded by the lid body 209 and the first sealing resin layer 204, and the semiconductor sensor chip 205, the amplifier 206, and the wires 207 are housed within this first space 212. At this time, the lid body 209 is positioned with a sufficient clearance to enable the conductive paste 209h that is provided on the inner surface 209f to be held in a state of non-contact with the semiconductor sensor chip 205, the amplifier 206, and the wires 207. In addition, the surfaces 202d of the bent portion 202b that are exposed at the top surface 204b of the first sealing resin layer 204 are electrically connected to the conductive paste 209h. As a result, the semiconductor sensor chip 205, the amplifier 206, and the wires 207 that are inside the first space 212 are enclosed within a magnetic shield formed by the conductive paste 209h, the connecting leads 202, and a stage portion 201.

The second sealing resin layer 210 is provided within a range extending from the top surface 204b of the first sealing resin layer 204 to a top end of the aperture portion 209i that is provided in the top wall 209a, and is formed so as to be adhered to the top surface 204b of the first sealing resin layer 204 while covering the outer surface 209d of the lid body 209, and thereby seal the top surface 204 b of the first sealing resin layer 204. Moreover, a top surface 210a of the second sealing resin layer 210 (i.e., a top surface of the semiconductor device 200A) is formed so as to be parallel with the bottom surface 204a of the first sealing resin layer 204 (i.e., the bottom surface of the semiconductor device 200A), and the distal ends of the supporting components 209e of the lid body 209 are located on the same plane as the top surface 210a of the second sealing resin layer 210.

Next, a method of manufacturing the semiconductor device 200A that has the above described structure will be described.

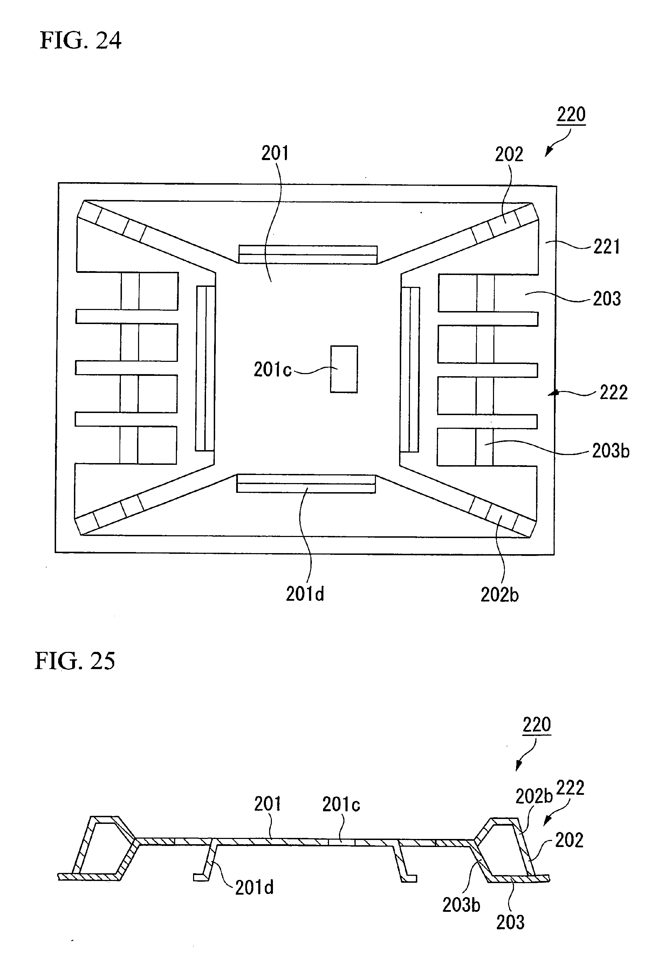

This semiconductor device 200A is manufactured using a lead frame 220. Firstly, as is shown in FIG 24 through FIG 25, a lead frame 220 is prepared that is provided with a rectangular frame portion 221 which forms an outer circumferential rectangular frame, the above-described plurality of leads 203 that protrude inwards from the respective outer circumferential sides of this rectangular frame portion 221, the above-described connecting leads 202 that extend inwards from corner portions of the rectangular frame portion 221, and the above-described stage portion 201 that is connected to and supported by these connecting leads 202. In this lead frame 220, a frame portion 222 is formed by combining the rectangular frame portion 221, the leads 203, and the connecting leads 202.

The lead frame 220 that is constructed in this manner is formed by performing a pressing process or an etching process or by performing both processes on a thin metal plate. In the present embodiment, the suspended portions 201d of the stage portion 201, the folded portions 203b of the leads 203, and the bent portions 202b of the connecting leads 202 are also formed at this stage. In addition to these, the through hole 201c of the stage portion 201 is also formed at this stage. Note that it is not essential that the suspended portions 201d, the folded portions 203b, the bent portions 202b, and the through hole 201c be formed at the same time, and is also possible for particularly the through hole 201 c to be formed using different process from a pressing process or an etching process.

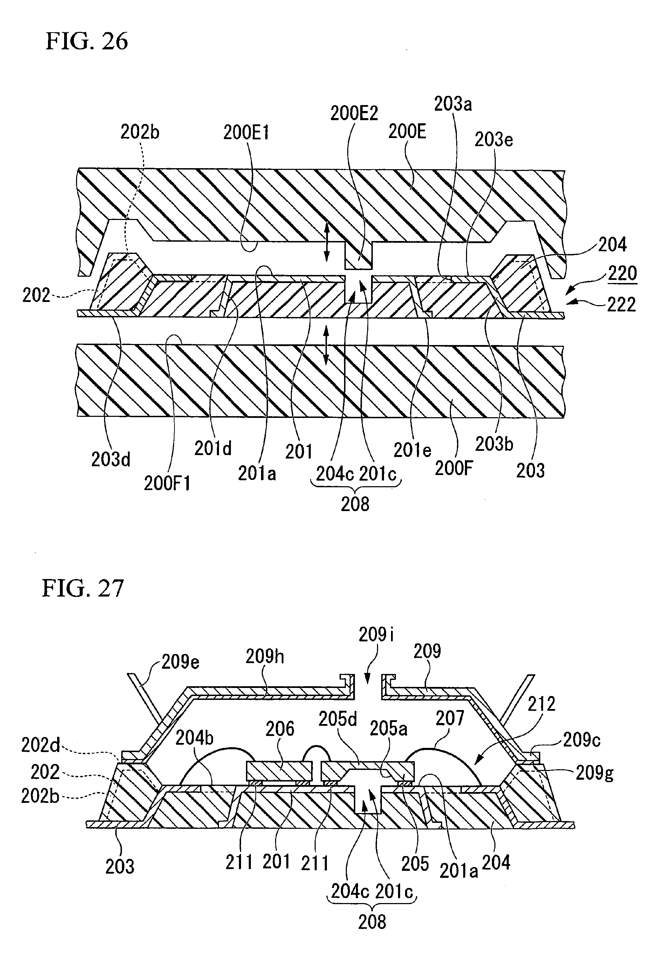

At the stage when the above-described lead frame 220 has been prepared, as is shown in FIG 24 and FIG 26, portions of the frame portion 222 excluding the rectangular frame portion 221, the leads 203, and a portion of the connecting leads 202 are sandwiched between a pair of first molds 200E and 200F and these molds are then fastened. Here, of this pair of first molds 200E and 200F, an inner surface 200E 1 of the one mold 200E that is placed on the top surface side of the lead frame 220 has a surface that abuts against the top surface 201 a of the stage portion 201 and against the top surface 203e which is on the distal end 203a side of the folded portion 203b of the leads 203, recessed surfaces that engage with the bent portions 202b of the connecting leads 202, and surfaces that abut respectively against top surfaces 202c which are on the outer side of the bent portions 202b of the connecting leads 202 and against top surfaces 203e which are on the outer side of the folded portions 203b of the leads 203. Moreover, a protruding portion 200E2 that is engaged with the through hole 201c of the stage portion 201 by being inserted therein when the molds are being fastened and whose distal end is located slightly above an inner surface 200F1 of the other mold 200F is formed in the one mold 200E. An inner surface 200F1 of the other mold 200F that is located on the bottom surface side of the lead frame 220 is formed as a flat plane and, when the molds are fastened together, abuts against the bottom surfaces 201e of the suspended portion 201d of the stage portion 201, against the bottom surface 203d of the portions of the leads 203 that are positioned on the outer side of the folded portion 203b, and against the bottom surface 202e of the portions of the connecting leads 202 that are positioned on the outer side of the bent portions 202b.

At the stage when the molds are fastened together in this manner using the pair of first molds 200E and 200F, the first sealing resin layer 204 is formed by injecting a first resin such as, for example, a molten epoxy resin into the cavity formed by the first molds 200E and 200F, thereby embedding the stage portion 201, the leads 203, and the connecting leads 202 inside the first resin. Note that because the stage portion 201 is connected to the connecting leads 202 and is supported in an elevated state, and because the bottom surfaces 201e of the suspended portions 201d abut against the inner surface 200F1 of the other mold 200F and are accordingly firmly held, it is expected that there is no change to the stage portion 201 as a result of the injection of the first resin.

Next, at the stage when the first resin has hardened and the first sealing resin layer has been formed, the first molds 200E and 200F are removed. At this stage, a recessed portion 204c is created below the stage portion 201 that is connected to the through hole 201c and is slightly above the bottom surface 204a of the first sealing resin layer 204, thereby forming a second space 208.

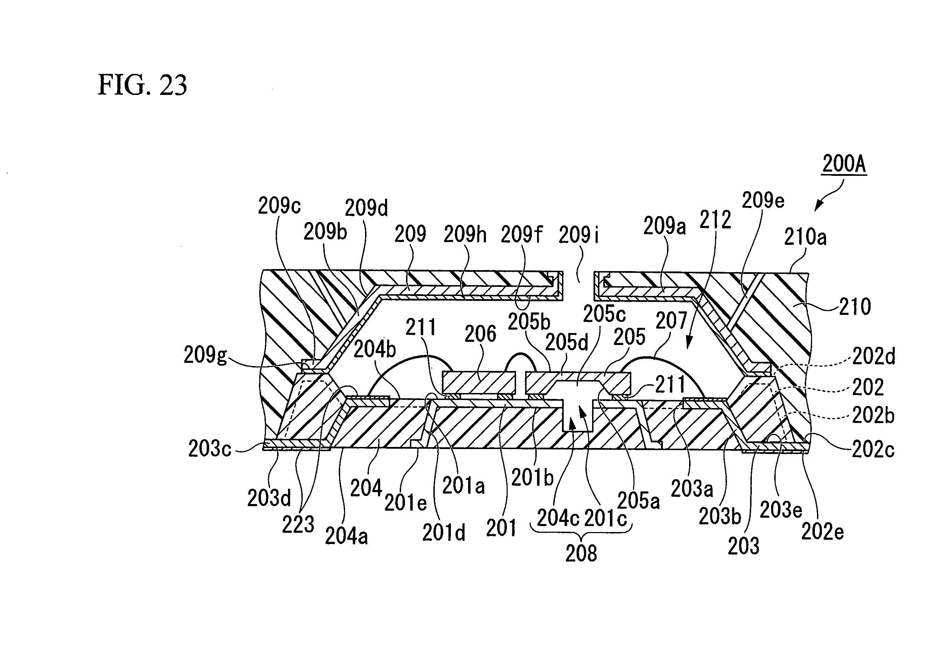

In the present embodiment, at this stage, the lead frame 220 on which the first sealing resin layer has been formed is immersed in a plating solution of, for example, silver, gold, or palladium. At this time, by connecting the cathode of a DC power supply, for example, to the rectangular frame portion 221 that is positioned on the outer side of the first sealing resin layer 204 of the lead frame, and connecting the anode to the plating solution, and then supplying DC current to the lead frame 220, as is shown in FIG 23, a plating layer 223 is formed on portions such as the top surface 203c on the one end 203a side and the bottom surface 203d on the other end 203c side of the leads 203 that are exposed from the first sealing resin layer 204. Note that this plating layer 223 is intended to improve the wettability for soldering when the semiconductor device 200A is packaged on a circuit board that is provided in a device such as, for example, a mobile telephone, or when the leads 203 are being connected (i.e., bonded) to the pattern of a circuit board, or when the wires 207 that electrically connect the semiconductor sensor chip 205, the amplifier 206, and the leads 203 are being connected (i.e., bonded).

Next, as is shown in FIG 27, the semiconductor chip 205 and the amplifier 206 are each adhered via the non-conductive component 211 and also in parallel with each other on the top surface 201a of the stage portion 201. At this time, in the semiconductor sensor chip 205, the bottom surface 205a and the top surface 201a of the stage portion 201 are positioned facing each other, and the diaphragm 205d is positioned so as to be directly above and also facing the through hole 201 c of the stage portion 201. Furthermore, the bonding pads of the semiconductor sensor chip 205 and the amplifier 206 are joined by the wires 207 to the respective leads 203, so that the semiconductor sensor chip 205, the amplifier 206, and the leads 203 are electrically connected.

Next, the lid body 209 is mounted on the top surface 204b of the first sealing resin layer 204 with the bottom surface 209g side of the distal end portion 209c of the lid body 209 placed in contact with the surface 202d of the bent portion 202b of the connecting leads 202, and with the conductive paste 209h electrically connected to the connecting leads 202. The first space 212 is thus formed with the semiconductor sensor chip 205, the amplifier 206, and the wires 207 covered by the lid body 209. At this time, by positioning the surfaces 202d of the bent portions 202b such that they are in a state of protruding above the top surface 201a of the stage portion 201, when the lid body 209 is placed in position, the lid body 209 does not come into contact with and consequently damage the semiconductor sensor chip 205, the amplifier 206, and the wires 207.

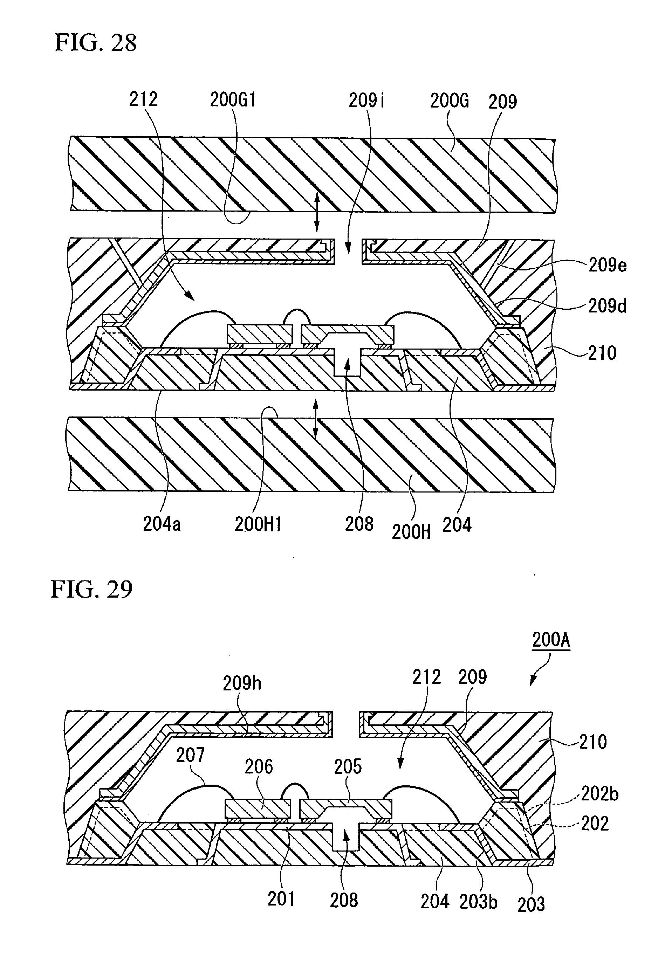

Next, as is shown in FIG 28, a pair of second molds 200G and 200H whose inner surfaces 200G1 and 200H1 form flat surfaces are fastened together. At this time, the one mold 200G that is placed on the upper side is positioned such that the inner surface 200G1 thereof abuts against the top end of the aperture portion 209i of the lid body 209 and against the distal end of the supporting components 209e, while the other mold 200H that is placed on the lower side is positioned such that the inner surface 200H1 thereof is in surface contact with the bottom surface 204a of the first sealing resin layer 204. At the stage when the pair of second molds 200G and 200H have been fastened together, a molten second resin such as, for example, an epoxy resin is injected into the resulting cavity, thereby covering the outer surface 209d of the lid body 209 and adhering to the first sealing resin layer 204, and forming the second sealing resin layer 210 that seals the outer surface 209d of the lid body 209 and the first sealing resin layer 204. Here, because the lid body 209 is reliably held as a result of the top end of the aperture portion 209i and the distal ends of the supporting components 209e abutting against the inner surface 200G1 of the one mold 200G, the position of the lid body 209 is not shifted by the urging force that accompanies the injection of the second resin.

At the stage when the second resin has hardened and the pair of second molds 200G and 200H have been removed, lastly, the rectangular frame portion 221 of the lead frame 220 and the unnecessary leads 203 and connecting leads 202 on the outer side portion of the semiconductor device 200A are cut off, thereby completing the process to manufacture the semiconductor device 200A.

In the semiconductor device 200A that is constructed in the manner described above, sound pressure such as noise or the like that is externally generated is guided to the first space 212 through the aperture portion 209i of the lid body 209, and reaches the diaphragm 205d of the semiconductor sensor chip 205. In conjunction with this, the diaphragm 205d vibrates by a deformation amount that corresponds to the size of the sound pressure. A bridge resistive circuit treats the amount of the deformation by the diaphragm 205d as a change in the electrical resistance, and detects sound pressure by converting these changes in the electrical resistance into pressure. In addition, electrical signals that are output at this time from the diaphragm 205d are sent to the amplifier 206 and are amplified, thereby enabling the sound pressure to be detected more accurately. Furthermore, in the semiconductor device 200A of the present embodiment, the recessed portion 204c can be formed with the stage portion 201 in an elevated state and the layer thickness of the first sealing resin layer increased, and the second space 208 on the bottom surface 205a side of the diaphragm 205d can be formed with a sizable volume. Because of this, in spite of the second space 208 being a sealed space, the deformation of the diaphragm 205d is not obstructed because of pressure changes within the space 208 that occur in conjunction with the vibration of the diaphragm 205d, and there are no errors in the detected sound pressure. Accordingly, the diaphragm 205d vibrates correctly by a deformation amount that corresponds to the incoming sound pressure.

In contrast, electromagnetic noise that is externally generated also acts on the semiconductor device in addition to the sound pressure from a detected object. This type of noise passes through the first sealing resin layer 204 and the second sealing resin layer 210 that are provided on the semiconductor device 200A of the present embodiment, and there is a possibility that it will reach the semiconductor sensor chip 205 and cause erroneous vibration of the diaphragm 205d. If noise reaches the diaphragm 205d in this manner, then errors occur in the sound pressure detections by the semiconductor device, which results in a loss of the reliability of the semiconductor device. In contrast to this, in the semiconductor device 200A of the present embodiment, the conductive paste 209h is provided on the lid body 209, and an electromagnetic shield that is formed by this conductive paste 209h, the connecting leads 202, and the stage portion 201 and that surrounds the semiconductor sensor chip 205 and the like inside the first space 212 is provided in the semiconductor device 200A. Because of this, noise that passes through the first sealing resin layer 204 and the second sealing resin layer 210 can be blocked by the electromagnetic shield, and this noise is unable to reach the semiconductor sensor chip 205 located within the first space 212. As a result, in the semiconductor device 200A of the present embodiment, there is no erroneous operation of the diaphragm 205d that is caused by the effects of noise.

Accordingly, in the above-described semiconductor device 200A and method of manufacturing the semiconductor device 200A, sound pressure such as noise and the like is allowed to reach the diaphragm 205d of the semiconductor sensor chip 205 via the aperture portion 209i of the lid body 209 and through the first space 212, and the diaphragm 205d is able to be vibrated using the second space 208 which is formed by the through hole 201c and the recessed portion 204c. At this time, the volume of the second space 208 which is in a sealed state can be easily increased by changing the size of the protruding portion 200E2 of the first mold 200E. As a result, when the diaphragm 205d is vibrating in response to incoming sound pressure, it is possible to suppress to a minimum pressure changes in the second space 208 that occur in conjunction with these vibrations. Accordingly, the diaphragm 205d can be made to vibrate correctly without being affected by these pressure changes, and the sound pressure can be accurately and precisely detected.

Moreover, the semiconductor device 200A of the present embodiment is manufactured using the lead frame 220, and it is possible to form a circuit board on which the semiconductor chip 205 is packaged using a comparatively simple manufacturing method such as performing a pressing process or an etching process on a thin metal plate. Because of this, in comparison with when a printed circuit board is used as in the conventional method, this method can be applied for mass production and it is possible to reduce the costs of manufacturing the semiconductor device 200A and, consequently, reduce the cost of the semiconductor device 200A itself. Moreover, by using the lead frame 220 in the manufacturing, resin sealing technology can be applied. Because the semiconductor device 200A is sealed by the first sealing resin layer 204 and the second sealing resin layer 210, it is provided with a high level of durability and excellent reliability.

Moreover, when the pair of first molds 200E and 200F are fastened together and the first resin is injected into the cavity, the stage portion 201 can be held firmly due to the suspended portion 201d being provided on the stage portion 201, and it is possible to prevent the stage portion 201 being shifted by the urging force that accompanies the injection of the first resin. Furthermore, as a result of the supporting component 209e being provided on the lid body 209, it is possible to fasten the pair of second molds 200G and 200H and reliably prevent the lid body 209 being shifted when the second resin is injected into the cavity.

Moreover, as a result of the bent portions 202b being provided on the connecting leads 202, and these bent portions 202b being formed such that the surfaces 202d are positioned above the top surface 201a of the stage portion 201, when the lid body 209 is placed in position, it is possible to prevent the lid body 209 coming into contact with and consequently damaging the semiconductor sensor chip 205, the amplifier 206, and the wires 207.

Furthermore, as a result of the conductive paste 209h being provided on the lid body 209, it is possible to equip the semiconductor device 200A with an electromagnetic shield, and to accordingly prevent any erroneous vibration of the diaphragm 205d that is caused by noise. As a result, a semiconductor device 200A that has accurate noise pressure detection can be provided.

Note that the present invention is not limited to the above described embodiments and various modifications may be made thereto insofar as they do not depart from the spirit or scope of the present invention. For example, in the present embodiment a description is given of when the suspended portion 201d is provided below the stage portion 201 and this suspended portion 201d makes it possible to prevent the stage portion 201 being shifted when the first resin is injected. However, because the stage portion 201 is supported by the connecting leads 202 and, during the first resin injection, the protruding portion 200E2 of the mold 200E is inserted into the through hole 201c and held therein, it is also possible, as is shown in FIG 29, for the suspended portion 201d to not be provided. Moreover, in the present embodiment, the conductive paste 209h is provided on the lid body 209, however, when, for example, the lid body 209 is formed from a conductive material such as metal, the lid body 209 by itself provides an electromagnetic shield effect. Therefore, it is not essential for the conductive paste 209h to be provided. Furthermore, it is not necessary for this type of conductive material to be limited to a paste material.

Furthermore, in the present embodiment, the bent portions 202b are provided on the connecting leads 202, and the lid body 209 is positioned so as to abut against the surfaces 202d, which consequently prevents the lid body 209 coming into contact with the semiconductor sensor chip 205 and the wires 207 and the like when the lid body 209 is being installed. However, if the lid body 209 is formed large enough in advance so that it does not come into contact with the semiconductor sensor chip 205 and the wires 207 and the like during installation, then it is not necessary to provide the bent portions 202b on the connecting leads 202.

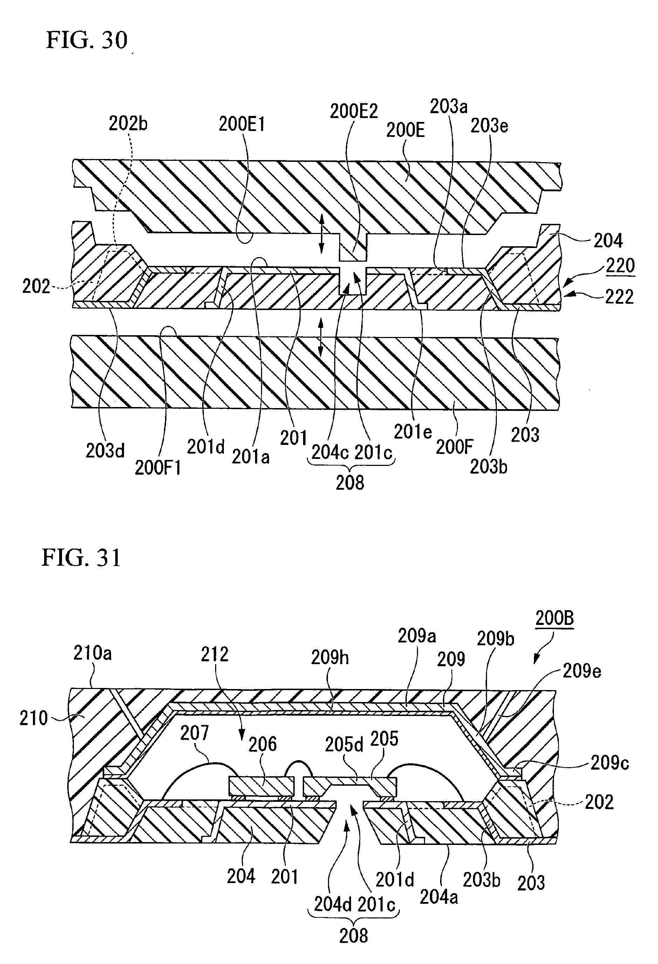

Moreover, when forming the first sealing resin layer 204, as is shown in FIG 30, it is also possible to provide the first sealing resin layer 204 on the outer side of the bent portions 202b. If this type of structure is employed, there is no possibility that the distal end portions 209c of the lid body 209 will slide off the surfaces 202d of the bent portions 202b when the lid body 209 is being installed. If the height of the first sealing resin layer 204 on the outer side of the bent portions 202b is made higher than the height of the surfaces 202d, then the lid body 209 can be installed with even greater stability.

Moreover, in the present embodiment, at the stage when the first sealing resin layer 204 was formed, the plating layer 223 was formed by immersing the lead frame 220 in a plating solution, however, it is also possible to form the plating layer 223 over the entire surface of the lead frame 220 by immersing the lead frame 220 in the plating solution at the stage when the working of the lead frame 220 has been completed but the first sealing resin layer 204 has not yet been formed. If the plating layer 223 is formed on the entire surface of the lead frame 220 in this manner, then, for example, a palladium plating may be used. If the plating layer 223 is formed in spots such as on the top surface 203e and the bottom surface 203d of the leads 203 that are exposed from the first sealing resin layer 204, as in the present embodiment, then, in addition to a gold plating or silver plating, a bismuth plating may also be used.

Moreover, in the present embodiment, the semiconductor sensor chip 205 and the amplifier 206 are provided on the semiconductor device 200A, and are also installed on the stage portion 201, however, it is also possible to detect sound pressure using only, for example, the semiconductor sensor chip 205, and to further amplify electrical signals output from the semiconductor sensor chip 205 using an amplifier 206 that is provided separately from the semiconductor device 200A.

Furthermore, the semiconductor sensor chip 205 is fixed to the top surface 201a of the stage portion 201 with the bottom surface 205a thereof facing this top surface 201a, however, it is also possible for the semiconductor sensor chip 205 to be installed with the top surface 205b of the semiconductor sensor chip 205 facing the top surface 201a of the stage portion 201.

Moreover, in the present embodiment, an example is shown in which the aperture portion 209i of the lid body 209 is formed directly above the diaphragm 205d of the semiconductor sensor chip 205, however, provided that the aperture portion 209i allows the first space 212 to be connected to the outside, it is not necessary that it be limited to this placement position. For example, if the aperture portion 209i is offset in a horizontal direction from above the diaphragm 205d, then not only is there no deterioration in the pressure detection accuracy, but also, conversely, if moisture and the like enters into the first space 212 through the aperture portion 109i, this moisture and the like can be prevented from coming into direct contact with the diaphragm 205d so that the pressure detection accuracy can be maintained or even improved.

Furthermore, in the present embodiment, a description is given of when the supporting components 209e are provided on the lid body 209, and by abutting the distal ends of the supporting components 209e against the inner surface 200G1 of the one mold 200G, the lid body 209 is prevented from being shifted by the urging force that accompanies the injection of the second resin. However, because the lid body 209 is also held by the inner surface 200G1 of the mold 200G abutting against the top end of the aperture portion 209i during the injection of the second resin, it is not essential for the supporting components 209e to be formed.

Next, a semiconductor device and a method of manufacturing this semiconductor device according to a seventh embodiment of the present invention will be described with reference made to FIG. 31 through FIG 34. In the description of the present embodiment, structure that is the same as that of the sixth embodiment is given the same symbol and a detailed description thereof is omitted.

In contrast to the semiconductor device 200A that was described in the sixth embodiment, as is shown in FIG 31, in a semiconductor device 200B of the present embodiment the aperture portion 209i that connects the first space 212 with the outside is not formed in the top wall 209a of the lid body 209, and the first space 212 is in a sealed state.

In contrast to this, a hole portion 204d that communicates with the through hole 201 c in the stage portion 201 and opens onto the bottom surface 204a of the first sealing resin layer 204 is provided in the first sealing resin layer 204. Here, when seen in cross-sectional view, the width of the hole portion 204d of the present embodiment is formed larger than the width of the through hole 201 c, and the second space 208 is formed by combining the through hole 201c and the hole portion 204d.

Next, a method of manufacturing the semiconductor device 200B having the above described structure will be described.

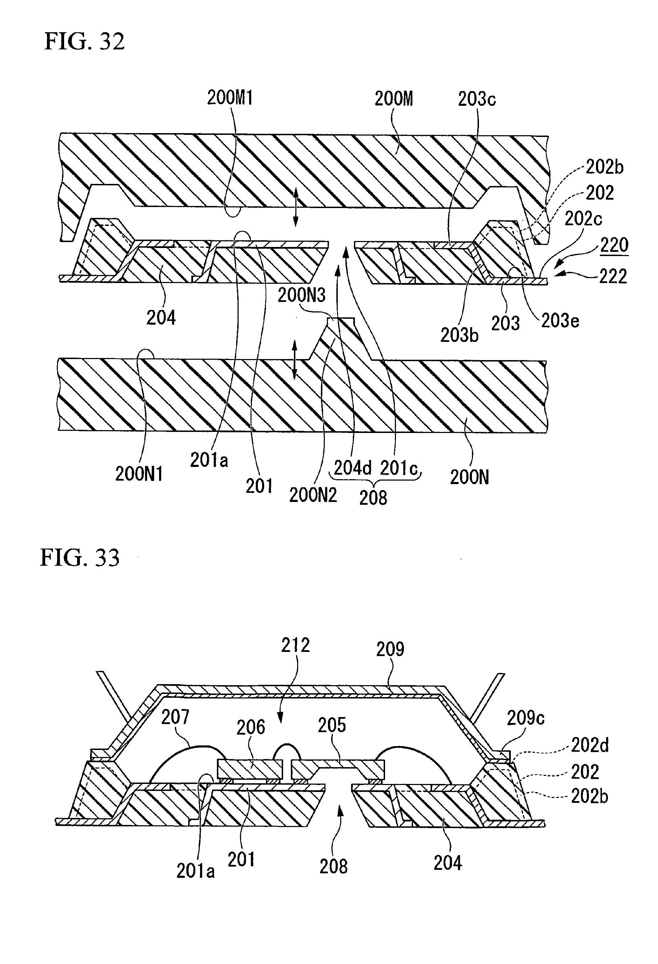

This semiconductor device 200B is manufactured using the lead frame 220 in the same way as in the sixth embodiment. At the stage when the lead frame 220 has been prepared, as is shown in FIG 24 and FIG 32, portions of the frame portion 222 excluding the rectangular frame portion 221, the leads 203, and a portion of the connecting leads 202 are sandwiched between a pair of first molds 200M and 200N and these molds are then fastened. Here, in the present embodiment, of this pair of first molds 200M and 200N, a protruding portion 200N2 is provided on an inner surface 200N1 side of the other mold 200N that is placed on the bottom surface side of the lead frame 220, and the through hole 201c is closed off when a convex portion 200N3 at the distal end portion of this protruding portion 200N2 is engaged in the through hole 201c of the stage portion 201 when the molds are fastened together. In contrast, an inner surface 200M1 of the one mold 200M that is placed on the top surface side of the lead frame 220 has a surface that abuts against the top surface 201 a of the stage portion 201 and against the top surface 203c which is on the distal end side of the folded portion 203b of the leads 203, recessed surfaces that engage with the bent portions 202b of the connecting leads 202, and surfaces that abut respectively against top surfaces 202c which are on the outer side of the bent portions 202b of the connecting leads 202 and against top surfaces 203e which are on the outer side of the folded portions 203b of the leads 203.

At the stage when the pair of first molds 200M and 200NF are fastened together in this manner, the first sealing resin layer 204 is formed by injecting a molten first resin into the cavity formed by the first molds 200M and 200N. Next, at the stage when the first resin has hardened and the first molds 200M and 200N have been removed, a hole portion 204d is formed below the stage portion 201 that is connected to the through hole 201c and opens at the bottom surface 204a of the first sealing resin layer 204, thereby forming a second space 208 of the present embodiment that is connected to the outside.

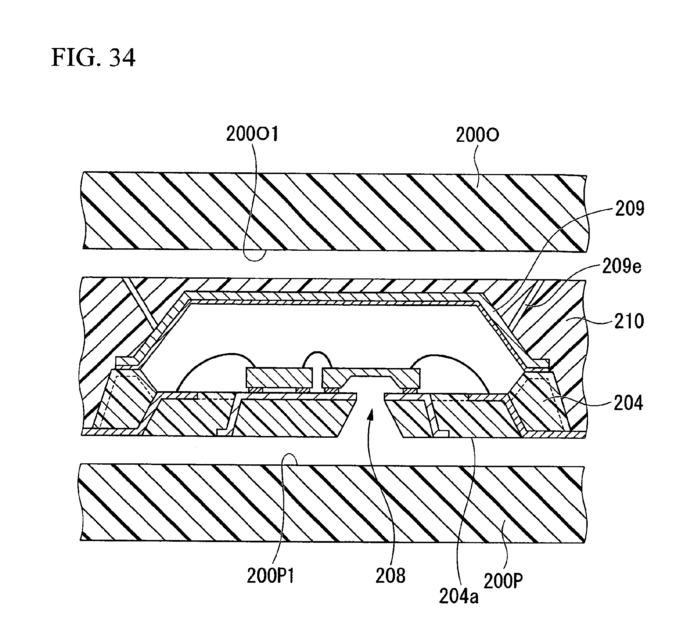

Next, as is shown in FIG 33, in the same way as in the sixth embodiment, at the stage when the semiconductor sensor chip 205 and the amplifier 206 are adhered to the top surface 201a of the stage portion 201 and the wires 207 have been connected, the lid body 209 is placed in position with the distal end portions 209c abutting against the surfaces 202d of the bent portions 202b, thereby forming a sealed first space 212. Next, as is shown in FIG 34, a pair of second molds 2000 and 200P are fastened together, and a second sealing resin layer 210 is formed so as to seal the first sealing resin layer and the lid body 209. At this time, an inner surface 200O1 of the one mold 2000 is placed against the distal ends of the supporting components 209e so that the lid body 209 is firmly held, and the inner surface 200P1 of the other mold 200P is placed against the bottom surface 204a of the first sealing resin layer 204 thereby fastening the molds together. As a result, it is possible to prevent the lid body 209 from being shifted by the urging force that accompanies the injection of the second resin. Lastly, at the stage when the second sealing resin layer 210 has been formed, portions of the lead frame 220 that are positioned outside the first sealing resin layer 204 and the second sealing resin layer 210 are cut off, thereby completing the process to manufacture the semiconductor device 200B.

In the semiconductor device 200B of the present embodiment that is constructed in this manner, pressure from the outside is able to reach the diaphragm 205d of the semiconductor sensor chip 205 via the second space 208. In addition, the diaphragm 205d is able to vibrate due to the sealed first space 212 being formed. At this time, because it is possible to easily alter the volume of the first space 212 by changing the size and shape of the lid body 209, it is also possible to easily keep to a minimum the pressure changes that accompany the vibrations of the diaphragm 205d, and the diaphragm 205d can be made to vibrate correctly.

Note that the present invention is not limited to the above described seventh embodiment and various modifications may be made thereto insofar as they do not depart from the spirit or scope of the present invention. For example, in the present embodiment the width of the hole portion 204d is formed larger than the width of the through hole 201c when seen in cross-sectional view, however, it may also be formed having substantially the same width as that of the through hole 201c. In this case, for example, by forming the protruding portion 200E2 that is formed on the one mold 200E of the pair of first molds 200E and 200F that are described in the sixth embodiment at a length that enables it to abut against the inner surface 200F1 of the other mold 200F when the molds are being fastened together, it is also possible to form a hole portion 204d that opens onto the bottom surface 204a of the first sealing resin layer 204 and that has substantially the same width as that of the through hole 1c.

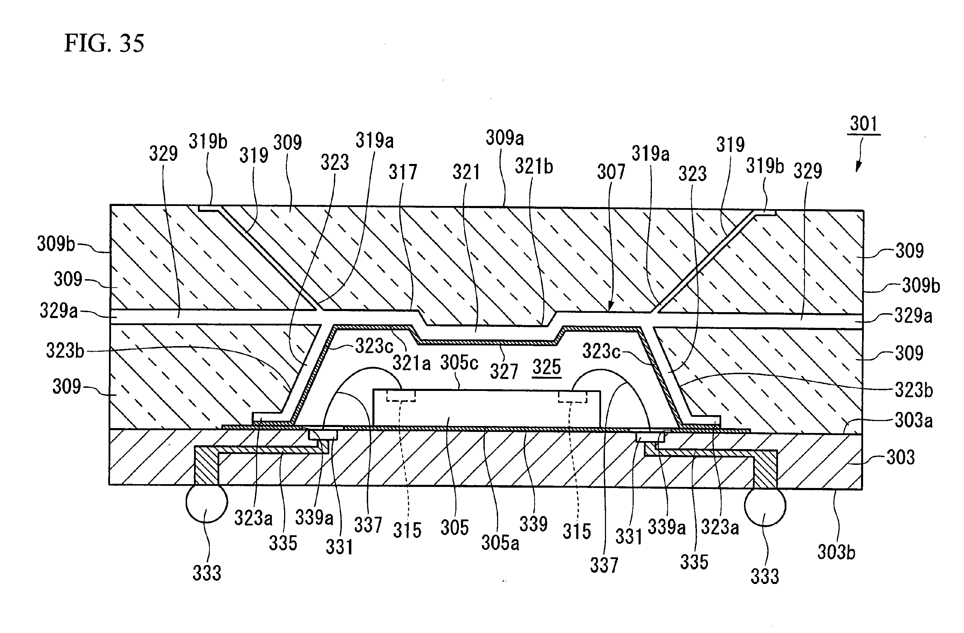

FIG 35 through FIG 40 show an eighth embodiment of the present invention. As is shown in FIG 35, a semiconductor device 301 is provided with a circuit board 303, a semiconductor chip 305 that is placed on one end side in the thickness direction of the circuit board 303, a lid frame 307, and a resin mold portion 309.

The semiconductor chip 305 is formed substantially in a plate shape, and one end surface in the thickness direction thereof 305a is adhesively fixed onto a front surface 303a that is positioned on the one end side of the circuit board 303. This semiconductor chip 305 is formed, for example, by an acceleration sensor that has the function of detecting acceleration.

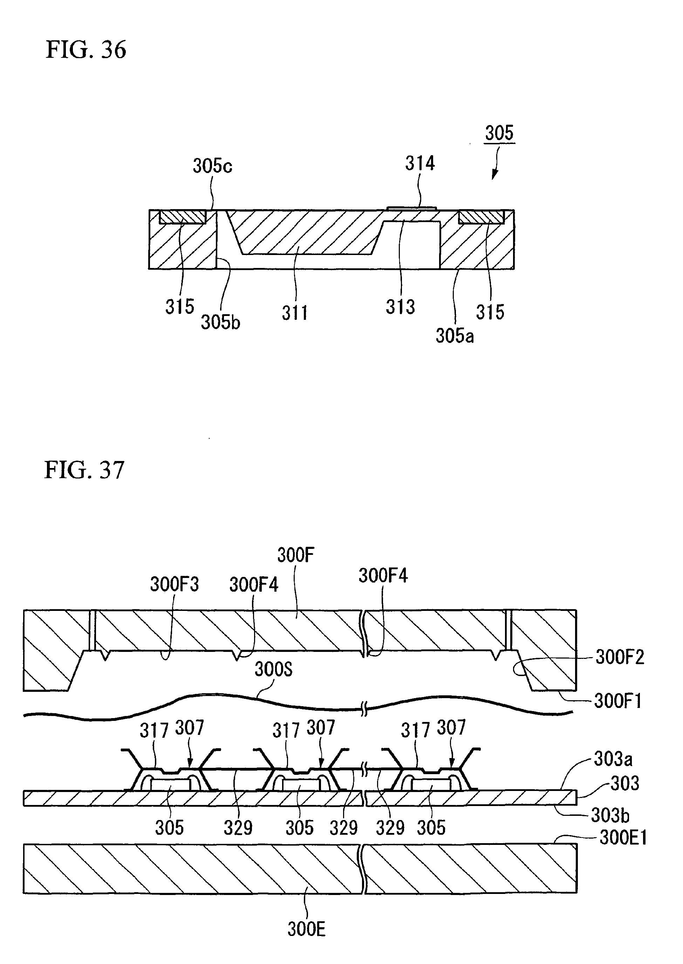

Namely, as is shown in FIG 36, a through hole 305b is formed in the semiconductor chip 305 that penetrates in the thickness direction thereof. A weight 311 is provided within this through hole 305b, and one end of this weight 311 is integrally fixed to an inner surface of the through hole 305b by a flexible portion 313. The flexible portion 313 is formed so as to be thinner than the thickness dimension of the semiconductor chip 305, and the flexible portion 313 is able to flex when acceleration is applied to the weight 311. A piezoelectric element 314 that converts the acceleration into electrical signals based on the flexing of the flexible portion 313 is adhered to the flexible portion 313.

Moreover, a plurality of pad electrodes 315 are formed so as to be exposed on another end surface 305c in the thickness direction of the semiconductor chip 305. These pad electrodes 315 have a role of supplying power to the semiconductor chip 305, and also function as terminals to transmit to the outside electrical signals that are fetched from the piezoelectric element 314.

As is shown in FIG 35, the lid frame 307 is formed from a heat resistant thermosetting resin, and is provided with a lid body 317 that is placed on the front surface 303a of the circuit board 303 so as to cover the semiconductor chip 305, and protruding portions 319 that protrude from the lid body 317 while being formed integrally therewith.

The lid body 317 is provided with a substantially plate-shaped top wall (i.e., top end portion) 321 that is placed in a position which is separated in the thickness direction from the front surface 303a of the circuit board 303, and side walls 323 that protrude from peripheral edges of the top wall 321 towards the front surface 303a of the circuit board 303. Namely, the lid body 317 is formed by the top wall 321 and the side walls 323 substantially in a hollowed-out shape that opens onto distal end portions 323a side of the side walls 323. In a state in which the distal end portions 323a of the side walls 323 are placed on the front surface 303a of the circuit board 303 that is positioned on the peripheral edges on the semiconductor chip 305, a hollow space portion 325 is created by the front surface 303a of the circuit board 303 and by inner surfaces 321a and 323c of the top wall 321 and side walls 323. Note that in this state, of the lid body 317, the top wall 321 is positioned the furthest away from the front surface 303a of the circuit board 303, and the inner surfaces 321a and 323c of the top wall 321 and side walls 323 are positioned such that they do not come into contact with the semiconductor chip 305.

Moreover, a thin film-shaped shield portion 327 that is formed on the inner surfaces 321a and 323c of the top wall 321 and side walls 323 facing the space portion 325 is provided on this lid frame 307. This shield portion 327 is formed by coating or blowing a conductive paste which has conductivity such as copper or silver or the like over the inner surfaces 321a and 323c of the top wall 321 and side walls 323. Namely, conductivity is imparted to the lid body 317 by this shield portion 327. The shield portion 327 is formed so as to extend as far as distal end portions 323a of the side walls 323. When the lid frame 307 has been placed in position, the shield portion 327 is in contact with the front surface 303a of the circuit board 303, and the space portion 325 is covered by this shield portion 327.

The protruding portions 319 extend as a pair from peripheral edges of the top wall 321, and extend in a direction in which they move further away from the front surface 303a of the circuit board 303 past the top wall 321. Moreover, each protruding portion 319 extends diagonally relative to the longitudinal direction of the top wall 321, and is also able to be elastically deformed relative to the lid body 317. Namely, each protruding portion 319 is elastically deformed by oscillating and flexing relative to the lid body 317 taking a base end portion 319a thereof as an axis.

In addition, a pair of joining portions 329 that extend integrally from peripheral edges of the top walls 321 in the longitudinal direction of the top walls 21 are formed in the lid frame 307.

On the circuit board 303 there are provided a plurality of pad electrodes 331 that are formed in a substantially plate shape and are placed on the front surface 303a, a plurality of solder balls (i.e., electrode portions) 333 that are placed on the rear surface 303b that is located on the other end side in the thickness direction of the circuit board 303, and wiring portions 335 that are placed inside the circuit board 303 and that electrically connect each of the plurality of pad electrodes 331 and solder balls 333. These wiring portions 335 are formed, for example, from copper foil.

The pad electrodes 331 are electrically connected by wires 337 to the pad electrodes 315 of the semiconductor chip 305. The pad electrodes 331 are positioned around the periphery of the area where the semiconductor chip 305 is placed and are exposed to the space portion 325. These pad electrodes 331 are formed, for example, by plating copper foil with nickel (Ni) having a thickness of 3 to 5 µm and gold (Au) having a thickness of 0.5 µm.

The solder balls 333 are formed substantially in a spherical shape, and protrude from the rear surface 303b of the circuit board 303, and are also placed at a position where they do not overlap in the thickness direction of the circuit board 303 with the space portion 325.

A shield component 339 that has conductivity and takes the form of a thin film is provided on the front surface 303a of the circuit board 303. Of the front surface of the circuit board 303, this shield component 339 is formed on areas facing the space portion 325, the area where the semiconductor chip 305 is placed, and the areas where the distal end portions 323a of the side walls 323 of the lid body 317 are placed. Namely, in a state in which the lid frame 307 has been placed on the front surface 303a of the circuit board 303, this shield component 339 is in contact with the shield portion 327 of the lid frame 307. Accordingly, the shield component 339 encloses the space portion 325 including the semiconductor chip 305 as well as the shield portion 327 of the lid frame 307.

Note that as a result of the above, the above described semiconductor chip 305 is fixed to the front surface 303a of the circuit board 303 via this shielding component 339, and the distal end portions 323a of the side walls 323 of the lid frame 307 are also placed on the front surface 303a of the circuit board 303 via this shield component 339. However, holes 339a are formed in this shield component 339 avoiding the respective pad electrodes 331 in order that the pad electrodes 331 of the circuit board 303 are exposed to the space portion 325, so that the shield component 339 and the pad electrodes 331 are electrically insulated from each other.

The resin mold portion 309 is in contact with the front surface 303a of the circuit board 303 and also with outer surfaces 321b and 323b of the lid body 317 that are located on the opposite side from the inner surfaces 321a and 323c. In addition, the resin mold portion 309 surrounds the joining portions 329 and the protruding portions 319 of the lid frame 307, and fixes the circuit board 303 and the lid frame 307 in a single integral unit.

Note that distal end portions 319b and 329a of the protruding portions 319 and the connecting portions 329 that protrude from the lid body 317 are exposed to the outside respectively at a surface 309a of the resin mold portion 309 that faces in the same direction as the circuit board 303a, and at side surfaces 309b that are adjacent to the surface 309a.

Namely, the resin mold portion 309 is constructed so as to cover the semiconductor chip 305 via the hollow space portion 325 that is formed by the lid body 317. Note that in FIG 35, the resin mold portion 309 is depicted as being separated by the protruding portions 319 and the joining portions 329, however, in actual fact, the protruding portions 319 and the joining portions 329 are surrounded by a single resin mold portion 309, and the resin mold portion 309 is formed as a single unit.

Next, a method of manufacturing the semiconductor device 301 which is constructed in the above described manner will be described.

Note that in this manufacturing method, a single circuit board 303 on which are formed a plurality of units made up of a plurality of pad electrodes 331 that are used to construct the semiconductor device 301, wiring portions 335, and a shield component 339 is prepared in advance.

In addition, the semiconductor chips 305 are each adhered to the front surface 303a of the circuit board 303 via the respective shield components 339. This adhering of the semiconductor chips 305 is performed by placing the semiconductor chips 305 on the front surface 303a of the circuit board 303 via a silver paste, and then curing this silver paste. After this adhering has ended, plasma cleaning is performed in order to remove any contamination adhering to the surfaces 303a and 305c of the circuit board 303 and semiconductor chips 305, and particularly to the pad electrodes 315 and 331. After this, the wires 337 are placed in position by wire bonding and the pad electrodes 315 and 331 of the semiconductor chips 305 and the circuit board 303 are mutually electrically connected.

Thereafter, as is shown in FIG 37, a plurality of lid frames 307 that are integrally joined by the joining portions 329 are prepared (frame preparation step). In this frame preparation step, a plurality of lid frames 307 that are joined together are formed by an injection molding method using heat resistant thermosetting resin.

Next, the plurality of lid frames 307 are stacked on the front surface 303a of the circuit board 303 so that the respective semiconductor chips 305 are covered by the respective lid bodies 317 (frame placement step). Here, because the respective joining portions 329 are set such that the respective lid frames 307 are placed in predetermined positions covering the respective semiconductor chips 305, the positioning of the respective lid frames 307 relative to the plurality of semiconductor chips 305 can be performed easily.

A mold 300E having a flat surface 300E1 is then placed on the rear surface 303b side of the circuit board 303, and a mold (i.e., one mold) 300F having a recessed portion 300F2 that has been hollowed out from a surface 300F1 is placed opposite this mold 300E on the front surface 303a side of the circuit board 303. Namely, the pair of molds 300E and 300F are constructed so as to sandwich the circuit board 303 in the thickness direction thereof. Projecting portions 300F4 that have a substantially V-shaped cross section are formed protruding from a bottom surface 300F3 of the recessed portion 300F2 of the mold 300F, and the respective projecting portions 300F4 are placed so as to be superimposed in the thickness direction on intermediate points between mutually adjacent semiconductor chips 305 and lid frames 307.

At the same time as this pair of molds 300E and 300F are placed in position, a sheet 300S in the shape of a thin film that is able to be peeled off easily from the mold 300F and from the resin which forms the resin mold portion is placed between the circuit board 303 and lid frame 307 and the mold 300F. This sheet 300S is formed, for example, from fluorine resin.

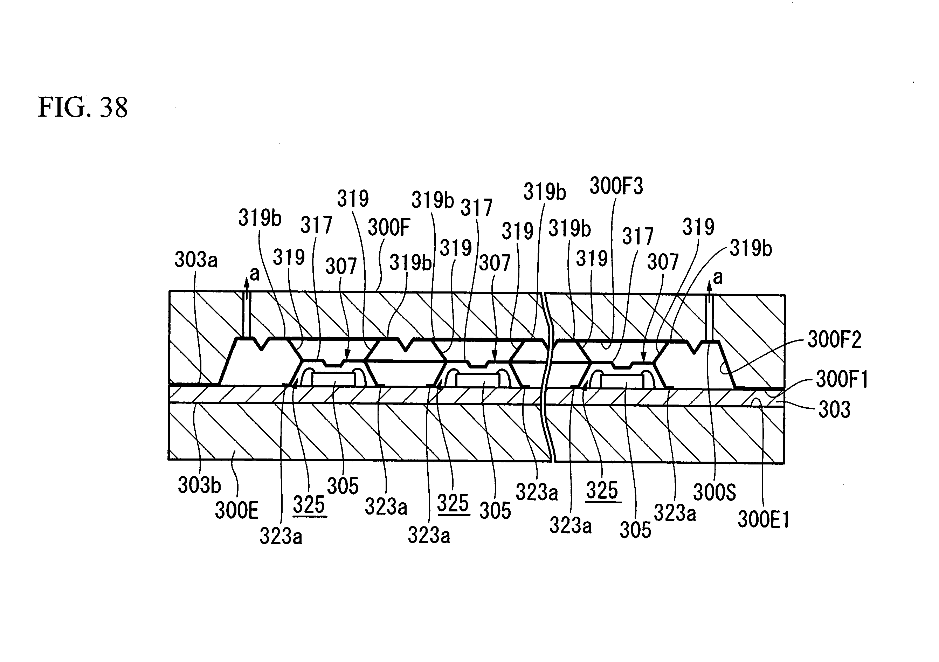

Thereafter, the mold 300F is moved in a direction towards the mold 300E and, as is shown in FIG 38, the circuit board 303 is sandwiched between the flat surface 300E1 and the surface 300F1 of the pair of molds 300E and 300F, and the protruding portions 319 are pressed towards the circuit board 303 by the bottom surface 300F3 of the recessed portion 300F2 of the mold 300F (pressing step). Prior to this pressing step, the sheet 300S is stuck using a vacuum (i.e., the arrows a) to the bottom surface 300F3 of the mold 300F.

Accordingly, in a state in which this pressing step has been performed, the rear surface 303b of the circuit board 303 is in contact with the flat surface 300E1 of the mold 300E, and the front surface 303a of the circuit board 303 is in contact via the sheet 300S with the surface 300F1 of the mold 300F. Moreover, the distal end portions 319b of the protruding portions 319 of the lid frame 307 abut against the bottom surface 300F3 of the mold 300F. Furthermore, because the protruding portions 319 extend from the lid body 317 in a direction in which they move further away from the circuit board 303, a gap is formed between the mold 300F and the lid body 317.

In this pressing step, because the distal end portions 323a of the lid body 317 that is in contact with the circuit board 303 via the protruding portions 319 are pressing against the circuit board 303, the gap between the distal end portions 323a of the lid body 317 and the circuit board 303 can be sealed off. Namely, the space 325 is sealed off from the outside.

Moreover, during this pressing step, because the lid frame 307 is pressed by the pair of molds 300E and 300F onto the circuit board 303, the relative positions of the lid frame 307 and the circuit board 303 are fixed.

Furthermore, in this pressing step, the protruding portions 319 are elastically deformed relative to the lid body 317. Namely, the force with which the lid body 317 is pressed onto the circuit board 303 by the mold 300F can be absorbed by the elastic deformation of the protruding portions 319. Because of this, due to the elastic deformation of the protruding portions 319, it is possible to prevent the force with which the lid frame 307 is pressed against the circuit board 303 by the mold 300F being excessively transmitted to the lid body 317, and it is possible to prevent the lid body 317 becoming deformed.

Moreover, because the distal end portions 323a of the lid body 317 is pressed by a moderate force onto the circuit board 303 due to the elastic force of the protruding portions 319, the gap between the distal end portions 323a of the lid body 317 and the circuit board 303 can be reliably closed off.

Thereafter, in a state in which the protruding portions 319 are pressed by the flat surface 300F 1 of the mold 300F, a thermosetting resin such as an epoxy resin is poured in a molten state into a single gap that is formed by the recessed portion 300F2 of the mold 300F, the circuit board 303, and the plurality of lid bodies 317 so as to form a resin mold portion 309 in which the circuit board 303 and the plurality of lid frames 307 are fixed as a single integral unit (molding step). Note that the aforementioned gap refers to a resin forming space that is used to form the resin mold portion 309. Moreover, this resin mold portion 309 is formed by a transfer molding method in which molten resin is poured sequentially from an end portion of a single large resin forming space.

In this molding step, because the gap between the distal end portions 323a of the lid body 317 and the circuit board 303 is sealed off by the pressing force of the protruding portion 319, it is possible to prevent the molten resin that is poured into the resin forming space entering into the space portion 325. Moreover, in this molding step, because the relative positions of the lid frame 307 and the circuit board 303 are already fixed, it is possible to prevent the lid frame 307 being moved relative to the circuit board 303 by the molten resin that is poured into the resin forming space.

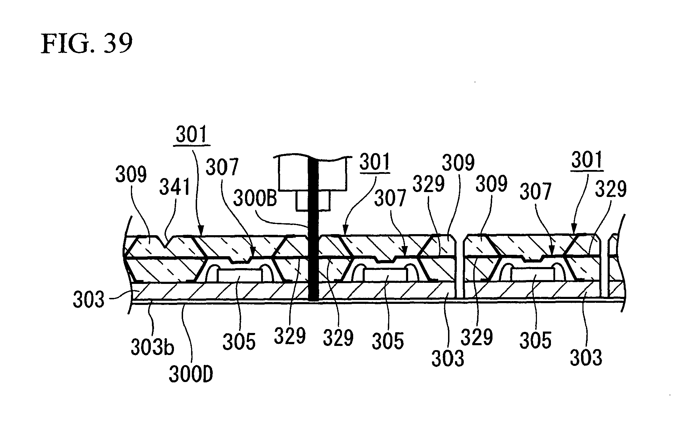

Note that, in this molding step, after the resin forming space has been filled by the molten resin, the resin mold portion 309 is formed by then hardening the resin using heat, as is shown in FIG 39. V-shaped grooves 341 are formed by the above-described projecting portions 300F4 of the mold 300F in the surface 309a of this resin mold portion 309.

After this molding step, a dicing tape 300D is adhered onto the entire rear surface 303b of the circuit board 303. In this state, a dicing step is performed in which a blade 300B is used to cut along the V-shaped grooves 341 to form the individual semiconductor devices 301. At this time, the resin mold portion 309, the circuit board 303, and the joining portions 329 are cut, however, the dicing tape D is not cut.

Finally, the individual semiconductor devices 301 are removed from the dicing tape 300D and, as is shown in FIG 35, the manufacturing of the semiconductor devices 301 is ended when the solder balls 333 are mounted on the wiring portions 335 that are exposed on the rear surfaced 303b of the circuit board 303.

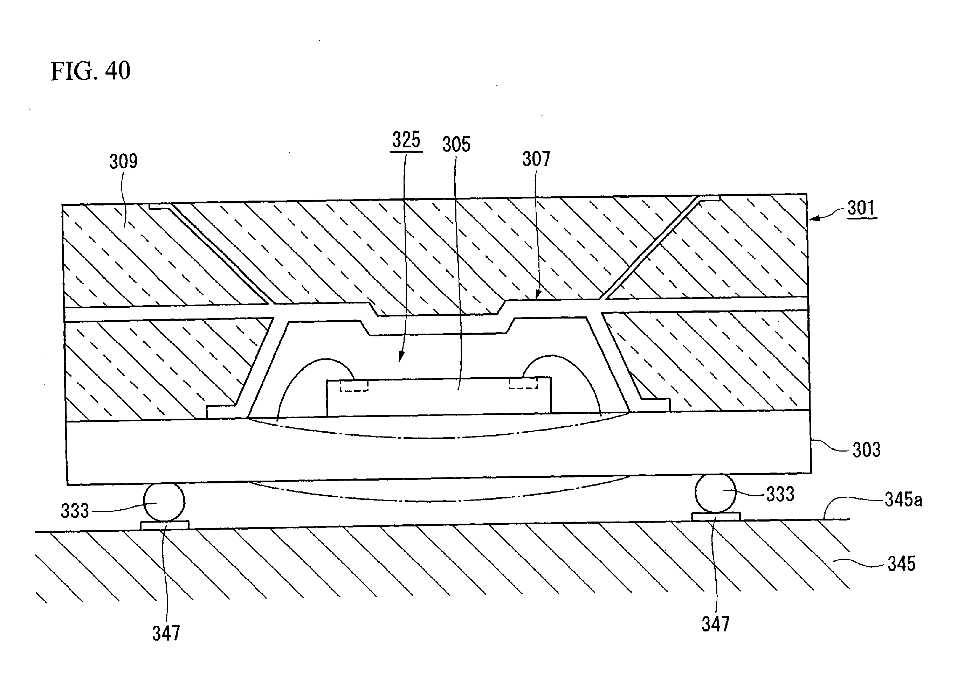

When a semiconductor device 301 is mounted on a package board, as is shown in FIG 40, the rear surface 303b of the circuit board 303 is positioned facing a surface 345a of a package board 345, and the solder balls 333 are placed on land portions 347 that are formed on the surface 345a of the package board 345. By then pressing the semiconductor device 301 against the surface 345a of the package board 345 while applying heat to the solder balls 333, the solder balls 333 are fixed to the land portions 347 and are also electrically connected thereto.

In this state, because the space portion 325 expands and contracts when the semiconductor device 301 is heated and cooled, the portion of the circuit board 303 that overlaps in the thickness direction with the space portion 325 bends.

Here, because the solder balls 333 are placed in a position where they do not overlap in the thickness direction with the space portion 325, it is possible to control changes in the position of the solder balls 333 relative to the package board 345 based on the bending of the circuit board 303. Moreover, because the solder balls 333 are provided so as to protrude from the rear surface 303b of the circuit board 303, even if the space portion 325 does expand, it is still possible to prevent the circuit board 303 coming into contact with the surface 345a of the package board 345. Accordingly, it is possible to prevent the solder balls 333 peeling away from the land portions 347 of the package board 345.

According to the above described semiconductor device 301, the method of manufacturing the semiconductor device, and the lid frame 307 that is used therein, simply by sandwiching the circuit board 303 and the lid frame 307 between the pair of molds 300E and 300F, it is possible to prevent molten resin flowing into the space portion 325 when the resin mold portion 309 is being formed, and it is possible to prevent the lid frame 307 moving relative to the circuit board 303. Accordingly, it is no longer necessary to perform a step to adhere the lid frame 307 which covers the semiconductor chip 305 to the circuit board 303, or to perform a step of forming a recessed portion or supporting portion in the circuit board 303 in order to support the distal end portions 323a of the lid body 317, and it is possible to reduce costs when manufacturing a semiconductor device 301 and achieve an improvement in the manufacturing efficiency.

Moreover, because the shield portion 327 of the conductive lid frame 317 and the shielding component 39 of the circuit board 303 surround the semiconductor chip 305, even if electrical noise that is generated on the exterior side of the semiconductor device 301 intrudes into the circuit board 303 and resin mold portion 309, in the lid frame 317 and the shielding component 339 the noise is prevented from intruding into the space portion 325. Accordingly, this noise is reliably prevented from reaching the semiconductor chip 305, and any erroneous operation of the semiconductor chip 305 that is caused by such noise can be reliably prevented.

Furthermore, because the force with which the lid frame 307 is pressed in the pressing step against the circuit board 303 by the mold 300F which has the recessed portion 300F2 is prevented from being transmitted in excess to the lid body 317 by the elastic deformation of the protruding portions 319 so that the lid body 317 is prevented from becoming deformed, it is possible to prevent any irregularity in the space portion 325 that is caused by deformation of the lid body 317.

Moreover, because the distal end portion 323a of the lid body 317 is pressed by a moderate force onto the circuit board 303 due to the elastic force of the protruding portions 319, the gap between the distal end portion 323a of the lid body 317 and the circuit board 303 can be reliably sealed off.

Furthermore, because the semiconductor device 301 has what is known as a surface package type of structure in which the solder balls 333 are only placed on the rear surface side of the circuit board which faces the package board 345, the package area of the semiconductor device 301 on the package board 345 is limited to the surface area of the rear surface 303b of the circuit board 303. Accordingly, it is possible to reduce the mounting area of the semiconductor device 301 on the package board 345, and achieve a reduction in the size of the package board. 345.

Moreover, because it is possible to restrict changes the position of electrode portions relative to the package board 345 based on bending of the circuit board 303 due to the expansion and contraction of the space portion 345, it is possible to prevent the solder balls 333 peeling away from the package board 345, and to secure an electrical connection between the semiconductor chip 305 and the package board 345.

Furthermore, when manufacturing a plurality of semiconductor devices 301, by joining together a plurality of the lid frames 307 using the joining portions 329, the positioning of the respective lid frames 307 on the respective semiconductor chips 305 that have been placed on the circuit board 303 can be performed easily. Moreover, it becomes possible to easily manufacture a plurality of semiconductor devices 301 simultaneously, and it is possible to achieve an improvement in the manufacturing efficiency of the semiconductor devices 301.

Moreover, in the pressing step because the protruding portions 319 of the lid frame 307 are abutted against the bottom surface 300F3 of the mold 300F via the sheet S, it is possible to prevent the mold 300F becoming damaged by the contact with the protruding portions 319. Moreover, because the molding step is performed with the sheet 300S placed on the bottom surface 300F3 of the mold 300F, it is possible to prevent the mold 300F becoming contaminated by molten resin.

Note that in the above described embodiment, the shield component 339 is placed on the front surface 303a of the circuit board 303, however, the present invention is not limited to this and it is also possible for the shield component 339 to be formed so as to surround the space portion 325 including at least the lid body 317 and the semiconductor chip 305. Namely, it is possible for a portion of the shield component 339 to be placed inside the circuit board 303.

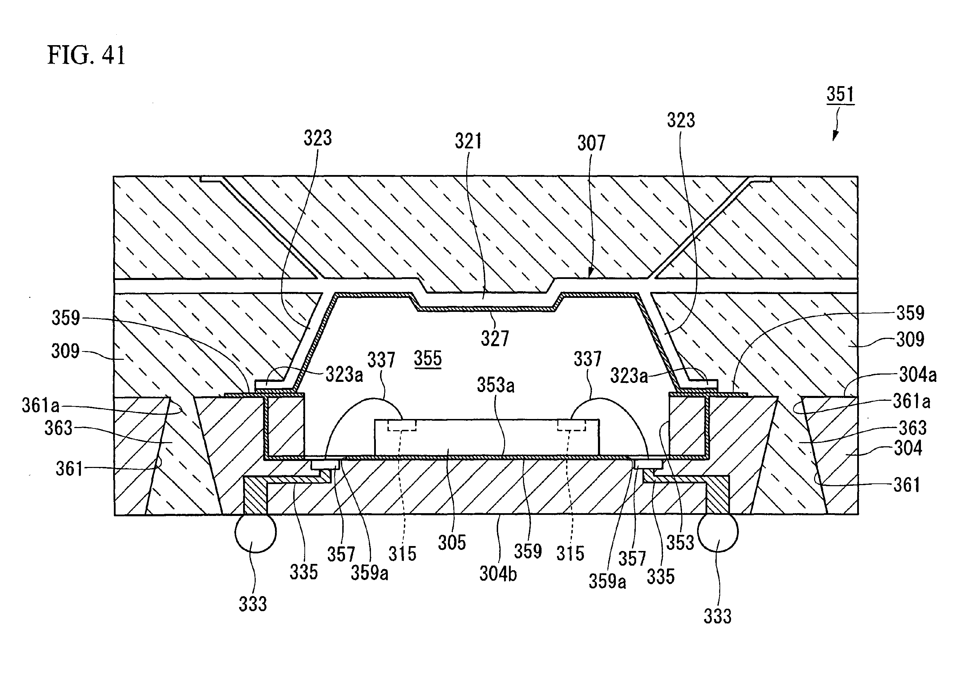

Next, a ninth embodiment of the present invention will be described with reference made to FIG 41. Note that, here, only points of variance with the eighth embodiment will be described and component elements that are the same as those of the semiconductor device 301 are given the same symbols and a description thereof is omitted.

As is shown in FIG 41, a recessed portion 353 that has a substantially rectangular shape in cross sectional view is formed in a circuit board 304 that constitutes a semiconductor device 351 according to this embodiment by being hollowed out in the thickness direction from a front surface 304a of the circuit board 304. A semiconductor chip 305 is placed on a bottom surface 353a of this recessed portion 353.

A lid frame 307 is placed so as to extend across this recessed portion 353. Namely, the distal end portions 323a of the lid body 317 are placed on the front surface 304a of the circuit board 304 that is positioned on a peripheral edge of the recessed portion 353. In this state, a hollow space portion 355 is created by the recessed portion 353 of the circuit board 304 and the top wall 321 and side walls 323 of the lid frame 307.

A plurality of pad electrodes 357 that are electrically connected to the pad electrodes 315 of the semiconductor chip 305 by wires 337 are placed on the bottom surface 353a of the recessed portion 353. These pad electrodes 357 are electrically connected via a wiring layer 335 to the plurality of solder balls 333 that are placed on the rear surface 304b of the circuit substrate 304. Note that, in the same way as in the eighth embodiment, the solder balls 333 are positioned such that they do not overlap in the thickness direction with the space portion 355.

Moreover, a shield component 359 that encloses the space portion 355 including the semiconductor chip 305 as well as the shield portion 317 of the lid frame 307 is provided on the circuit board 304. Namely, the shield component 359 is placed on the bottom surface 353a of the recessed portion 353, and is provided so as to be exposed from peripheral edges of the bottom surface 353a right through the interior of the circuit board 304 as far as the front surface 304a of the circuit board 304 that is positioned on the peripheral edges of the recessed portion 353. Accordingly, in a state in which the lid frame 307 is placed on the front surface 304a of the circuit board 304, the shield component 359 is in contact with the shield portion 327 of the lid frame 307.

Note that, as a result of the above, the semiconductor chip 305 is fixed to the front surface 304a of the circuit board 304 via this shield component 359, and the distal end portions 323a of the side walls 323 of the lid frame 307 are also placed on the front surface 304a of the circuit board 304 via this shield component 359. Holes 359a are formed in this shield component 359 avoiding the respective pad electrodes 357 in order that the pad electrodes 357 of the circuit board 304 are exposed to the space portion 355, so that the shield component 359 and the pad electrodes 357 are electrically insulated from each other.

A plurality of tapered through holes 361 are formed in peripheral edges of the circuit board 304 penetrating in the thickness direction thereof such that they become narrower as they move from the rear surface 304b to the front surface 304a of the circuit board 304. Anchor portions 363 that are formed integrally with the resin mold portions 309 via aperture portions 361a of the through holes 361 which are positioned on the front surface 304a side of the circuit board 304 are provided inside each through hole 361. Namely, the anchor portions 363 are formed by filling the through holes 361 with the same resin material as that used for the resin mold portion 309. Note that the anchor portions 363 form the same plane as the rear surface 304b of the circuit board 304.

The semiconductor device 351 that is constructed in the manner described above can be manufactured using the same pair of molds 300E and 300F as in the eighth embodiment. Note also that the anchor portions 363 can be formed in the molding step by supplying molten resin that is used to form the resin mold portion 309 through the aperture portions 361a of the through holes 361. Moreover, in the molding step, because the through holes 361 open towards the mold 300E that has the flat surface 300E1, it is preferable for the same type of sheet 300S as was used in the eighth embodiment to be placed between the rear surface 304b of the circuit board 304 and the mold 300E.

When the semiconductor devices 351 become heated when they are being packaged by soldering or the like on the package board 345 or when a semiconductor device 351 becomes heated as a result of the operation or the like of the semiconductor chip 305, there is an expansion of the space portion 355. Because of this, a force acts on the resin mold portion 309 in a direction moving away from the circuit board 304 due to this expansion. Here, because the through holes 361 that have been filled with the anchor portions 363 are formed in a tapered shape, the anchor portions 363 are unable to be pulled free by this force from the aperture portions 361a which have a narrowed distal end. Accordingly, it is possible to prevent the resin mold portion 309 peeling away from the circuit board 304.

According to the above described semiconductor device 351, the same effects can be achieved as those of the eighth embodiment.

In addition, because the semiconductor chip 305 and the pad electrodes 357 that are placed on the bottom surface 353a of the recessed portion 353 are electrically connected by the wires 337, it is possible to prevent the wires 37 from protruding to the outside of the recessed portion 353. Accordingly, when the frame placement step and the pressing step are being performed with these wires 337 having been placed in position, it is possible to reliably deform the wires 337 while preventing the wires 337 from coming into contact with the lid frame 307. Accordingly, when manufacturing the semiconductor device 351, it is possible to easily secure an electrical connection between the circuit board 304 and the semiconductor chip 305.

Furthermore, by forming the tapered through holes 361, and by forming the resin mold portion 309 integrally with the anchor portions 363 by means of the aperture portions 361a of the through holes 361 which have a narrowed distal end, it is possible to prevent the resin mold portion 309 being pulled away from the front surface 304a of the circuit board 304 due to the expansion of the space portion 355. Note that the through holes 361 and the anchor portions 363 also achieve the same effects when they are included in the structure of the semiconductor device 301 of the eighth embodiment.

Note that, in the above described seventh and eighth embodiments, the protruding portions 319 of the lid frame 307 are elastically deformed by oscillating and flexing relative to the lid body 317, however, the present invention is not limited to this and it is sufficient if the protruding portions 319 are able to at least be elastically deformed relative to the lid body 317.

Moreover, the protruding portions 319 are provided so as to be elastically deformable relative to the lid body 317, however, the present invention is not limited to this and it is sufficient if the protruding portions 319 protrude at least from peripheral edges of the top wall 321.

Furthermore, the protruding portions 319 are made to protrude from peripheral edges of the top wall 321, however, the present invention is not limited to this and it is sufficient if the protruding portions 319 extend in a direction in which they move further away from the front surfaces 303a and 304a of the circuit boards 303 and 304 than the top wall 321. Namely, the protruding portions 319 may be made to protrude, for example, from a center portion of the top wall 321, or may be made to protrude from the side walls 323. In this structure as well, because the protruding portions 319 can be pressed by the mold 300F, it is possible to prevent molten resin entering the space portions 325 and 355 and prevent the lid frame 307 moving relative to the circuit boards 303 and 304 when the semiconductor devices 301 and 351 are being manufactured.

Moreover, the shield portion 327 of the lid frame 307 is formed by coating a conductive paste over the inner surfaces 321a and 323c of the top walls 321 and side walls 323 that constitute the lid body 317, however, the present invention is not limited to this, and it is sufficient if electrical noise is prevented from entering into the space portions 325 and 355 at least via the lid body 317. Namely, the shield portion 327 may be formed, for example, by coating a conductive paste over the outer surfaces of the top wall 321 and the side walls 323, or by immersion in a conductive paste.

Furthermore, it is also possible, for example, to form the lid frame 307 using a conductive resin, and coat a non-conductive resin on the inner surfaces 321a and 323c of the lid body 317 that face the space portions 325 and 355. It is also possible coat both the non-conductive resin and the shield portion 327 on top of each other on these inner surfaces 321a and 323c.

Furthermore, the lid frame 307 is formed from a heat-resistant thermosetting resin, however, it is sufficient if it is at least formed from a resin material. However, it is preferable for the lid frame 307 to be formed from a resin material that has sufficient heat resistance to prevent it from being thermally deformed when the lid frame 307 is heated in the molding step and when the semiconductor device 301 is being packaged on the package board. Specifically, it is preferable for the lid frame 307 to be formed from a resin material such as engineering plastic that is able to withstand heat up to approximately 170 to 180 °C.

Moreover, if consideration is given to the prevention of the intrusion of electrical noise into the space portions 325 and 355, then it is also possible to form the lid frame 307 from a conductive material such as a metal. In the case of this structure, the lid frame 307 is able to withstand higher temperatures during the molding step and during the packaging of the semiconductor device 301 on the package board. Moreover, because a conductive material has greater rigidity compared to a resin material, it is possible to prevent the top wall 321 and the side walls 323 of the lid frame 307 bending and becoming deformed in the molding step, and it is easy to secure the space portions 325 and 355.

Furthermore, the lid frame 307 is not limited to being formed from the above described resin material or conductive material. For example, if it is particularly important to prevent electrostatic charges in the semiconductor chip 305, then it is preferable for the lid frame 307 to be formed from a resin material in which carbon has been mixed.

When manufacturing the semiconductor devices 301 and 351, a plurality of lid frames 307 that are joined by the joining portions 329 were placed on the front surfaces 303a and 304a of the circuit boards 303 and 304, however, it is also possible to use individual lid frames 307 that do not have the joining portions 329.

Furthermore, the resin mold portion 309 is formed from a thermosetting resin such as an epoxy resin or the like, however, in the molding step, there may be instances when the space portions 325 and 355 become filled by gas that is generated from the resin when this is heated or the like. When this gas is an odorous gas such as bromine (Br) or the like, there may be harmful effects on the semiconductor chip 305. Accordingly, if this type of gas is considered, then it is preferable for a resin that does not include a fire-resistant compound such as a halogen compound or the like to be selected as the resin that is used to form the resin mold portion 309, and it is particularly preferable for a resin that does not generate a gas that may cause harmful effects to the semiconductor chip 305 such as bromine and the like to be selected.

Furthermore, the solder balls 333 that are electrically connected to the wiring portions 35 are provided on the rear surfaces 303b and 304b of the circuit boards 303 and 304, however, the present invention is not limited to this and it is sufficient if at least electrode portions that are to be electrically connected to the package board 345 are exposed on the rear surfaces 303b and 304b of the circuit boards 303 and 304. Namely, it is also possible for these electrode portions to be formed integrally with the wiring portions 335, and it is also possible for the wiring portions 335 to be made to protrude from the rear surfaces 303b and 304b of the circuit boards 303 and 304.

Furthermore, the semiconductor chip 305 and the circuit boards 303 and 304 are electrically connected by the wires 337, however, the present invention is not limited to this and it is sufficient simply for the semiconductor chip 305 and the circuit boards 303 and 304 to be electrically connected. Namely, it is also possible, for example, for the semiconductor chip 305 to be placed on the front surface 303a or the bottom surface 353a of the recessed portion 353 of the circuit boards 303 and 304 so that the pad electrodes 315, 331, and 357 of the semiconductor chip 305 and the circuit boards 303 and 304 are facing each other.

Moreover, an acceleration sensor chip is described above as an example of the semiconductor chip 305, however, the present invention is not limited to this and it is sufficient for the semiconductor chip 305 to at least be provided with a moving portion such as the flexible portion 313 that constitutes an acceleration sensor chip.

Embodiments of the present invention have been described in detail above with reference made to the drawings, however, the specific structure of the present invention is not limited to these embodiments and, insofar as they do not depart from the spirit or scope of the present invention, design modifications and the like may also be included in the present invention.

### INDUSTRIAL APPLICABILITY

The present invention can be applied to a semiconductor device that is provided with a semiconductor chip such as a sound pressure sensor chip and a pressure sensor chip, and to a method of manufacturing the same, and to a lid frame that is used with the same, and makes it possible to achieve a reduction in manufacturing costs and an improvement in manufacturing efficiency when manufacturing a semiconductor device in which a semiconductor chip that is placed in a space portion is connected with an external space.

## Claims

1. A semiconductor device comprising:
a substrate;
a semiconductor chip that is fixed to a first surface of the substrate;
a chip covering lid body that is provided on the first surface of the substrate so as to cover the semiconductor chip and that forms a hollow first space portion that surrounds the semiconductor chip, and in which there is provided a substantially cylindrical aperture portion that extends to the outer side of the first space portion and has an aperture end at a distal end thereof and that is connected to the first space portion; and
a first resin mold portion that forms the first space portion via the chip covering lid body and covers the substrate such that the aperture end is exposed, and that fixes the substrate integrally with the chip covering lid body.

2. The semiconductor device according to claim 1, wherein the substrate is a circuit board and the semiconductor chip is electrically connected to the circuit board.

3. The semiconductor device according to claim 2, wherein
the circuit board has a recessed portion that is formed in the first surface by hollowing out the circuit board in the thickness direction thereof,
the semiconductor chip is fixed to a bottom surface of the recessed portion, and
the chip covering lid body is fixed to the circuit board in the vicinity of the recessed portion.

4. The semiconductor device according to claim 2, wherein
conductivity is imparted to the chip covering lid body, and
a shield component that has conductivity is formed on the first surface of the circuit board that is positioned in the first space portion, and
the shield component is electrically connected to the chip covering lid body.

5. The semiconductor device according to claim 2, wherein the circuit board is provided with:
pad electrodes that are placed inside the first space portion and are electrically connected to the semiconductor chip;
electrode portions that are placed on a second surface which is on the opposite side of the circuit board from the first surface; and
wiring portions that penetrate the circuit board and electrically connect the pad electrodes to the electrode portions.

6. The semiconductor device according to claim 1, wherein
the substrate is a stage portion that is separated from a lead frame, and
the semiconductor device has electrical connection leads that are placed around a periphery of the stage portion and that are fixed by the first resin mold portion such that one end of each electrical connection lead is exposed from the first resin mold portion, and the semiconductor chip is electrically connected to the electrical connection leads inside the first space portion.

7. The semiconductor device according to claim 6 wherein the semiconductor device has:
a chip through hole that is formed in a position on the stage portion where the semiconductor chip is mounted, and that penetrates in the thickness direction of the stage portion from the first surface to the second surface which is on the opposite side from the first surface; and
a second resin mold portion that is formed on the second surface of the stage portion, and is integrally fixed to the second surface of the stage portion so as to form a second space portion that is connected to the chip through hole.

8. The semiconductor device according to claim 7, wherein the second space portion is formed by a stage covering lid body that covers the second surface of the stage portion.

9. The semiconductor device according to claim 6, wherein
the stage portion and the chip covering lid body have conductivity, and
the semiconductor chip is fixed to one surface of the stage portion in a state of being electrically insulated from the stage portion, and
the chip covering lid body is electrically connected to the stage portion.

10. The semiconductor device according to claim 9, wherein
a chip non-conductive portion that is formed from an electrically non-conductive material is provided on an inner surface of the chip covering lid body that faces the semiconductor chip.

11. The semiconductor device according to claim 8, wherein
the stage portion and the stage covering lid body have conductivity, and
the semiconductor chip is fixed to one surface of the stage portion in a state of being electrically insulated from the stage portion, and
the stage covering lid body is electrically connected to the stage portion.

12. The semiconductor device according to claim 6, wherein
the electrical connections between the semiconductor chip and the electrical connection leads are achieved using electrical wiring that extends from the semiconductor chip through the stage portion in the thickness direction thereof as far as the electrical connection leads.

13. The semiconductor device according to claim 12, wherein
a wiring through hole is formed in the stage portion penetrating in the thickness direction thereof, and
the electrical wiring is provided with an insertion terminal portion that, in a state of being electrically insulated from the stage portion, is fixed to the stage portion so as to be exposed at one surface and at another surface of the stage portion via the wiring through hole, and with a first wire that electrically connects together the semiconductor chip and the insertion terminal portion, and with a second wire that electrically connects together the electrical connection leads and the insertion terminal portion.

14. The semiconductor device according to claim 7, wherein
a diaphragm is formed in the semiconductor chip and the chip through hole is formed facing the diaphragm, and
a connecting lead that is displaced towards the second surface side is connected to the stage portion, and the second resin mold portion is fixed to the second surface of the stage portion so as to envelop the electrical connection leads and the connecting lead.

15. The semiconductor device according to claim 14, wherein
a bent portion that is displaced towards the first surface side of the stage portion is formed in an intermediate portion of the connecting lead.

16. The semiconductor device according to claim 14, wherein
a suspended portion that extends from a side end to an outer surface of the second resin mold portion is provided on the stage portion.

17. The semiconductor device according to claim 14, wherein
a conductive layer is formed on an inner surface of the chip covering lid body.

18. The semiconductor device according to claim 14, wherein
a folded portion is provided in an intermediate portion of the electrical connection leads, and a portion extending from one end of the electrical connection leads to the folded portion is formed within the first space portion.

19. A semiconductor device comprising:
a stage portion having a first and a second surface;
a chip through hole that is formed in the stage portion and penetrates the first and second surfaces in the thickness direction thereof;
a semiconductor chip that is fixed to the first surface of the stage portion which is also a portion where the chip through hole is formed;
a chip covering lid body that is provided on the first surface of the stage portion so as to cover the semiconductor chip and that forms a hollow first space portion that surrounds the semiconductor chip; and
a resin mold portion that covers the first surface of the stage portion so as to form the first space portion via the chip covering lid body, and that also covers the second surface of the stage portion so as to form a second space portion that is connected to the chip through hole on the second surface of the stage portion and form an aperture portion that connects the second space portion to the outside, and that fixes the stage portion integrally with the chip covering lid body.

20. The semiconductor device according to claim 19, wherein the second space portion is formed by a stage covering lid body that covers the second surface of the stage portion, and
the stage covering lid body is provided with the aperture portion.

21. The semiconductor device according to claim 19, wherein
the stage portion and the chip covering lid body have conductivity, and
the semiconductor chip is fixed to one surface of the stage portion in a state of being electrically insulated from the stage portion, and
the chip covering lid body is electrically connected to the stage portion.

22. The semiconductor device according to claim 21, wherein
a chip non-conductive portion that is formed from an electrically non-conductive material is provided on an inner surface of the chip covering lid body that faces the semiconductor chip.

23. The semiconductor device according to claim 20, wherein
the stage portion and the stage covering lid body have conductivity, and
the semiconductor chip is fixed to one surface of the stage portion in a state of being electrically insulated from the stage portion, and
the stage covering lid body is electrically connected to the stage portion.

24. The semiconductor device according to claim 19, wherein
the electrical connections between the semiconductor chip and the electrical connection leads are achieved using electrical wiring that extends from the semiconductor chip through the stage portion in the thickness direction thereof as far as the electrical connection leads.

25. The semiconductor device according to claim 24, wherein
a wiring through hole is formed in the stage portion penetrating in the thickness direction thereof, and
the electrical wiring is provided with an insertion terminal portion that, in a state of being electrically insulated from the stage portion, is fixed to the stage portion so as to be exposed at one surface and at another surface of the stage portion via the wiring through hole, and with a first wire that electrically connects together the semiconductor chip and the insertion terminal portion, and with a second wire that electrically connects together the electrical connection leads and the insertion terminal portion.

26. The semiconductor device according to claim 19, wherein
a diaphragm is formed in the semiconductor chip and the chip through hole is formed facing the diaphragm, and
a connecting lead that is displaced towards the second surface side of the stage portion is connected to the stage portion, and the electrical connection leads are placed in the vicinity of the stage portion, and
the resin mold portion has a first resin layer that covers the first surface of the stage portion so as to form the first space portion via the chip covering lid body, and has a second resin layer that forms the second space portion and the aperture portion on the second surface of the stage portion and that covers the second surface of the stage portion so as to envelop the electrical connection leads and the connecting lead.

27. A lid frame that is used in a semiconductor device that is constructed such that a semiconductor chip that placed on top of and fixed to a first surface of a circuit board and is also electrically connected thereto is covered by resin via a hollow space portion, wherein
the lid frame is provided with a lid body that is provided on the first surface side of the circuit board so as to cover the semiconductor chip and that forms the space portion, and with a substantially cylindrical aperture portion that protrudes from the lid body to the outer side of the space portion so as to open the space portion to the outside.

28. The lid frame according to claim 27, wherein the lid body has conductivity.

29. The lid frame according to claim 27, wherein the aperture portion is formed so as to be elastically deformable relative to the lid body.

30. A semiconductor device comprising:
a circuit board;
a semiconductor chip that placed on top of and fixed to one surface side in the thickness direction of the circuit board and is also electrically connected thereto;
a lid frame that is placed on top of the one surface side of the circuit board and that also covers the semiconductor chip; and
a resin mold portion that is placed so as to provide a hollow space portion between itself and the semiconductor chip via the lid body frame, and that fixes the circuit board integrally with the lid frame, wherein
a lid body that is provided on the circuit board and forms the space portion, and protruding portions that extend from the lid body in the thickness direction so as to protrude towards the outer side from a top surface of the space portion, and whose distal end portions are exposed to the outside of the resin mold portion are formed in the lid frame.

31. The semiconductor device according to claim 30, wherein the semiconductor chip is placed on the bottom surface of a recessed portion that is formed by hollowing out one surface of the circuit board in the thickness direction thereof, and
the lid frame is positioned so as to span across the recessed portion.

32. The semiconductor device according to claim 30, wherein the lid body has conductivity, and
a shield component that has conductivity and that together with the lid body surrounds the space portion including the semiconductor chip is provided on the circuit board, and
the shield component is electrically connected to the lid body.

33. The semiconductor device according to claim 30, wherein a tapered through hole that penetrates in the thickness direction and becomes narrower as it approaches the one end side of the circuit board is formed in the circuit board, and
an anchor portion that is formed integrally with the resin mold portion via an aperture portion located on the side of the through hole where it becomes narrower is provided inside the through hole.

34. The semiconductor device according to claim 30, wherein the circuit board is provided with pad electrodes that are placed on one surface side of the circuit board so as to be exposed to the space portion, and that are electrically connected to the semiconductor chip,
electrode portions that are positioned so as to be exposed at another surface side in the thickness direction of the circuit board; and
wiring portions that are placed inside the circuit board and that electrically connect together the pad electrodes and the electrode portions.

35. The semiconductor device according to claim 34, wherein the electrode portions are placed in positions where they do not overlap in the thickness direction with the space portion.

36. A lid frame that is used in a semiconductor device that is constructed such that a semiconductor chip that placed on top of and fixed to a one surface side of a circuit board in the thickness direction thereof and is also electrically connected thereto is covered by resin via a hollow space portion, wherein
the lid frame is provided with a lid body that is provided on the one surface side of the circuit board so as to cover the semiconductor chip and that forms the space portion, and with protruding portions that protrude from the lid body to the outer side of the space portion and extend further in the thickness direction from a top end portion of the lid body.

37. The lid frame according to claim 36, wherein the lid body has conductivity.

38. The lid frame according to claim 36, wherein the protruding portions are formed so as to be elastically deformable relative to the lid body.

39. A method of manufacturing a semiconductor device that is used to manufacture a semiconductor device that is constructed such that a semiconductor chip that placed on top of and fixed to a first surface of a circuit board and is also electrically connected thereto is covered by resin via a hollow space portion, comprising:
a frame preparation step in which a frame is prepared that has a lid body that together with the circuit board forms the space portion, and that has a substantially cylindrical aperture portion that protrudes to as to extend further in the thickness direction from the top end portion of the lid body, and that allows the space portion to be open to the outside;
a frame placement step in which the lid frame is placed on top of one end side of the circuit board such that the lid body covers the semiconductor chip;
a pressing step in which the circuit board and the lid frame are sandwiched in the thickness direction by a pair of top and bottom molds, and an aperture end of the aperture portion is closed off by one mold and the aperture portion is also pressed against the circuit board by this one mold; and
a molding step in which a resin mold portion is formed by filling a gap that is formed by the one mold, the lid body, the aperture portion, and the circuit board with resin.

40. The method of manufacturing a semiconductor device according to claim 39, wherein, prior to the pressing step, there is provided a sheet placement step in which an elastically deformable sheet in the shape of a thin film is placed between the one mold and the aperture end of the aperture portion.

41. The method of manufacturing a semiconductor device according to claim 40, wherein, after the molding step, there is provided a seal adhesion step in which a sheet-shaped screening seal that closes off the aperture end is adhered to the aperture end of the aperture portion.

42. A method of manufacturing a semiconductor device comprising:
a frame preparation step in which a lead frame is prepared that is formed by a thin metal plate in which a substantially plate-shaped stage portion, on one surface of which is mounted a semiconductor chip, and leads that are positioned on the periphery of the stage portion are joined together as a single unit, and in which chip through holes are formed in the stage portion that penetrate in the thickness direction thereof;
a chip adhesion step in which the semiconductor chip is adhered to one surface of the stage portion so as to be superimposed in the thickness direction on the chip through holes;
a wiring step in which the semiconductor chip and the leads are electrically connected together;
a chip lid body placement step in which a chip covering lid body is placed on one surface of the stage portion so as to cover the semiconductor chip, and a hollow first space portion that surrounds the semiconductor chip is formed by the chip covering lid body and the stage portion; and
a molding step in which a resin mold portion is formed in which the stage portion, the leads, and the chip covering lid body are fixed in a single unit such that the leads are exposed to the outside and such that the chip through holes are connected from the other surface to the outside.

43. A method of manufacturing a semiconductor device comprising:
a frame preparation step in which a lead frame is prepared that is formed by a thin metal plate in which a substantially plate-shaped stage portion, on one surface of which is mounted a semiconductor chip, and leads that are positioned on the periphery of the stage portion are joined together as a single unit, and in which chip through holes are formed in the stage portion that penetrate in the thickness direction thereof;
a chip adhesion step in which the semiconductor chip is adhered to one surface of the stage portion so as to be superimposed in the thickness direction on the chip through holes;
a wiring step in which the semiconductor chip and the leads are electrically connected together;
a chip lid body placement step in which a chip covering lid body is placed on one surface of the stage portion so as to cover the semiconductor chip, and a hollow first space portion that surrounds the semiconductor chip is formed by the chip covering lid body and the stage portion;
a stage lid body placement step in which a stage covering lid body is placed on the other surface so as to cover the other surface of the stage portion including the chip through holes, and a hollow second space portion is formed by the stage covering lid body and the stage portion; and
a molding step in which a resin mold portion is formed in which the stage portion, the leads, the chip covering lid body, and the stage covering lid body are fixed in a single unit such that the leads are exposed to the outside and such that the first space portion is exposed to the outside via an aperture portion that is formed in the chip covering lid body.

44. A method of manufacturing a semiconductor device comprising:
a frame preparation step in which a lead frame is prepared that is formed by a thin metal plate in which a substantially plate-shaped stage portion, on one surface of which is mounted a semiconductor chip, and leads that are positioned on the periphery of the stage portion are joined together as a single unit, and in which chip through holes and a wiring through hole are formed in the stage portion that penetrate in the thickness direction thereof;
a chip adhesion step in which the semiconductor chip is adhered to one surface of the stage portion so as to be superimposed in the thickness direction on the chip through holes;
a terminal portion mounting step in which insertion terminal portions that have conductivity are mounted on the stage portion so as to be exposed from both surfaces of the stage portion via the wiring through hole;
a first wiring step in which the semiconductor chip and the insertion terminal portions are electrically connected together;
a chip lid body placement step in which a chip covering lid body is placed on one surface of the stage portion so as to cover the semiconductor chip, and a hollow first space portion that surrounds the semiconductor chip is formed by the chip covering lid body and the stage portion;
a second wiring step in which the leads and the insertion terminal portions are electrically connected together; and
a molding step in which a resin mold portion is formed in which the stage portion, the leads, and the chip covering lid body are fixed in a single unit such that the leads are exposed to the outside and such that the chip through hole is connected from the other surface to the outside.

45. A method of manufacturing a semiconductor device comprising:
a frame preparation step in which a lead frame is prepared that is formed by a thin metal plate in which a substantially plate-shaped stage portion, on one surface of which is mounted a semiconductor chip, and leads that are positioned on the periphery of the stage portion are joined together as a single unit, and in which chip through holes and a wiring through hole are formed in the stage portion that penetrate in the thickness direction thereof;
a chip adhesion step in which the semiconductor chip is adhered to one surface of the stage portion so as to be superimposed in the thickness direction on the chip through holes;
a terminal portion mounting step in which insertion terminal portions that have conductivity are mounted on the stage portion so as to be exposed from both surfaces of the stage portion via the wiring through hole;
a first wiring step in which the semiconductor chip and the insertion terminal portions are electrically connected together;
a chip lid body placement step in which a chip covering lid body is placed on one surface of the stage portion so as to cover the semiconductor chip, and a hollow first space portion that surrounds the semiconductor chip is formed by the chip covering lid body and the stage portion;
a second wiring step in which the leads and the insertion terminal portions are electrically connected together;
a stage lid body placement step in which a stage covering lid body is placed on the other surface so as to cover the other surface of the stage portion including the chip through holes, and a hollow second space portion is formed by the stage covering lid body and the stage portion; and
a molding step in which a resin mold portion is formed in which the stage portion, the leads, the chip covering lid body, and the stage covering lid body are fixed in a single unit such that the leads are exposed to the outside and such that the first space portion is exposed to the outside via an aperture portion that is formed in the chip covering lid body.

46. A method of manufacturing a semiconductor device that is provided with a semiconductor sensor chip in which is formed a diaphragm that is deformed when pressure is applied thereto and that detects the pressure in accordance with the deformation amount, in which
a lead frame is prepared that is provided with a substantially plate-shaped stage portion in which a through hole is provided, connection leads that have one end that is connected to the stage portion and that support the stage portion in an elevated state, and a lead that has one end placed in the vicinity of the stage portion,
using a pair of first molds that have a protruding portion provided on one of the molds, the molds are fastened onto the lead frame such that this protruding portion is inserted into the through hole,
a cavity of the pair of first molds is filled with a first resin,
at a stage when a first sealing resin layer that forms a boundary around a concave portion that is hollowed out so as to be connected with the through hole by means of the protruding portion and that seals the stage portion, the connection leads, and the lead has been formed, the semiconductor sensor chip is adhered to the stage portion with the diaphragm being made to face the through hole,
the semiconductor sensor chip and the lead that is exposed at a top surface of the first resin sealing layer are electrically connected,
at a stage when a lid body that forms a space above the semiconductor sensor chip and covers this space and that is provided with an aperture portion that connects this space to the outside has been mounted on the first sealing resin layer, the first sealing resin layer and the lid body are held together as a single unit using a pair of second molds and these molds are then fastened together, and
by filling a cavity of the pair of second molds with a second resin, a second sealing resin layer is formed that is adhered to the first sealing resin layer so as to cover the outer surface of the lid body while maintaining a state of connection between the space and the outside.

47. A method of manufacturing a semiconductor device that is provided with a semiconductor sensor chip in which is formed a diaphragm that is deformed when pressure is applied thereto and that detects the pressure in accordance with the deformation amount, in which
a lead frame is prepared that is provided with a substantially plate-shaped stage portion in which a through hole is provided, connection leads that have one end that is connected to the stage portion and that support the stage portion in an elevated state, and a lead that has one end placed in the vicinity of the stage portion,
using a pair of first molds that have a protruding portion provided on one of the molds, the molds are fastened onto the lead frame such that this protruding portion is inserted into the through hole,
a cavity of the pair of first molds is filled with a first resin,
at a stage when a first sealing resin layer that forms a boundary around a hole portion that is open to the outside so as to be connected with the through hole by means of the protruding portion and that seals the stage portion, the connection leads, and the lead has been formed, the semiconductor sensor chip is adhered to the stage portion with the diaphragm being made to face the through hole,
the semiconductor sensor chip and the lead that is exposed at a top surface of the first resin sealing layer are electrically connected,
at a stage when a lid body that forms a space in a sealed state above the semiconductor sensor chip and covers this space has been mounted on the first sealing resin layer, the first sealing resin layer and the lid body are held together as a single unit using a pair of second molds and these molds are then fastened together, and
by filling a cavity of the pair of second molds with a second resin, a second sealing resin layer is formed that covers the outer surface of the lid body and s adhered to the first sealing resin layer.
